# EUROPEAN PATENT SPECIFICATION

(11) **EP 3 484 139 B1**
(45) Date of publication and mention of the grant of the patent: **20.12.2023**
(21) Application number: 17823485.2
(22) Date of filing: 02.06.2017
(51) Int. Cl.: H04N 23/54, H01L 27/146

(54) **PHOTOSENSITIVE COMPONENT, AND CAMERA MODULE**
LICHTEMPFINDLICHES BAUELEMENT UND KAMERAMODUL
COMPOSANT PHOTOSENSIBLE, ET MODULE DE CAMÉRA

(30) Priority: 03.07.2016 CN 201610516600; 03.07.2016 CN 201620691699 U; 28.11.2016 CN 201611067131; 28.11.2016 CN 201621286847 U; 06.02.2017 CN 201710065909; 06.02.2017 CN 201720112605 U
(43) Date of publication of application: 15.05.2019
(73) Proprietor: Ningbo Sunny Opotech Co., Ltd., Ningbo, Zhejiang 315400 (CN)
(72) Inventor: WANG, Mingzhu, Ningbo Zhejiang 315400 (CN); CHEN, Zhenyu, Ningbo Zhejiang 315400 (CN); LUAN, Zhongyu, Ningbo Zhejiang 315400 (CN); HUANG, Zhen, Ningbo Zhejiang 315400 (CN); GUO, Nan, Ningbo Zhejiang 315400 (CN); XI, Fengsheng, Ningbo Zhejiang 315400 (CN); TANAKA, Takehiko, Nara Nara (JP); ZHAO, Bojie, Ningbo Zhejiang 315400 (CN); JIANG, Heng, Ningbo Zhejiang 315400 (CN); WU, Ye, Ningbo Zhejiang 315400 (CN); DENG, Zilong, Ningbo Zhejiang 315400 (CN)
(74) Representative: Gong, Jinping
(86) International application number: PCT/CN2017/086998
(87) International publication number: WO 2018/006673

(56) References cited:
- EP-A1- 3 429 183
- EP-B1- 1 475 960
- CN-A- 1 577 872
- CN-A- 103 915 393
- CN-A- 104 576 674
- CN-A- 105 681 637
- CN-A- 105 681 640
- CN-A- 105 681 640
- CN-A- 105 704 354
- CN-A- 105 704 354
- CN-U- 205 961 279
- CN-U- 206 136 071
- CN-U- 206 302 476
- JP-A- 2001 077 277
- JP-A- 2016 033 963
- US-A1- 2011 194 023

## Description

### Technical field

The present invention relates to the field of image capture modules, and further relates to a photosensitive assembly and an image capture module.

### Technical background

Conventional image capture modules are usually packaged by a COB (Chip On Board) process. As a relatively mature packaging technology, the COB package has its advantages, but there are also many unfavorable factors.

A conventional image capture module generally includes a circuit board, a photosensitive chip, a filter, a base, a driver, a lens, and at least one capacitance-resistance component. After the components are packaged in a COB manner, the photosensitive chip is mounted on the circuit board, the base is mounted on the circuit board, the filter is mounted on the base, and is located in the photosensitive path of the photosensitive chip, the driver is mounted to the base, the lens is mounted to the driver to be located in the photosensitive path of the photosensitive chip, and a focal length of the image capture module can be adjusted by the driver.

Firstly, in the prior art, the photosensitive chip is attached to the upper surface of the circuit board, and in the process, the chip is usually attached to the circuit board by glue bonding, and the consistency of the optical axis of the image capture module is an important aspect thereof. Therefore, the respective flatness of the photosensitive chip and the circuit board is required to be relatively high, so that subsequently the main optical axis of the lens is aligned with the center optical axis of the photosensitive chip.

Secondly, the base is fixed to the circuit board in an adhesive manner, and the components such as the filter, the driver and the lens are based on the base, so that the flatness of the base itself and the flatness to be installed is required to be relatively high.

Thirdly, the photosensitive chip is electrically connected to the circuit board through a gold wire, and the circuit board is provided with the protruding capacitance-resistance component. Thus, when the base is mounted, a space for the gold wire and the capacitance-resistance component needs to be reserved so that the gold wire and the capacitance-resistance component do not contact with each other in all directions, which causes unnecessary space occupation. Moreover, in another aspect, the capacitance-resistance component is susceptible to dust and debris, and the dust and debris may affect the imaging of the module to form a black spot.

Fourthly, it is also a relatively important aspect. Adapting to the development of various smart devices, such as smart phones, the requirements for thinner and lighter image capture modules has been increasing. So far, in the case of extremely miniaturized image capture modules, almost each of the micro-spaces is extremely important to the image capture module. In this assembly mode, the respective space occupied independently by the photosensitive chip, the circuit board, and the capacitance-resistance component makes the size of the image capture module difficult to be reduced. In the attaching type structure, since the photosensitive chip has a certain thickness, it is necessary to mount the base when mounting other components, and provide a spatial position protruding from the circuit board for the photosensitive chip.

Fifthly, the height of the image capture module needs to meet the requirements of optical imaging. In this assembly mode, the chip is mounted on the circuit board, and the filter is mounted on the base. Therefore, the back focal length of the image capture module is larger, and the overall height of the image capture module is larger.

With the continuous development of smart electronic devices, the requirements for image capture modules are increasing. Smart electronic devices, such as smart phones, are becoming more and more multifunctional, lighter and thinner. Accordingly, image capture modules are also required to develop toward more excellent image quality and miniaturization.

Taking smartphones as an example, it is known that the thickness of existing smartphones has been reduced to a few millimeters, such as 6 or 7 mm. The image capture module to be mounted naturally requires less than this size. Obviously, the image capture module is already in a miniaturized size structure. It is conceivable that it is extremely difficult to further reduce the image capture module in such a miniaturized size structure.

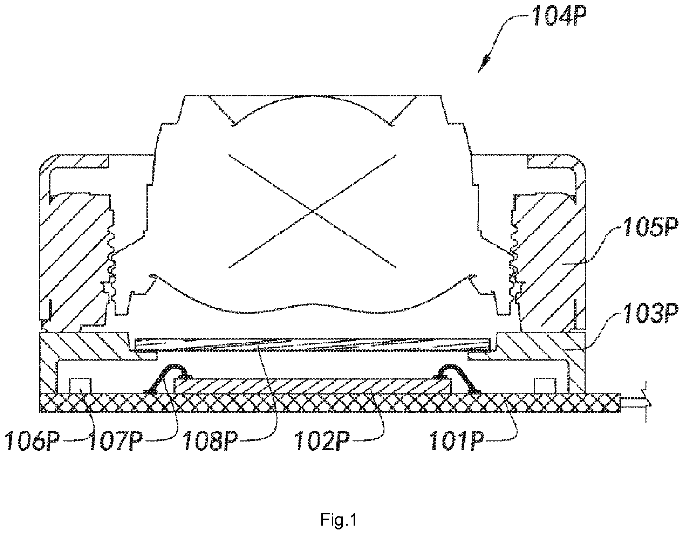

With the rapid development of image capture modules in recent years, the various performances of the modules have entered an excellent level, and to achieve the corresponding image quality, various components and relative structures are basically determined. Referring to Fig. 1, an image capture module packaged by a COB manner generally includes a circuit board 101P, a photosensitive chip 102P, a lens holder 103P, a lens 104P, and a motor 105P. The photosensitive chip 102P is attached to the circuit board 101P, the lens holder 103P is mounted on the circuit board 101P, and the lens 104P is mounted to the motor 105P. Also, the lens 104P is located in the photosensitive path of the photosensitive chip 102P, and a filter 108P is mounted on the lens holder 103P, and is located in the photosensitive path of the photosensitive chip 102P. It should be noted that the circuit board 101P usually needs to be mounted with some capacitance-resistance components 106P and a gold wire 107P, such as mounting resistors and capacitors to cooperate with the operation of the circuit board 101P, and the capacitance-resistance components 106P and the gold wire 107P are generally protruded from the circuit board 101P. Thus, the existing structure has many problems.

First, the lens holder 103P is adhered to the circuit board 101P by glue. Due to the unevenness of the lens holder 103P itself and the tilt of the attached assembly, the tilt of the module and the inconsistency of the optical axis are easily caused.

Next, the capacitance-resistance component 106P, the gold wire 107P and the photosensitive chip 102P are in the same communicated space, and dust and impurities remaining on the capacitance-resistance component 106P and the gold wire 107P are easily transferred to the photosensitive chip 102P, thereby affecting the imaging quality of the image capture module, so that black spots, stains, and the like are adversely occurred in the imaging of the image capture module.

Thirdly, the lens holder 103P is adhered to the circuit board 101P by glue, and the structural strength is poor. Therefore, the thickness of the circuit board 101P is required to be large, so that the thickness of the image capture module is not easily reduced.

Fourthly, the image capture module structure of the existing COB package has reached a high degree of optimization, and the relative positions and structural relationship of components such as the lens holder 103P, the circuit board 101P, the photosensitive chip 102P, the lens 104P and the motor 105P have been relatively determined. On this basis, the size of the image capture module is difficult to be further reduced.

Fifthly, the photosensitive chip 102P is mounted on the circuit board 101P, and the structural relationship of the laminate makes the height of the image capture module larger.

Sixthly, and more importantly, the photosensitive chip 102P is mounted on the circuit board 101P by means of glue bonding, and the upper side of the photosensitive chip 102P is sealed in the space opposite the lens 104P, and the lower side thereof is blocked by the circuit board 101P, so that the overall heat dissipation effect of the photosensitive chip 102P is poor. Thus, heat can only be dissipated through the conduction characteristic of the circuit board 101P. Generally, the heat dissipation effect of the circuit board is poor. Further, when the photosensitive chip 102P generates heat, it is easy to affect the working performance of the image capture module, such as affecting the image quality.

In recent years, electronic devices have been increasingly oriented toward lightweight and thinness and high performance, which imposes very demanding requirements on the size and performance of an image capture module that is one of the standard configurations of the electronic devices. Those skilled in the art should know that the imaging quality of the image capture module depends not only on the performance of the photosensitive chip of the image capture module, but also is greatly limited by the flatness of the photosensitive chip. Therefore, a circuit board having a higher thickness and a higher strength can be generally selected for the existing image capture module, to ensure the flatness of the photosensitive chip, which results in an increase in the height dimension of the image capture module.

In addition, the existing image capture module mounts the photosensitive chip on the circuit board by a SMT process (Surface Mount Technology). When performing the SMT process, it is necessary to provide glue or similar adhesive between the photosensitive chip and the circuit board. The adhesive at different positions between the photosensitive chip and the circuit board has a difference in the deformation rate at the time of curing, thereby causing a problem such as tilting of the photosensitive chip, and the adhesive filled between the photosensitive chip and the circuit board also causes the height dimension of the image capture module to be increased.

The circuit board is a polymer material board. Since the thickness of the circuit board is required to be as thin as possible, when the image capture module is used, the photosensitive chip directly mounted on the circuit board generates heat when photoelectric conversion is performed. The continuous impact of this heat on the circuit board causes deformation of the circuit board, thereby affecting the flatness of the photosensitive chip. In order to solve the problem that the flatness of the photosensitive chip is affected due to the deformation of the circuit board caused by heat, the circuit boards of some image capture modules are overlapped with a metal layer, so that, due to the metal layer, the circuit board does not deform when heated. However, this not only increases the manufacturing cost of the image capture module, but further increases the height dimension of the image capture module.

EP3429183A1 of the applicant, which was filed prior to and published later than the present application, discloses a camera module and photosensitive component and manufacturing method thereof. The photosensitive component includes an encapsulation portion and a photosensitive portion that includes a main circuit board and a photosensitive sensor, wherein the encapsulation portion is integrally encapsulated to form on the main circuit board and the photosensitive sensor.

US2011194023A1 discloses a camera module with molded tape flip chip imager mount and a method for manufacturing camera modules is disclosed. The camera module includes a flexible circuit substrate, an image capture device flip-chip mounted to the bottom surface of the flexible circuit substrate, a housing mounted over the top surface of the flexible circuit substrate, and a lens unit coupled to the housing.

CN105704354A of the applicant, discloses a camera module, a photosensitive assembly thereof and a manufacturing method. The photosensitive assembly comprises a packaging part and a photosensitive part, wherein the photosensitive part comprises a circuit board main body and a photosensitive chip; and the packaging part is integrally packaged and formed on the circuit board main body and the photosensitive chip.

JP2016033963A discloses a semiconductor package, comprising: a semiconductor chip, a substrate which has a penetrated part where the semiconductor chip is to be mounted and the semiconductor chip is fixed to the penetrated part, and a mold resin which covers the semiconductor chip and the substrate so as to expose the pixels.

EP1475960B1 relates to a camera module, wherein an FPC interposed between an optical unit and a solid-state imaging device is formed with an opening for exposing a cover glass and an assembly reference surface of the solid-state imaging device.

### Summary of the Invention

The present invention provides a photosensitive assembly and an image capture module set out in the appended set of claims.

An object of the present invention is to provide a photosensitive assembly and an image capture module, wherein the photosensitive assembly comprises a photosensitive element, a window-form circuit board and a packaging body, the photosensitive element and the window-form circuit board are integrally packaged by the packaging body.

Another object of the present invention is to provide a photosensitive assembly and an image capture module, wherein the photosensitive element and the window-form circuit board are integrally packaged by the packaging body in a spatially overlapping manner, thereby reducing the relative height of the photosensitive element and the window-form circuit board.

Another object of the present invention is to provide a photosensitive assembly and an image capture module, wherein the window-form circuit board has a window for receiving the photosensitive element, so that the relative height of the photosensitive element and the window-form circuit board is reduced, and the height of the image capture module is reduced.

Another object of the present invention is to provide a photosensitive assembly and an image capture module, wherein the window of the window-form circuit board is a through hole, so that the relative height of the photosensitive element and the circuit board element can be adjusted for adapting to different thickness of the circuit board.

Another object of the present invention is to provide a photosensitive assembly and an image capture module, wherein the photosensitive element and the window-form circuit board are electrically connected by a connecting wire, and the connecting wire is integrally packaged by the packaging body.

Another object of the present invention is to provide a photosensitive assembly and an image capture module, wherein the photosensitive assembly includes a filter, and the filter is disposed on the photosensitive element to block the photosensitive element from being contaminated and reduce the back focal length of the image capture module.

Another object of the present invention is to provide a photosensitive assembly and an image capture module, wherein the packaging body includes a lens portion integrally extending upwardly, and is adapted to mount a lens of the image capture module, thereby providing the flatness and stable installation condition for the lens. Another object of the present invention is to provide a photosensitive assembly and an image capture module, wherein the packaging body can extend down to the bottom portion of the photosensitive assembly to package the photosensitive assembly from a bottom layer.

An object of the present invention is to provide an image capture module and a photosensitive assembly, wherein the photosensitive assembly comprises an integral package base, a circuit board and a photosensitive element, and the photosensitive element is integrally packaged on the circuit board in a sinking manner through the integral package base, thereby reducing the size of the image capture module.

An object of the present invention is to provide an image capture module and a photosensitive assembly, wherein the integral base is integrally packaged on the photosensitive element and the circuit board instead of the conventional lens holder and the conventional chip attachment method.

An object of the present invention is to provide an image capture module and a photosensitive assembly, wherein the circuit board includes a circuit board main body and has a setting region, the setting region is disposed on the circuit board main body, and the photosensitive chip is disposed in the setting region, thereby reducing the relative height of the circuit board main body and the photosensitive chip.

An object of the present invention is to provide an image capture module and a photosensitive assembly, wherein the integral package base includes a base main body, and the base main body includes a primary base and a secondary base, thereby sequentially fixing the photosensitive element to complete the sinking and packaging of the photosensitive element.

An object of the present invention is to provide an image capture module and a photosensitive assembly, wherein the primary base includes a backing and a primary package base, and during manufacturing, the backing is first formed on the circuit board, and then a manufacturing apparatus is supported on the backing to form the primary package base, thereby pre-fixing the photosensitive element, and preventing the manufacturing mold from damaging the photosensitive element.

An object of the present invention is to provide an image capture module and a photosensitive assembly, wherein the secondary base includes an encapsulation base and a secondary package base, the encapsulation base and the primary package base form an annular structure, and the encapsulation base encapsulates the electrical connection elements of the photosensitive chip.

An object of the present invention is to provide an image capture module and a photosensitive assembly, wherein in the manufacturing process, a manufacturing apparatus is supported on the annular structure to form the secondary package base, so that a mounting groove is formed by the annular structure and the secondary package base, reducing the formation of corners in the one-shot molding process, reducing burrs occurring during molding, and improving the flatness of surface.

An object of the present invention is to provide an image capture module and a photosensitive assembly, wherein the secondary package base overmolds electronic components on the surface of the circuit board, thereby reducing the space occupied independently by the electronic components, and reducing the size of the image capture module.

An object of the present invention is to provide an image capture module and a photosensitive assembly, wherein the image capture module includes a filter element, and the filter element covers the photosensitive element to protect the photosensitive element.

An object of the present invention is to provide an image capture module, and a photosensitive assembly of the image capture module, wherein a molded circuit board assembly includes a circuit board, a photosensitive element and a maintaining portion integrally formed on the circuit board and the photosensitive element. Compared with an image capture module of the prior art, the flatness of a photosensitive element of the image capture module according to the present invention is maintained by the maintaining portion to improve the imaging quality of the image capture module.

An object of the present invention is to provide an image capture module, and a photosensitive assembly of the image capture module, wherein the flatness of the photosensitive element is maintained by the maintaining portion, and thus the image capture module can select a thinner circuit board to reduce the size of the image capture module, and particularly reduce the height dimension of the image capture module.

An object of the present invention is to provide an image capture module, and a photosensitive assembly of the image capture module, wherein when the image capture module is used, even when the image capture module has problems, for example deformed by heat, the flatness of the photosensitive element cannot be affected.

An object of the present invention is to provide an image capture module, and a photosensitive assembly of the image capture module, wherein the circuit board has a receiving space for receiving the a photosensitive element, to reduce a difference in height between the chip upper surface of the photosensitive element and the substrate upper surface of the circuit board, or even cause the chip upper surface of the photosensitive element to be the same horizontal plane as the substrate upper surface of the circuit board, or cause the chip upper surface of the photosensitive element to be lower than the substrate upper surface of the circuit board. In this way, the image capture module can have a longer focal length.

An object of the present invention is to provide an image capture module, and a photosensitive assembly of the image capture module, wherein there is a first safety distance L between the photosensitive element and the circuit board, that is, there is a predetermined safety distance between the photosensitive element and the circuit board, so that the photosensitive element and the circuit board are not in contact, and when the circuit board is deformed, the image capture module prevents the flatness of the photosensitive element from being affected by preventing the circuit board from contacting the photosensitive element.

An object of the present invention is to provide an image capture module, and a photosensitive assembly of the image capture module, wherein the maintaining portion has a bonding side and a mounting side, and forms a light window; wherein the light window is in communication with the bonding side and the mounting side, and the opening size of the light window on the mounting side is larger than the opening size of the light window on the bonding side, to facilitate the drafting of a molding die after the maintaining portion is molded using the molding die.

An object of the present invention is to provide an image capture module, and a photosensitive assembly of the image capture module, wherein the maintaining portion has an inner surface, the inner surface defining the light window, and at least a part of the inner surface extends obliquely from the bonding side toward the mounting side, so that a first included angle α is formed between at least a part of the inner surface of the maintaining portion and an optical axis of the photosensitive element, where the first included angle α is an acute angle.

An object of the present invention is to provide an image capture module, and a photosensitive assembly of the image capture module, wherein when a molded circuit board assembly is molded using the molding die, a light window molding member of an upper mold of the molding die causes the maintaining portion to form the light window, and the first included angle α reduces the friction force generated between the light window molding member and the inner surface of the maintaining portion when the molding die is drafted, to avoid abrasion of the inner surface of the maintaining portion.

An object of the present invention is to provide an image capture module, and a photosensitive assembly of the image capture module, wherein the first included angle α reduces the friction generated between the light window molding member and the inner surface of the maintaining portion when the molding die is drafted, thereby preventing the inner surface of the maintaining portion from generating contaminants such as debris to contaminate the photosensitive region of the photosensitive element.

An object of the present invention is to provide an image capture module, and a photosensitive assembly of the image capture module, wherein the maintaining portion has the outer surface, and the outer surface and the inner surface of the maintaining portion correspond to each other. The outer surface extends obliquely from the bonding side toward the mounting side, so that a second included angle β is formed between the outer surface of the maintaining portion and the optical axis of the photosensitive element, where the second included angle β is an acute angle.

An object of the present invention is to provide an image capture module, and a photosensitive assembly of the image capture module, wherein when a molded circuit board assembly is molded using the molding die, an enclosure member of an upper mold of the molding die forms the outer surface of the maintaining portion, and the second included angle β reduces the friction force generated between the outer surface of the maintaining portion and the enclosure member when the molding die is drafted, to avoid abrasion of the outer surface of the maintaining portion.

An object of the present invention is to provide an image capture module, and a photosensitive assembly of the image capture module, wherein the inner surface of the maintaining portion has a first inner surface, a second inner surface, and a third inner surface, which are sequentially formed between the bonding side and the mounting side of the maintaining portion; wherein the first included angle α is formed between the first inner surface of the maintaining portion and the optical axis of the photosensitive element, a third included angle γ is formed between the third inner surface and the optical axis of the photosensitive element, and the third included angle γ is an acute angle. In this way, the second inner surface is kept horizontal when performing a drafting operation on the molding die.

An object of the present invention is to provide an image capture module, and a photosensitive assembly of the image capture module, wherein the first included angle α, the second included angle β and the third included angle γ can ensure that the tendency of the maintaining portion detaching from the circuit board and the photosensitive element caused by the molding die rubbing the maintaining portion cannot be occurred when performing a drafting operation on the molding die, thereby ensuring the flatness of the maintaining portion and ensuring the reliability and stability of the image capture module.

An object of the present invention is to provide an image capture module, and a photosensitive assembly of the image capture module, wherein the light window molding member has a groove to correspond to a photosensitive region of the photosensitive element, so that when a molded circuit board assembly is molded using the molding die, the groove causes a second safety distance h to be formed between the light window molding member and the photosensitive region of the photosensitive element to avoid scratching the photosensitive region of the photosensitive element.

An object of the present invention is to provide an image capture module, and a photosensitive assembly of the image capture module, wherein the light window molding member of the molding die is provided with a cover film in an overlapping manner to protect the photosensitive element by isolating a pressing surface of the light window molding member and a photosensitive region of the photosensitive element by the cover film.

An object of the present invention is to provide an image capture module, and a photosensitive assembly of the image capture module, wherein the cover film absorbs an impact force acting on the photosensitive element by deformation when the mold clamping operation is performed on the molding die, to protect the photosensitive element.

An object of the present invention is to provide an image capture module, and a photosensitive assembly of the image capture module, wherein the cover film blocks a gap from being generated between the light window molding member and the photosensitive element by deformation, thereby preventing the molding material for forming the maintaining portion from contaminating the photosensitive region of the photosensitive element and avoiding the occurrence of "flash" phenomenon.

An object of the present invention is to provide an image capture module, and a photosensitive assembly of the image capture module, wherein a molded circuit board assembly includes a frame-shaped protective element; wherein the protective element is located outside of the photosensitive region of the photosensitive element; and wherein the protective element is used for supporting the light window molding member, so that there is the second safety distance h between the light window molding member and the photosensitive region of the photosensitive element, avoiding scratching the photosensitive region of the photosensitive element.

An object of the present invention is to provide an image capture module, and a photosensitive assembly of the image capture module, wherein the protective element absorbs an impact force acting on the photosensitive element by deformation when the mold clamping operation is performed on the molding die, to protect the photosensitive element.

An object of the present invention is to provide an image capture module, and a photosensitive assembly of the image capture module, wherein the protective element blocks a gap from being generated between the light window molding member and the photosensitive element by deformation, thereby preventing the molding material for forming the maintaining portion from contaminating the photosensitive region of the photosensitive element and avoiding the occurrence of "flash" phenomenon.

### Brief description of the drawings

Fig. 1 is a schematic diagram of an image capture module of a conventional COB package.
Fig. 2 is a perspective view of an image capture module in accordance with a first preferred embodiment of the present disclosure.
Fig. 3 is an exploded view of the image capture module in accordance with the first preferred embodiment of the present disclosure.
Fig. 4 is a cross-sectional view of the image capture module in accordance with the first preferred embodiment of the present disclosure.
Fig. 5 is a flow chart showing the manufacturing process of a photosensitive assembly of the image capture module in accordance with the first preferred embodiment of the present disclosure.
Figs. 6A and 6B are two equivalent implementations of a packaging body of the photosensitive assembly of the image capture module in accordance with the first preferred embodiment of the present disclosure.
Fig. 7 is a first modified implementation of the photosensitive assembly of the image capture module in accordance with the first preferred embodiment of the present disclosure.
Fig. 8 is a second modified implementation of the photosensitive assembly of the image capture module in accordance with the first preferred embodiment of the present disclosure.
Fig. 9 is a cross-sectional view of an image capture module in accordance with a second preferred embodiment of the present disclosure.
Fig. 10 is an exploded view of a photosensitive assembly of the image capture module in accordance with the second preferred embodiment of the present disclosure.
Fig. 11 is a modified implementation of the photosensitive assembly of the image capture module in accordance with the second preferred embodiment of the present disclosure.
Fig. 12 is a cross-sectional view of an image capture module in accordance with a third preferred embodiment of the present disclosure.
Fig. 13 is a perspective view of a photosensitive assembly of the image capture module in accordance with the third preferred embodiment of the present disclosure.
Fig. 14 is a modified implementation of the photosensitive assembly of the image capture module in accordance with the third preferred embodiment of the present disclosure.
Fig. 15 is a cross-sectional view of an image capture module in accordance with a fourth preferred embodiment of the present disclosure.
Fig. 16 is a modified implementation of the image capture module in accordance with the fourth preferred embodiment of the present disclosure.
Fig. 17 is a cross-sectional view of an image capture module in accordance with a fifth preferred embodiment of the present disclosure.
Fig. 18 is a modified implementation of the photosensitive assembly of the image capture module in accordance with the fifth preferred embodiment of the present disclosure.
Fig. 19 is a cross-sectional view of an image capture module in accordance with a sixth preferred embodiment of the present disclosure.
Fig. 20 is a modified implementation of the photosensitive assembly of the image capture module in accordance with the sixth preferred embodiment of the present disclosure.
Fig. 21 is a cross-sectional view of an image capture module in accordance with a seventh preferred embodiment of the present disclosure.
Fig. 22 is a cross-sectional view of an image capture module in accordance with an eighth preferred embodiment of the present disclosure.
Fig. 23 is a cross-sectional view of an image capture module in accordance with a ninth preferred embodiment of the present disclosure.
Fig. 24 is a block diagram showing a method of manufacturing the photosensitive assembly in accordance with the above preferred embodiments of the present disclosure.
Fig. 25A is a perspective view of an image capture module in accordance with a tenth preferred embodiment of the present disclosure.
Fig. 25B is a cross-sectional view taken along line A-A of Fig. 25A.
Fig. 26A is a schematic view showing a process of forming the image capture module in accordance with the tenth preferred embodiment of the present disclosure.
Fig. 26B is a perspective view of a photosensitive assembly in accordance with the tenth preferred embodiment of the present disclosure.
Fig. 27 is another implementation of the image capture module in accordance with the tenth preferred embodiment of the present disclosure.
Fig. 28 is a photosensitive assembly in accordance with an eleventh preferred embodiment of the present disclosure.
Fig. 29A is a schematic view showing a process of forming the photosensitive assembly in accordance with the eleventh preferred embodiment of the present disclosure.
Fig. 29B is a perspective view of the photosensitive assembly in accordance with the eleventh preferred embodiment of the present disclosure.
Figs. 30A and 30B are schematic views showing a process of manufacturing the photosensitive assembly through a manufacturing apparatus in accordance with the eleventh preferred embodiment of the present disclosure.
Fig. 31 is a first modified implementation of the photosensitive assembly in accordance with the eleventh preferred embodiment of the present disclosure.
Figs. 32A and 32B are schematic views showing a process of manufacturing the modified implementation of the photosensitive assembly through a manufacturing apparatus in accordance with the eleventh preferred embodiment of the present disclosure.
Fig. 33 is a second modified implementation of the photosensitive assembly in accordance with the eleventh preferred embodiment of the present disclosure.
Fig. 34 is a photosensitive assembly in accordance with a twelfth preferred embodiment of the present disclosure.
Figs. 35A and 35B is a schematic view showing a process of forming the photosensitive assembly in accordance with the twelfth preferred embodiment of the present disclosure.
Figs. 36A, 36B and 36C are schematic views showing a process of manufacturing the photosensitive assembly through a manufacturing apparatus in accordance with the twelfth preferred embodiment of the present disclosure.
Fig. 37 is a photosensitive assembly in accordance with a thirteenth preferred embodiment of the present disclosure.
Fig. 38 is a photosensitive assembly in accordance with a fourteenth preferred embodiment of the present disclosure.
Fig. 39 is an array image capture module in accordance with a fifteenth preferred embodiment of the present disclosure.
Fig. 40 is a schematic view of the application of the image capture module in accordance with the above embodiment of the present disclosure.
Fig. 41 is a block diagram showing a method of manufacturing the photosensitive assembly in accordance with the above preferred embodiments of the present disclosure.
Fig. 42A is a block diagram of an electronic device in accordance with a preferred embodiment of the present disclosure.
Fig. 42B is a perspective view of the electronic device in accordance with the above preferred embodiments of the present disclosure.
Fig. 43 is a perspective view of an image capture module in accordance with a preferred embodiment of the present disclosure.
Fig. 44 is an exploded view of the image capture module in accordance with the above preferred embodiments of the present disclosure.
Fig. 45A is a cross-sectional view showing a molded circuit board assembly of the image capture module according to the above preferred embodiments of the present disclosure, which depicts a lead wire for conductively connecting a photosensitive assembly and a circuit board of the molded circuit board assembly being in a wire bonding direction from the circuit board to the photosensitive element.
Fig. 45B is a cross-sectional view showing a molded circuit board assembly of the image capture module according to the above preferred embodiments of the present disclosure, which depicts the lead wire for conductively connecting a photosensitive assembly and a circuit board of the molded circuit board assembly being in a wire bonding direction from the photosensitive element to the circuit board.
Fig. 45C is a cross-sectional view showing a molded circuit board assembly of the image capture module according to the above preferred embodiments of the present disclosure, which depicts the lead wire for conductively connecting a photosensitive assembly and a circuit board of the molded circuit board assembly being formed between the photosensitive element and the circuit board by a flattening bonding process.
Fig. 45D is a cross-sectional view of the molded circuit board assembly of the image capture module in accordance with the above preferred embodiments of the present disclosure, where the photosensitive chip is conductively connected to the circuit board by a flip chip process.
Fig. 46A is an enlarged schematic view of Fig. 45A at position S.
Fig. 46B is an enlarged schematic view of Fig. 45B at position S'.
Fig. 46C is an enlarged schematic view of Fig. 45C at position S".
Fig. 46D is an enlarged schematic view of Fig. 45D at position S‴.
Fig. 47 is a schematic view showing a first step of the steps of manufacturing the image capture module according to the above preferred embodiments of the present disclosure.
Fig. 48 is a schematic view showing a second step of the steps of manufacturing the image capture module according to the above preferred embodiments of the present disclosure.
Figs. 49A to 49D are schematic views of a third step of the steps of manufacturing the image capture module according to the above preferred embodiments of the present disclosure, respectively, which depict a molding die for molding the molded circuit board assembly.
Fig. 50 is a schematic view showing a fourth step of the steps of manufacturing the image capture module according to the above preferred embodiments of the present disclosure.
Fig. 51 is a schematic view showing a fifth step of the steps of manufacturing the image capture module according to the above preferred embodiments of the present disclosure.
Fig. 52 is a schematic view showing a sixth step of the steps of manufacturing the image capture module according to the above preferred embodiments of the present disclosure.
Fig. 53 is an enlarged schematic view of Fig. 52 at position T.
Fig. 54 is a schematic view showing a seventh step of the steps of manufacturing the image capture module according to the above preferred embodiments of the present disclosure.
Fig. 55 is a schematic view showing an eighth step of the steps of manufacturing the image capture module according to the above preferred embodiments of the present disclosure.
Fig. 56 is a schematic view showing a ninth step of the steps of manufacturing the image capture module according to the above preferred embodiments of the present disclosure.
Fig. 57A is a schematic view showing a tenth step of the steps of manufacturing the image capture module according to the above preferred embodiments of the present disclosure, which depicts an implementation of the image capture module.
Fig. 57B is a schematic view showing a tenth step of the steps of manufacturing the image capture module according to the above preferred embodiments of the present disclosure, which depicts another implementation of the image capture module.
Fig. 58 is a modified embodiment of the molded circuit board assembly of the image capture module in accordance with the above preferred embodiments of the present disclosure.
Fig. 59 is a modified embodiment of the molded circuit board assembly of the image capture module in accordance with the above preferred embodiments of the present disclosure.
Fig. 60 is a modified embodiment of the molded circuit board assembly of the image capture module in accordance with the above preferred embodiments of the present disclosure.

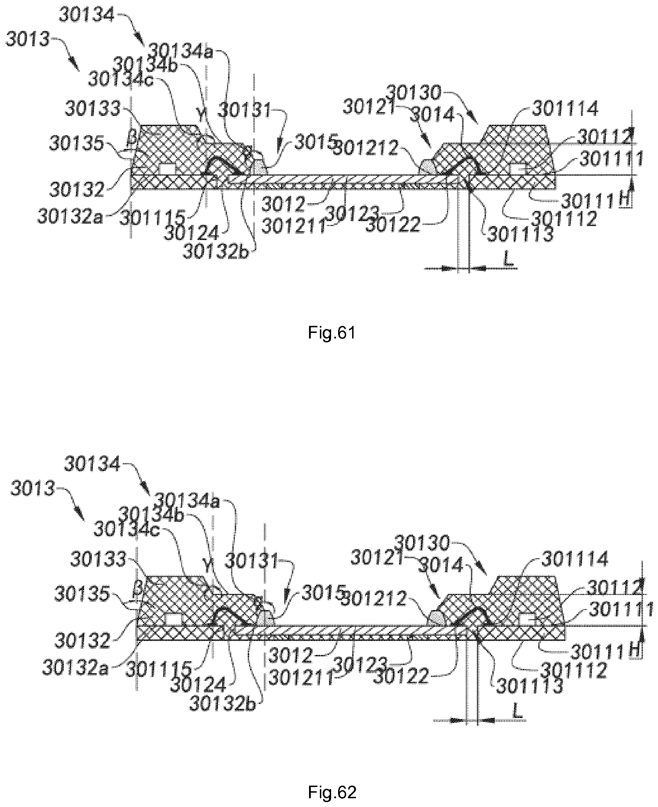

Fig. 61 is a modified embodiment of the molded circuit board assembly of the image capture module in accordance with the above preferred embodiments of the present disclosure.
Fig. 62 is a modified embodiment of the molded circuit board assembly of the image capture module in accordance with the above preferred embodiments of the present disclosure.

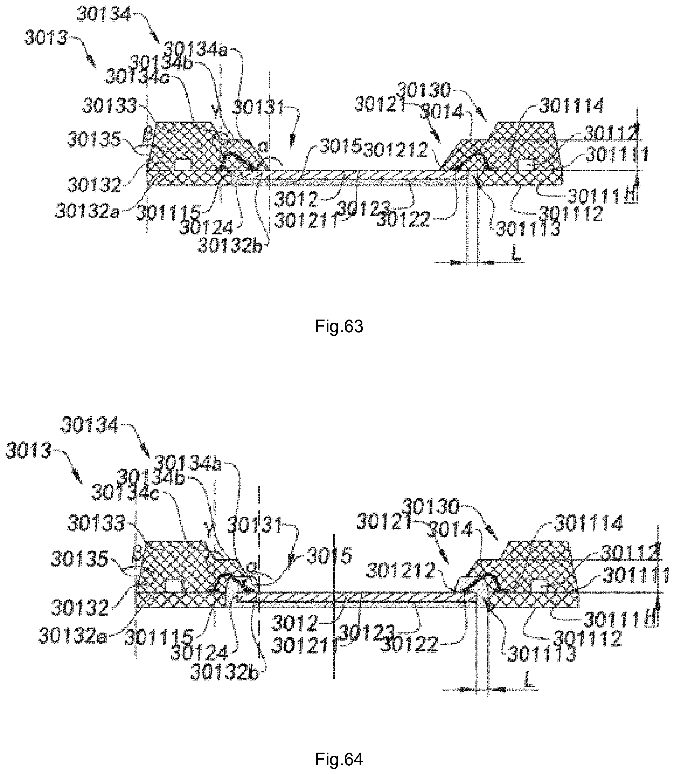

Fig. 63 is a modified embodiment of the molded circuit board assembly of the image capture module in accordance with the above preferred embodiments of the present disclosure.
Fig. 64 is a modified embodiment of the molded circuit board assembly of the image capture module in accordance with the above preferred embodiments of the present disclosure.
Fig. 65 is a modified embodiment of the molded circuit board assembly of the image capture module in accordance with the above preferred embodiments of the present disclosure.
Fig. 66 is a modified embodiment of the molded circuit board assembly of the image capture module in accordance with the above preferred embodiments of the present disclosure.
Fig. 67 is a partial cross-sectional view of the molded circuit board assembly of the image capture module according to the above preferred embodiments of the present disclosure, which depicts a relationship of a first included angle α, a second included angle β, and a third included angle γ.
Fig. 68 is a partial cross-sectional view of the molded circuit board assembly of the image capture module according to the above preferred embodiments of the present disclosure, which depicts a relationship of the first included angle α, the second included angle β, and the third included angle γ.
Fig. 69 is a partial cross-sectional view of the molded circuit board assembly of the image capture module according to the above preferred embodiments of the present disclosure, which depicts a relationship of the first included angle α, the second included angle β, and the third included angle γ.
Fig. 70 is a partial cross-sectional view of the molded circuit board assembly of the image capture module according to the above preferred embodiments of the present disclosure, which depicts a relationship of the first included angle α, the second included angle β, and the third included angle γ.
Fig. 71 is a partial cross-sectional view of the molded circuit board assembly of the image capture module according to the above preferred embodiments of the present disclosure, which depicts a relationship of the first included angle α, the second included angle β, and the third included angle γ.
Fig. 72 is a partial cross-sectional view of the molded circuit board assembly of the image capture module according to the above preferred embodiments of the present disclosure, which depicts a relationship of the first included angle α, the second included angle β, and the third included angle γ.
Fig. 73 is a partial cross-sectional view of the molded circuit board assembly of the image capture module according to the above preferred embodiments of the present disclosure, which depicts a relationship of the first included angle α, the second included angle β, and the third included angle γ.
Fig. 74 is a partial cross-sectional view of the molded circuit board assembly of the image capture module according to the above preferred embodiments of the present disclosure, which depicts a relationship of the first included angle α, the second included angle β, and the third included angle γ.
Fig. 75 is a partial cross-sectional view of the molded circuit board assembly of the image capture module according to the above preferred embodiments of the present disclosure, which depicts a relationship of the first included angle α, the second included angle β, and the third included angle γ.
Fig. 76 is a partial cross-sectional view of the molded circuit board assembly of the image capture module according to the above preferred embodiments of the present disclosure, which depicts a relationship of the first included angle α, the second included angle β, and the third included angle γ.
Fig. 77 is a partial cross-sectional view of the molded circuit board assembly of the image capture module according to the above preferred embodiments of the present disclosure, which depicts a relationship of the first included angle α, the second included angle β, and the third included angle γ.
Fig. 78 is a partial cross-sectional view of the molded circuit board assembly of the image capture module according to the above preferred embodiments of the present disclosure, which depicts a relationship of the first included angle α, the second included angle β, and the third included angle γ.

### Detailed description of the embodiments

The following description is presented to disclose the invention to enable those skilled in the art to practice the present invention. The preferred embodiments in the following description are by way of example only, and other obvious variations will occur to those skilled in the art.

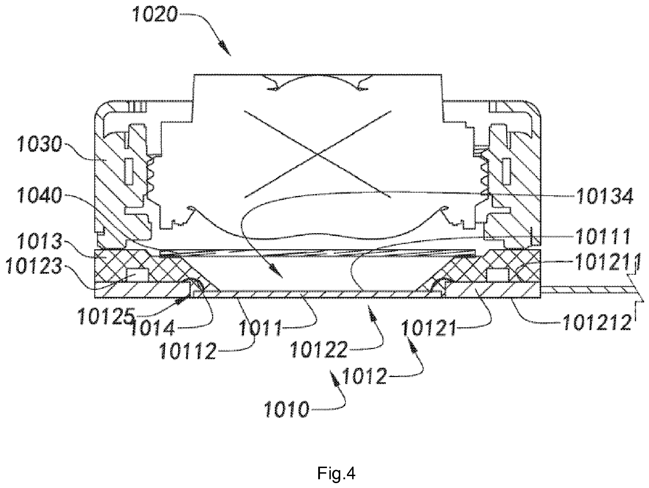

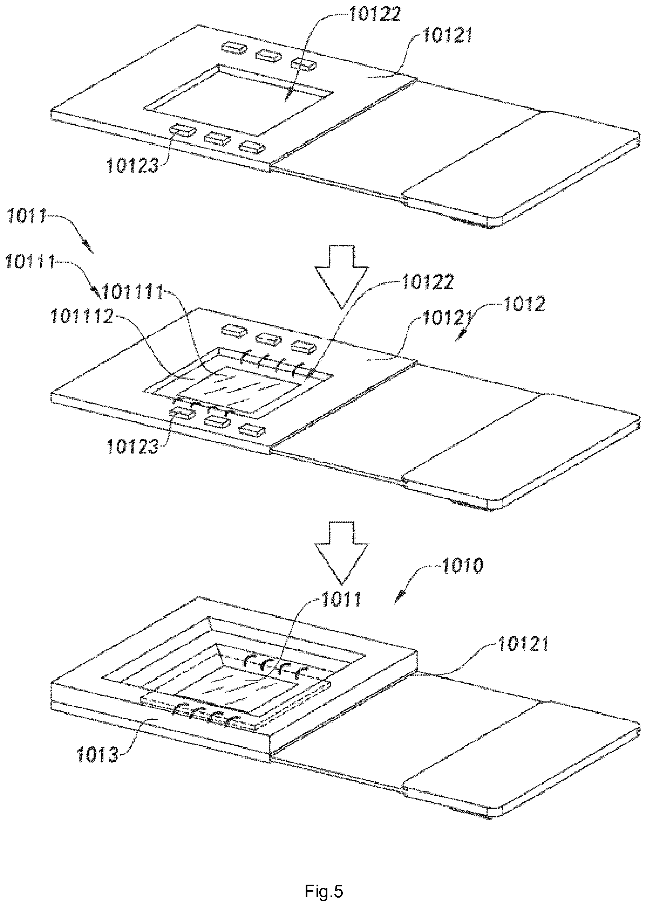

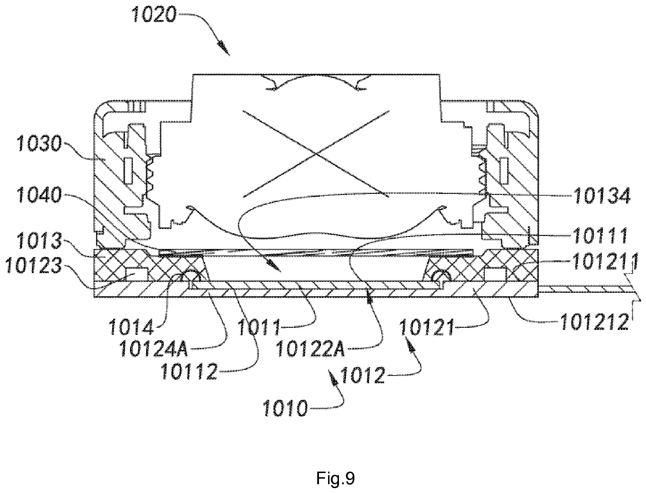

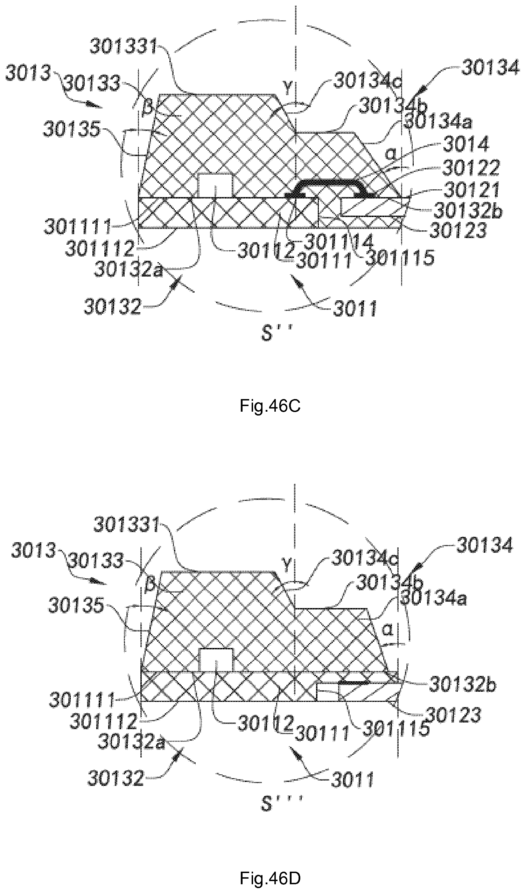

Nevertheless, the embodiments of Figs. 9-11, 18, 25A-25B, 26A-26B, 27, 28, 29A-29B, 30A-30B, 33, 37-39, 45D, 46D and 58 are not covered by the claimed invention, since there is no gap formed between the photosensitive element and the circuit board main body, for the packaging body extending thereinto and overmolding the bottom surface or back surface of the photosensitive element. In addition, Figs. 1-5, 6A, 7-8, 12-17, 19-24, 34-36C, 40-44, 59-60 and 65 (or the corresponding embodiments) are not covered by the claims, since they do not show the packaging body overmolding the bottom surface or back surface of the photosensitive element. The embodiments / aspects / examples, which are not according to the invention, are present for illustration purposes only.

It should be understood by those skilled in the art that in the disclosure of the present application, the orientation or positional relationship indicated by the terms "longitudinal", "transverse", "upper", "lower", "front", "back", "left", "right", " "upright", "horizontal", "top", "bottom", "inside", "outside", etc. is based on the orientation or positional relationship shown in the figures, which is merely for the convenience of describing the present disclosure and simplifying the description, and does not indicate or imply that the mentioned device or element must have a particular orientation and be constructed and operated in a particular orientation. Therefore, the above terms are not to be construed as limiting the present disclosure.

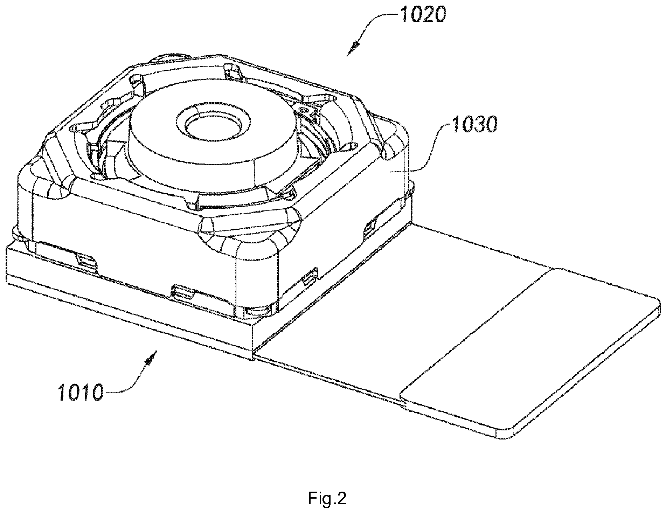

An image capture module according to the first preferred embodiment of the present disclosure is shown in Figs. 2 to 5. The image capture module includes at least one photosensitive assembly 1010, at least one lens 1020, and at least one filter 1040.

The filter 1040 is mounted to the photosensitive assembly 1010 and is located in the photosensitive path of the photosensitive assembly 1010. The lens 1020 is located in the photosensitive path of the photosensitive assembly 1010. For example, during image acquisition, light reflected by a target object enters the interior of the image capture module through the lens 1020, and the light reaches the photosensitive assembly 1010 through the optical effect of the lens 1020 and the filter 1040. Through the photosensitive action of the photosensitive assembly 1010, photoelectric conversion is performed on the light to convert the optical signal into an electrical signal, and then the electrical signal is transmitted to an electronic device applying the image capture module through the photosensitive assembly 1010, realizing image reproduction. That is, the image acquisition process of the target object is completed.

Further, the image capture module may further include at least one driver 1030, the lens 1020 is mounted on the driver 1030, and the driver 1030 is mounted on the photosensitive assembly 1010, so that the lens 1020 is located in the photosensitive path of the photosensitive assembly 1010, and the focal length of the image capture module can be adjusted by the driver 1030. The driver 1030 can be implemented as a motor, such as, but not limited to, a voice coil motor, or a piezoelectric motor. That is, in this embodiment of the present disclosure, the image capture module is an AFM (Automatic Focus Model). Of course, in other embodiments of the present disclosure, the image capture module may be of other types, such as a FFM (Fixed focus Model). It will be understood by those skilled in the art that the type of image capture module is not limiting to the present disclosure.

The filter 1040 may be an infrared cut-off filter, a wafer level infrared cut-off filter or a blue glass filter. It will be understood by those skilled in the art that the specific type of filter 1040 is not limiting to the present disclosure.

The photosensitive assembly 1010 includes at least one photosensitive element 1011, at least one window-form circuit board 1012, and at least one packaging body 1013. The photosensitive element 1011 and the window-form circuit board 1012 are arranged in a spatially overlapping manner to reduce the relative height of the photosensitive element 1011 and the window-form circuit board 1012. The photosensitive element 1011 and the window-form circuit board 1012 are integrally packaged by the packaging body 1013.

The packaging body 1013 has at least one light window 10134 for providing a light path for the photosensitive element 1011. That is, the light entering from the lens 1020 passes through the light window 10134 to reach the photosensitive element 1011 for photoelectric conversion.

In this embodiment of the present disclosure, the inside of the packaging body 1013 is formed with a stepped structure to facilitate mounting the filter 1040. Of course, the stepped structure may also be used to mount the driver 1030 or the lens 1020, and it will be understood by those skilled in the art that the mounting components of the packaging body 1013 are not limiting to the present disclosure.

The photosensitive element 1011 includes a top surface 10111 and the bottom surface 10112. The top surface 10111 is opposite to the lens 1020 for photoelectric conversion.

Further, the top surface 10111 of the photosensitive element 1011 includes a photosensitive region 101111 and a non-photosensitive region 101112, the photosensitive region 101111 for performing photosensitization, the non-photosensitive region 101112 for electrically connecting to the window-form circuit board 1012, thereby transmitting an electrical signal after photoelectric conversion by the photosensitive region 101111 to the window-form circuit board 1012. In an implementation, the photosensitive element 1011 may be implemented as a square CCD or CMOS chip, and the non-photosensitive region 101112 surrounds the periphery of the photosensitive region 101111. The window-form circuit board 1012 may include a pre-embedded circuit for processing the electrical signal transmitted by the photosensitive element 1011.

The packaging body 1013 integrally packages at least a part of the non-photosensitive region 101112 of the photosensitive element 1011. That is, the packaging body 1013 may package a partial region of the non-photosensitive region 101112 of the photosensitive element 1011, and may also package the entire region of the non-photosensitive region 101112 of the photosensitive element 1011.

The photosensitive element 1011 is electrically connected to the window-form circuit board 1012 through at least one electrical connection element 1014, thereby realizing electrical signal transmission of the photosensitive element 1011 and the window-form circuit board 1012. The electrical connection element 1014 can be a connection element made of one or more of gold, silver, copper, aluminum and conductive non-metal, such as, but not limited to, a gold wire, a silver wire, a copper wire, an aluminum wire. In one manufacturing method, the electrical connection element 1014 is disposed on the photosensitive element 1011 and the window-form circuit board 1012 by a W/B (Wired/Bond) process. Further, the electrical connection element 1014 connects the non-photosensitive region 101112 of the photosensitive element 1011 and the window-form circuit board 1012.

The photosensitive assembly 1010 includes at least one electronic component 10123, and the electronic component 10123 protrudes from the window-form circuit board 1012. The electronic component 10123 is electrically connected to the window-form circuit board 1012. The electronic component 10123 can be a resistor, a capacitor, a driving element, a signal processing element, a memory element, or the like. The electronic component 10123 is an electronic component 10123 of the window-form circuit board 1012, and completes the transmission of the electrical signal. In other embodiments, the electronic component 10123 may not be protruded or the electronic component may be embedded in the window-form circuit board 1012. It should be understood by those skilled in the art that the type and arrangement of the electronic component 10123 are not limiting to the present disclosure.

The electronic component 10123 and the electrical connection element 1014 are packaged in the packaging body 1013. In other words, the electrical connection element 1014 and the electronic component 10123 are overmolded by the packaging body 1013, and thus cannot be exposed to the external environment. In the existing method, the connecting gold wire and the capacitance-resistance component are usually exposed to the outside. On the one hand, dust contaminated on the gold wire and the capacitance-resistance component may affect the image quality of the image capture module. On the other hand, the installation space for the gold wire and the capacitance-resistance component needs to be reserved, thereby causing the waste of space of the image capture module.

The window-form circuit board 1012 includes a circuit board main body 10121, and the window-form circuit board 1012 has a window 10122. The window 10122 is disposed on the circuit board main body 10121 to form a window-form circuit board. The photosensitive element 1011 is received in the window 10122, thereby reducing the space occupied additionally by the photosensitive element 1011.

That is, the photosensitive element 1011 is received in the window 10122 of the window-form circuit board 1012, so that the photosensitive element 1011 is sunk relative to the position of the circuit board main body 10121, and thus the relative height of the photosensitive element 1011 and the circuit board main body 10121 is reduced. When the height of the top surface 10111 of the photosensitive element 1011 is not higher than the top surface 101211 of the circuit board main body 10121, the circuit board main body 1011 provides a sufficient space environment for the photosensitive element 1011, and the overall height of the photosensitive element 1011 and the circuit board main body 10121 is presented only as the height of the circuit board main body 10121.

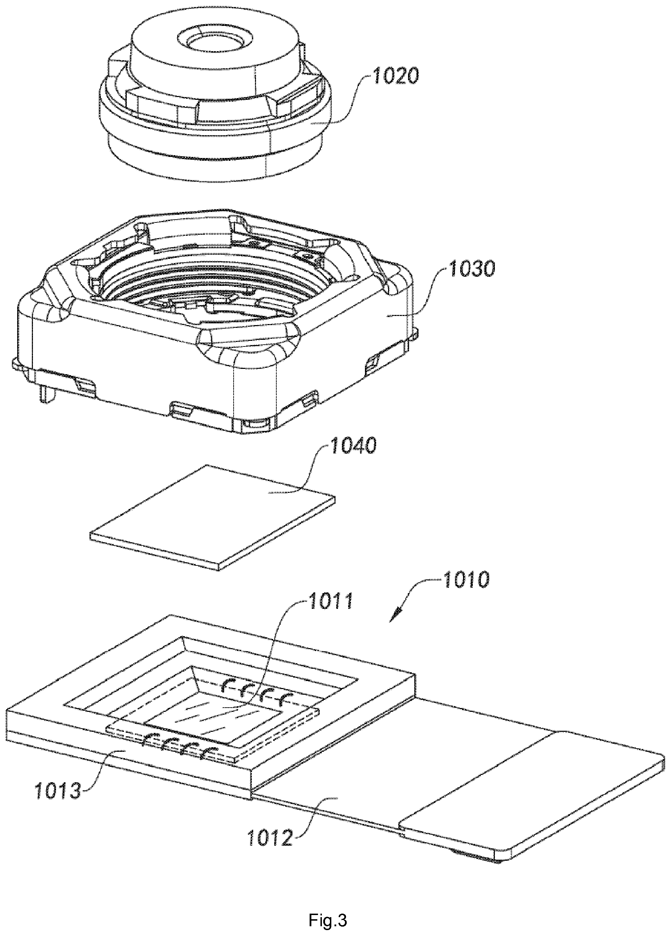

The circuit board main body 10121 has a top surface 101211 and the bottom surface 101212. The packaging body 1013 is packaged on the top surface 101211 of the circuit board main body 10121 and the non-photosensitive region 101112 of the top surface 10111 of the photosensitive element 1011. The size of the window 10122 of the window-form circuit board 1012 may be set according to the size of the photosensitive element 1011, and may be equivalent to the size of the photosensitive element 1011, so that the window 10122 is adapted to receive the photosensitive element 1011. It may also be larger than the photosensitive element 1011, and it is convenient to adjust the photosensitive element 1011 while receiving the photosensitive element 1011. In an implementation process, a gap 10125 may be reserved between the photosensitive element 1011 and the window-form circuit board 1012 for easy installation, and the gap 10125 is filled by the packaging body 1013 to fix the photosensitive element 1011. Referring to Fig. 3, in an implementation, the packaging body 1013 enters the gap 10125, and fills a space between the circuit board main body 10121 and the photosensitive element 1011, so that a position where the packaging body 1013 extends into the gap 10125 is substantially the same in height as the bottom surface 10112 of the photosensitive element 1011 and the bottom surface 101212 of the circuit board main body 10121. Thus, the packaging body 1013 can reinforce the photosensitive element 1011 and the window-form circuit board 1012.

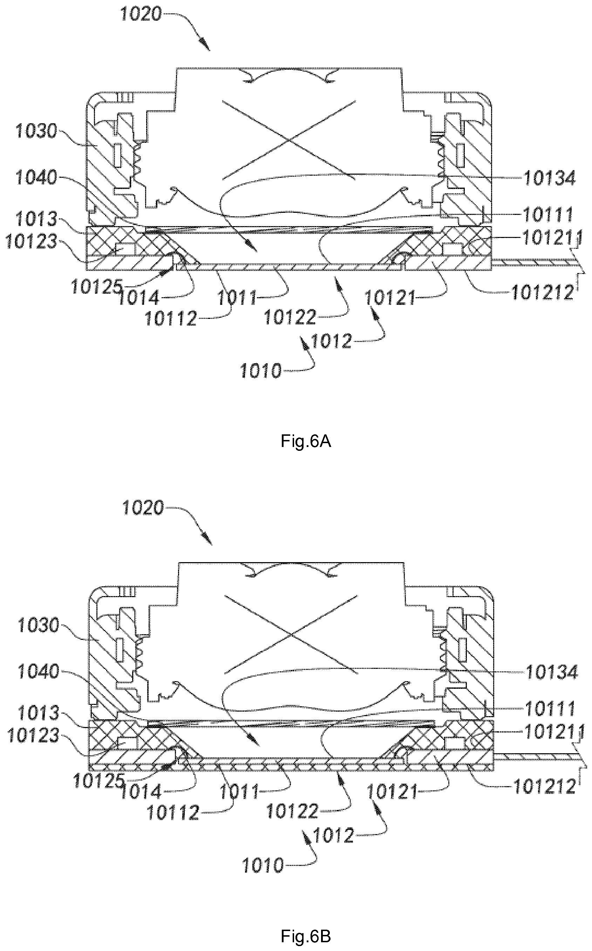

Referring to Fig. 6A, in another implementation, the packaging body 1013 does not enter the gap 10125, and the packaging body 1013 is substantially the same in height as the top surface 10111 of the photosensitive element 1011 and the top surface 101211 of the circuit board main body 10121. However, in the implementation process, the photosensitive element 1011 and the circuit board main body 10121 are bonded by adhesive bonding, such as glue, to block the packaging body 1013 from entering the gap 10125. Referring to Fig. 6B, in another implementation, the packaging body 1013 extends into the gap 10125 and overmolds the bottom portion of the photosensitive assembly 1010 through the gap 10125. It should be understood by those skilled in the art that the relationship between the gap 10125 and the packaging body 1013 and the gap 1013 can be set as needed, and the size of the gap 10125 and the position where the packaging body 1013 extends in the gap 10125 are not limiting to the present disclosure.

It should be noted that in another embodiment, the circuit board main body 10121 may not be spaced apart from the photosensitive element 1011 to form the gap 10125, but may be in direct contact. It should be noted that when the packaging body 1013 reinforces the window-form circuit board 1012 and the photosensitive element 1011, unlike the prior art that requires to add a reinforcing plate at the bottom of the circuit board, the packaging body can function to reinforce the window-form circuit board 1012. Of course, the back side of the window-form circuit board 1012 of the present disclosure may further be provided with a reinforcing plate to further enhance the packaging strength of the photosensitive assembly 1010.

In the process of manufacturing the photosensitive assembly 1010, a circuit board substrate is first windowed to form the window-form circuit board 1012 having the window 10122, and then the photosensitive element 1011 is disposed in the window 10122 (the photosensitive element 1011 and the window-form circuit board 1012 may also be fixed by glue). Subsequently, the photosensitive element 1011 and the circuit board main body 10121 are electrically connected through the electrical connection element 1014, such as bonding. Next, the non-photosensitive region 101112 of the photosensitive element 1011, the electrical connection element 1014, the electronic component 10123, and the window-form circuit board 1012 are integrally packaged in a manner of integrally packaging.

The material of the circuit board main body 10121 may be a Rigid-flex board RG (Rigid Flex), a flexible printed circuit board FPC (Flex Print Circuit), a rigid printed circuit board PCB (Printed Circuit Board), a ceramic substrate, or the like.

It should be noted that a packaging region of the non-photosensitive region 101112 of the photosensitive element 1011 can be set as needed. That is, the non-photosensitive region 101112 can be completely packaged or partially packaged. It should be understood by those skilled in the art that the size and shape of the packaging region are not limiting to the present disclosure.

In the present disclosure, the packaging body 1013 is integrally formed by a molding process and adheres to a circuit board, which is different from a conventional base. When the photosensitive assembly 1010 is manufactured, the photosensitive element 1011 and the window-form circuit board 1012 are placed into a die, and then a molding material is applied into the die. The molding material forms the packaging body 1013 of a predetermined shape after curing, and the photosensitive element 1011 and the window-form circuit board 1012 are fixed by the packaging body 1013. The molding material may be selected from a group consisting of nylon, LCP (Liquid Crystal Polymer), PP (Polypropylene), epoxy resin, and other thermoplastic or thermosetting materials.

This integrated packaging method reduces the conventional process of bonding the base with glue, and the packaging body 1013 is manufactured by molding, its shape is easier to control and its surface flatness is better, so that flat mounting conditions can be provided for the filter 1040, the driver 1030 and the lens 1020 to facilitate ensuring the consistency of the optical axis of the image capture module. On the other hand, the conventional glue bonding space is reduced, which helps to reduce the height of the image capture module. Further, in the embodiment of the present disclosure, the photosensitive element 1011 is disposed in the window 10122 and then integrally packaged, so that it is not necessary to consider the thickness of the photosensitive element 1011 when forming the packaging body 1013, thereby further providing a possible space for reducing the height of the image capture module.

The packaging body 1013 has a ring-shaped structure in a plan view, such as, but not limited to, a square, a circle, and a triangle, to facilitate providing a mounting position for the filter 1040, the driver 1030, or the lens 1020. Thus, when the driver 1030 or the lens 1020 is mounted on the packaging body 1013, a closed inner environment is formed. Moreover, by virtue of the advantages of molded integrated packaging, the surface of the packaging body 1013 can be ensured to be flat, thereby providing flat mounting conditions for the filter 1040, the lens 1020 or the driver 1030.

According to this embodiment of the present disclosure, the window 10122 is a through hole, that is, the window 10122 is in communication with both sides of the circuit board main body 10121, thereby providing an adjustable space for the photosensitive element 1011. In other words, the relative position of the photosensitive element 1011 in the window 10122 and the circuit board main body 10121 can be set as needed.

It is to be noted that, in the present disclosure, the photosensitive element 1011 and the window-form circuit board 1012 are integrally packaged by the packaging body 1013, so that when the photosensitive element 1011 is disposed in the window 10122, additional support member are not required to fix the photosensitive element 1011, and thus the position of the photosensitive element 1011 can be relatively freely selected. In other words, the packaging body 1013 provides a fixing function respectively for the photosensitive element 1011 and the circuit board main body 10121 from above, so that it is not necessary for the circuit board main body 10121 or other components to provide supporting and fixing functions for the photosensitive element 1011 from other directions, such as from below. And the structural strength of the circuit board main body 10121 and the photosensitive element 1011 can be enhanced by the integrally packaging function of the packaging body 1013.

Further, according to this implementation of the present disclosure, the photosensitive element 1011 is disposed near a position below the window 10122, and one end of the electrical connection element 1014 is connected to the non-photosensitive region 101112 of the photosensitive element 1011 and the other end of the connection is connected to the circuit board main body 10121 through the window 10122.

Further, the bottom surface 10112 of the photosensitive element 1011 and the bottom surface 101212 of the circuit board main body 10121 are relatively the same in height, so that the bottom of the photosensitive assembly 1010 is relatively flat without significant steps. In other words, the bottom surface 10112 of the photosensitive element 1011 is substantially flush with the bottom surface 101212 of the circuit board main body 101212.

In this manner, the bottom surface 10112 of the photosensitive element 1011 is exposed in the external space, thereby enhancing the heat dissipation function of the photosensitive element 1011, which is different from the attaching manner where the bottom surface 10112 is blocked by the circuit board and has poor heat dissipation performance.

For example, the present disclosure provides two methods of manufacturing the window-form circuit boards 1012. In one method, substrate layers are first opened with the window 10122, the size of the window 10122 being determined according to the photosensitive element 1011, and then the substrate layers are laminated and a circuit is buried between predetermined substrate layers, thereby forming a form circuit board 1012 having the window 10122. In another method, the substrate layers are laminated, and a circuit is buried between the substrate layers in a predetermined route, and the buried route is determined according to the placement position of the photosensitive element 1011. Then, the window 10122 is opened in the laminated substrate layers. The window 10122 is within the embedded circuit, and is determined according to the shape of the photosensitive element 1011. That is, it does not damage the circuit.

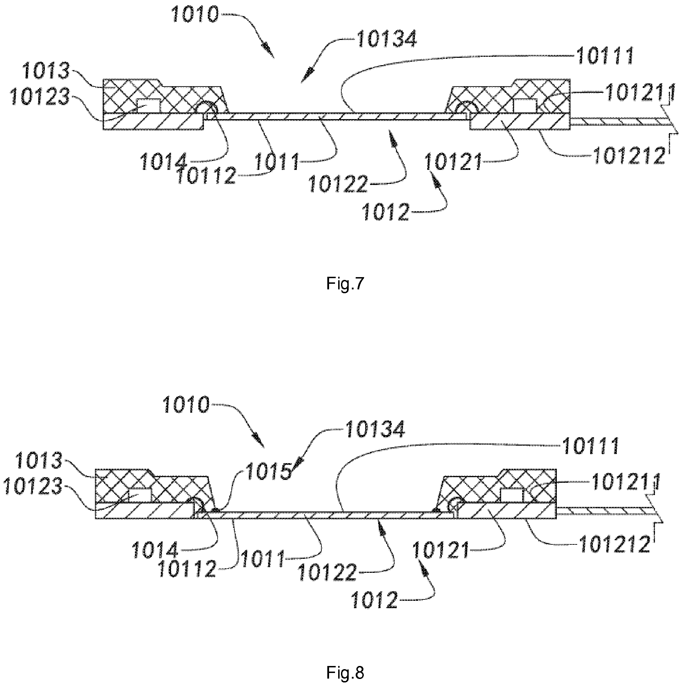

The first modified implementation of the photosensitive assembly 1010 of the image capture module in accordance with the first preferred embodiment of the present disclosure is as shown in Fig. 7. Unlike the above implementation, in this implementation, the top surface 10111 of the photosensitive element 1011 and the top surface 101211 of the circuit board main body 10121 are relatively the same in height. That is, the top surface 10111 of the photosensitive element 1011 is substantially flush with the top surface 101211 of the circuit board main body 10121, and a space is reserved at a position below the photosensitive element 1011. In the case where the upper surfaces are flush, the photosensitive element 1011 and the window-form circuit board 1012 are electrically connected through the electrical connection element 1014.

In the process of manufacturing this photosensitive element 1011, a boss-shaped jig can be provided to support the photosensitive element 1011 so that the upper surfaces of the photosensitive element 1011 and the window-form circuit board 1012 are flush. Then, the photosensitive element 1011 and the window-form circuit board 1012 are integrally packaged to form the packaging body 1013, so that the relative positions of the photosensitive element 1011 and the window-form circuit board 1012 are fixed by the packaging body 1013.

The second modified implementation of the photosensitive assembly 1010 of the image capture module in accordance with the first preferred embodiment of the present disclosure is as shown in Fig. 8. Unlike the above implementation, in this implementation, the photosensitive element 1011 includes a barrier member 1015, and the barrier member 1015 is disposed at a position where the packaging body 1013 and the photosensitive element 1011 are in contact with each other, which is used to prevent the influence of the packaging body 1013 on the inner region of the photosensitive element 1011, such as contamination of the photosensitive region 101111. That is, the barrier member 1015 is disposed outside the photosensitive region 10111, to facilitate blocking the molding material in the fluid state from entering the photosensitive region 101111 in the manufacturing process, and protect the photosensitive element 1011 during the operation of the packaging die.

The barrier member 1015 has an annular or frame-shaped structure and is disposed on the photosensitive element 1011. That is, the position at which the inner edge of the packaging body 1013 and the photosensitive element 1011 are in contact with each other is blocked by the barrier member 1015.

The barrier member 1015 may be formed by a colloid or a plastic member of a predetermined shape.

In the process of manufacturing the photosensitive assembly 1010, before the photosensitive element 1011 and the window-form circuit board 1012 are integrally packaged, it is required to provide the barrier member 1015 on the photosensitive element 1011, such as coating glue. Then, the packaging body 1013 is formed with the barrier member 1015 as a boundary, so that the material of the packaging body 1013 does not contaminate the region of the photosensitive element 1011 located inside the barrier member 1015.

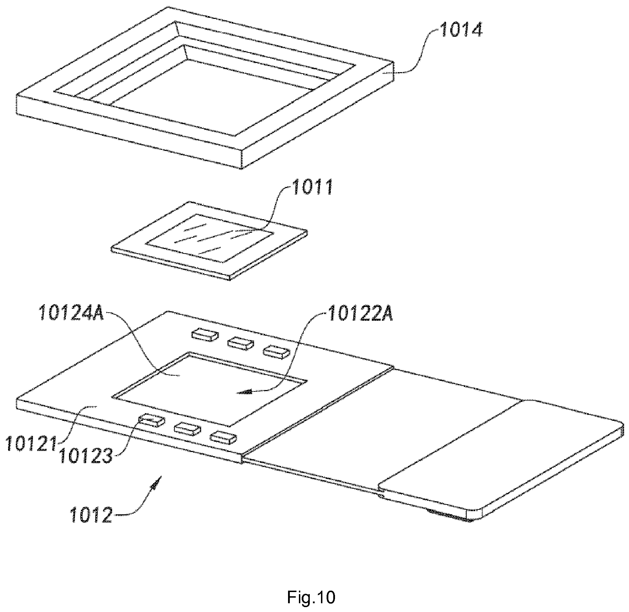

An image capture module according to the second preferred embodiment of the present disclosure is shown in Figs. 9 and 10. Unlike the above preferred embodiment, the window 10122A is a groove structure, that is, the photosensitive element 1011 is received in the groove structure, so that the relative height of the surfaces of the photosensitive element 1011 and the window-form circuit board 1012 is reduced. Further, when the depth of the groove structure is greater than or equal to the thickness of the photosensitive element 1011, the overall thickness of the photosensitive element 1011 and the window-form circuit board 1012 is represented as the thickness of the window-form circuit board 1012.

The window 10122A corresponds to a window bottom 10124A, and the photosensitive element 1011 is disposed on the window bottom 10124A. In other words, the window bottom 10124A supports the photosensitive element 1011. The size of the window 10122A may match the size of the photosensitive element 1011 so that the surfaces of the photosensitive element 1011 and the circuit board main body 10121 are flush. Of course, a gap may exist between the photosensitive element 1011 and the circuit board main body 10121, and then the photosensitive element 1011 and the circuit board main body 10121 may be fixed by an adhesive.

In this embodiment of the present disclosure, the electrical connection element 1014 is electrically connected to the photosensitive element 1011 and the circuit board main body 10121. That is, the electrical connection element 1014 connects the photosensitive element 1011 located within the window 10122A and the top surface 101211 of the circuit board main body outside the window 10122A.

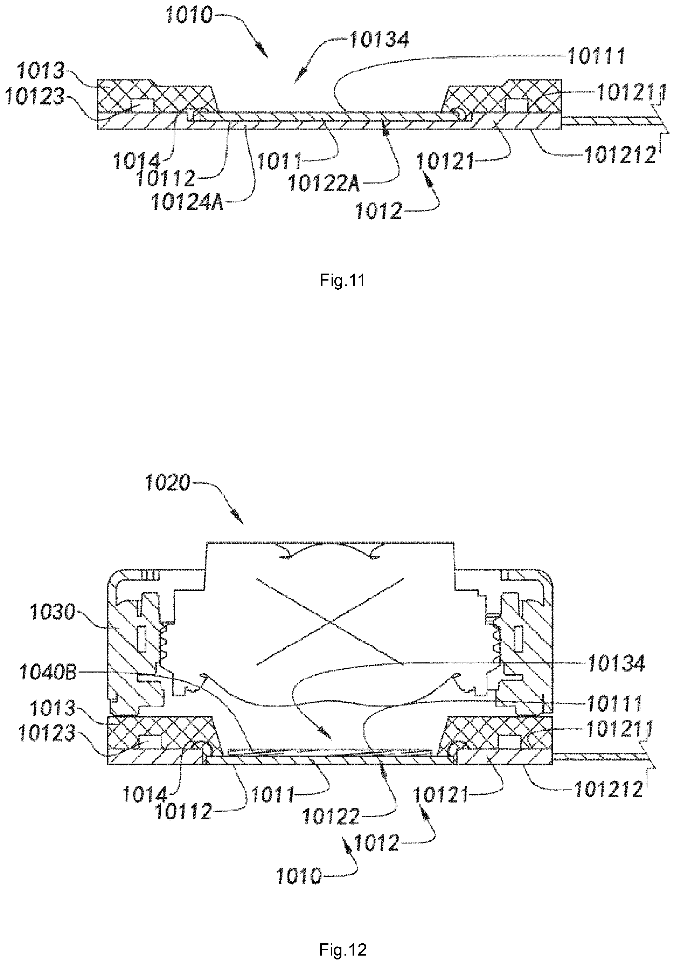

A modified implementation of the photosensitive assembly 1010 of the image capture module in accordance with the second preferred embodiment of the present disclosure is shown in Fig. 11. Unlike the above preferred embodiments, the electrical connection element 1014 is disposed in the window 10122A of the window-form circuit board 1012. Further, one end of the electrical connection element 1014 is connected to the non-photosensitive region 101112 of the photosensitive element 1011, and the other end is connected to the surface of the circuit board of the window bottom 10124A corresponding to the window 10122A. In comparison with the above implementation, since the electrical connection structure is to be provided on the circuit board surface 10124A of the window bottom of the circuit board main body 10121, and the processs of electrically connecting the electrical connection element 1014 and the photosensitive element 1011 is to be completed in a small space, the process is more difficult than the above implementation.

In comparison with the first preferred embodiment described above in the aspect of the manufacturing process, the process of the groove-like window 10122 of the second embodiment is more difficult than that of the window 10122A of the through-hole shape. Since the thickness of the circuit board is small, and the groove is provided on the circuit board having a small thickness, the process precision is required to be high. Moreover, if the electrical connection element 1014 is disposed in the groove, it is equivalent to set a circuit on a thinner circuit board, which is more difficult. Therefore, on the whole, the manner in which the window 10122A of the through-hole shape and the electrical connection element 1014 are connected to the outside is more suitable for implementation, and more space that the photosensitive element 1011 can be adjusted and better heat dissipation performance are provided.

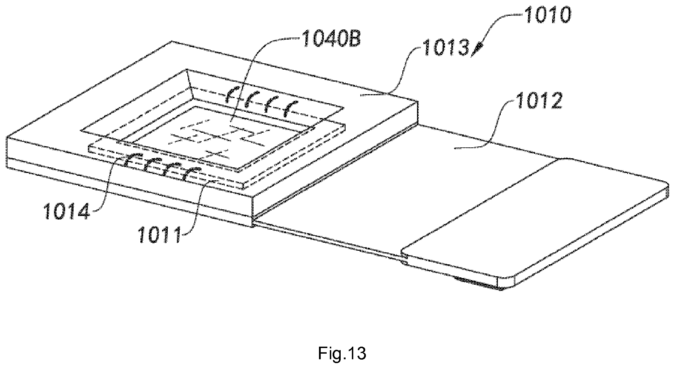

An image capture module according to the third preferred embodiment of the present disclosure is shown in Figs. 12 and 13. Unlike the above preferred embodiments, in this embodiment, the photosensitive assembly 1010 includes a filter 1040B and the filter 1040B is attached to the photosensitive element 1011. That is, the filter 1040B blocks the photosensitive element 1011, thereby reducing contamination of the photosensitive element 1011 and damage of the die to the photosensitive element 1011.

In this embodiment, the upper surface of the packaging body 1013 may be a flat planar structure, and it is not necessary to provide a stepped structure to mount the filter 1040B. The driver 1030 or the lens 1020 is mounted to the packaging body 1013.

For example, the filter 1040B may be attached to the photosensitive element 1011 by adhering. In other embodiments, the filter 1040B may also be attached to the photosensitive element 1011 by adsorption, and it should be understood by those skilled in the art that the specific attachment manner of the filter 1040B and the photosensitive element 1011 is not limiting to the present disclosure.

In this manner, the filter 1040B is disposed on the photosensitive element 1011. Thus, in the image capture module, it is not necessary to mount the filter 1040B on the packaging body 1013. Moreover, in this manner, the distance between the filter 1040B and the photosensitive element 1011 is reduced, thereby reducing the back focal length of the image capture module. As a result, the height of the image capture module can be further reduced.

In the process of manufacturing the photosensitive assembly 1010, the filter 1040B may be attached to the photosensitive element 1011 before the photosensitive element 1011 and the window-form circuit board 1012 are integrally packaged, so that the filter element 1040B blocks the photosensitive element 1011, in particular, the photosensitive region -101111 of the photosensitive element 1011. Therefore, in the integrally packaging process, the packaging material of the packaging body 1013 is prevented from contaminating the photosensitive element 1011 by the filter element 1040B blocking and protecting the photosensitive element 1011, thereby improving image quality. Of course, in other embodiments of the present disclosure, the filter 1040B may be disposed after the packaging body 1013 is formed, to reduce the back focal length of the image capture module. It should be understood by those skilled in the art that the order in which the filter 1040B is arranged is not limiting to the present disclosure.

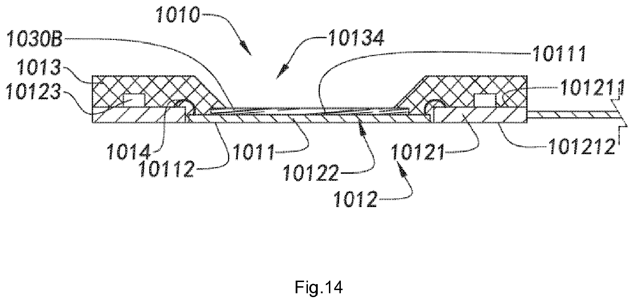

A modified implementation of the photosensitive assembly 1010 of the image capture module in accordance with the third preferred embodiment of the present disclosure is shown in Fig. 14. Unlike the above embodiment, in this embodiment, the photosensitive element 1011 includes a filter 1040B, the filter 1040B is attached to the photosensitive element 1011, and the outer edge of the filter 1040B is integrally packaged by the packaging body 1013. That is, the photosensitive element 1011, the window-form circuit board 1012, and the filter 1040B are all integrally packaged by the packaging body 1013, thereby fixing the filter 1040B. In manufacturing the photosensitive assembly 1010, the filter 1040B needs to be overlapped with the photosensitive element 1011 before the packaging body 1013 is formed. They may be bonded by glue or may not be bonded. Instead, the filter 1040B is fixed in a manner of integrally packaging.

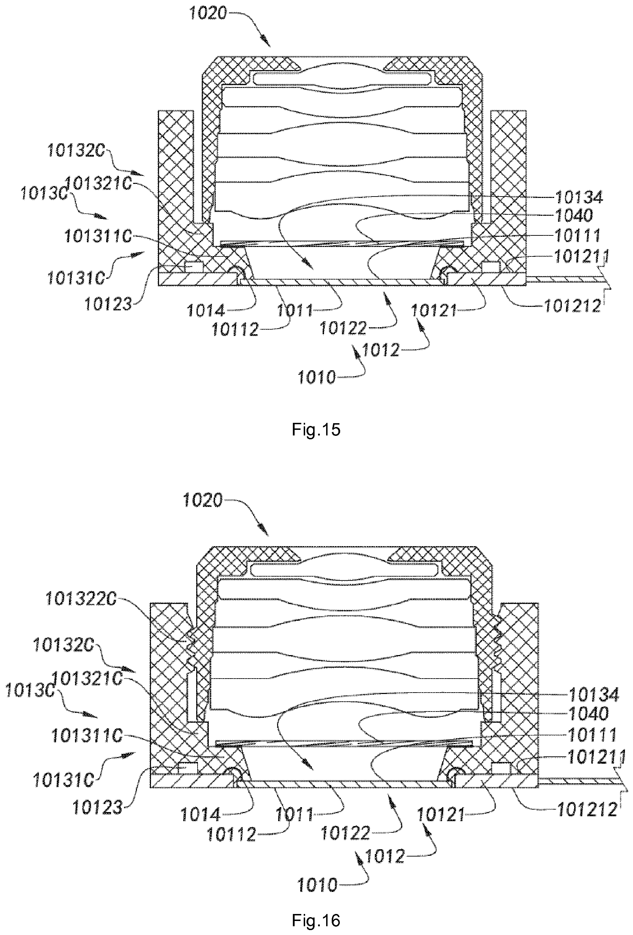

An image capture module according to the fourth preferred embodiment of the present disclosure is shown in Fig. 15. Unlike the above embodiment, the photosensitive assembly 1010 includes a packaging body 1013C, and the packaging body 1013C includes a bracket portion 10131C and a lens portion 10132C. The bracket portion 10131C is used for mounting the filter 1040, and the lens portion 10132C is used for mounting the lens 1020.

Further, the outside of the lens portion 10132C integrally extends upward along the bracket portion 10131C, and a stepped structure is formed inside. The bracket portion 10131C includes a first support table 101311C, and the filter 1040 is mounted on the first support table 101311C. The lens portion 10132C includes a second support table 101321C, and the lens 1020 is mounted on the second support table 101321C. That is, the first support table 101311C and the second support table 101321C form a step structure with two steps.

The lens portion 10132C extends integrally to facilitate providing a stable mounting environment for the lens 1020. According to this embodiment of the present disclosure, the depth of the lens portion 10132C can be determined according to the height of the lens 1020, to stably mount the lens 1020, and improve the accuracy of the image capture module.

In this manner, the lens 1020 is provided with an installation environment to form a fixed focus image capture module, and the lens 1020 can be provided with a flat and stable installation environment by means of molded integrated packaging.

Further, in this embodiment, the lens portion 10132C is internally flat and is adapted to be mounted with a non-threaded lens.

A modified implementation of the image capture module in accordance with the fourth preferred embodiment of the present disclosure is shown in Fig. 16. Unlike the above preferred embodiments, in this embodiment, the inside of the lens portion 10132C has a threaded structure 101322C, which is suitable for mounting a threaded lens. Of course, in other embodiments, the lens portion 10132C may also have other different structures inside to facilitate mounting different types of lenses.

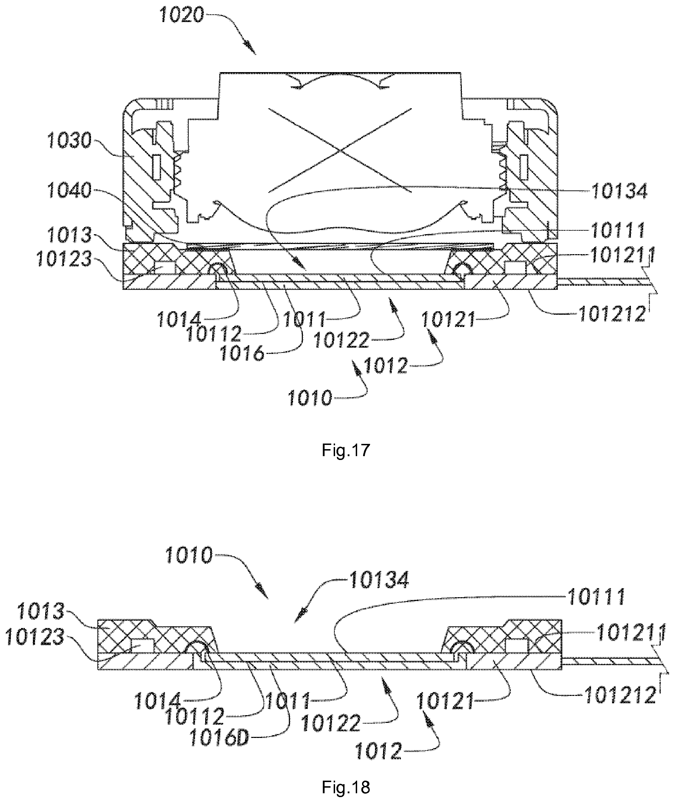

A cross-sectional view of an image capture module in accordance with the fifth preferred embodiment of the present disclosure is shown in Fig. 17. Unlike the preferred embodiment described above, the photosensitive assembly 1010 includes a substrate 1016 and the substrate 1016 is disposed below the photosensitive element 1011.

Further, the height of the bottom of the substrate 1016 and the height of the bottom surface 101212 of the circuit board main body 10121 are substantially the same, so that the bottom of the photosensitive assembly 1010 is kept flat. In other words, the substrate 1016 fills the remaining space of the window 10122 below the photosensitive element 1011, so that when the thickness of the photosensitive element 1011 is smaller than the thickness of the circuit board main body 10121, and the photosensitive element 1011 is disposed at a position near the top surface 101211 of the circuit board main body 10121, the bottom of the photosensitive assembly 1010 can still be kept flat without a significant step structure.

The substrate 1016 can enhance the structural strength and heat dissipation performance of the photosensitive assembly 1010. In an embodiment, the substrate 1016 can be a metal plate or a plastic plate. In another embodiment, the substrate 1016 may be a film layer attached to the lower surface 10112 of the photosensitive element 1011 in order to protect the photosensitive element 1011 and enhance the structural strength and heat dissipation performance of the photosensitive element 1011. By way of example and not limitation, the film layer is a metal coating.

The substrate 1016 may be mounted on the circuit board main body 10121 by bonding or may be attached to the photosensitive element 1011 by bonding.

Of course, in other embodiments, the substrate 1016 may be disposed below the circuit board main body 10121. For example, when the thickness of the photosensitive element 1011 is greater than the thickness of the circuit board main body 10121, the height difference between the photosensitive element 1011 and the circuit board main body 10121 can be compensated by the substrate 1016, so that the bottom of the photosensitive assembly 1010 is kept flat.

A modified implementation of the photosensitive assembly of the image capture module in accordance with the fifth preferred embodiment of the present disclosure is shown in Fig. 18. Unlike the above embodiment, the window-form circuit board 1012 includes a substrate 1016D, and the substrate 1016D is received in the window 10122 of the window-form circuit board 1012. The substrate 1016D has a groove-like structure, and the photosensitive element 1011 is received in the substrate 1016D. That is, the substrate 1016D provides a mounting position for the photosensitive element 1011 so that the photosensitive element 1011 and the top surface 101211 of the circuit board main body 10121 are flush, and the height of the lower surface of the substrate 1016D is substantially aligned with that of the bottom surface 101212 of the circuit board main body 10121, which causes the bottom of the photosensitive assembly 1010 to be flat.

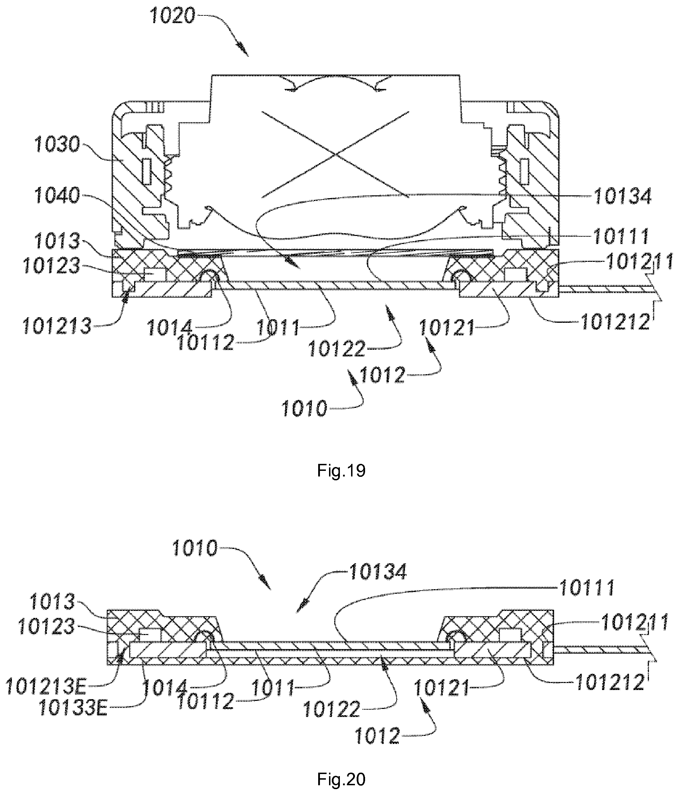

An image capture module according to the sixth preferred embodiment of the present disclosure is shown in Fig. 19. Unlike the above embodiment, the circuit board main body 10121 of the window-form circuit board 1012 has at least one reinforcing hole 101213, and the packaging body 1013 extends into the reinforcing hole 101213, thereby reinforcing the structural strength of the circuit board main body 10121. The number and depth of the reinforcing holes 101213 may be arranged as needed, and are disposed at a position where the circuit board 1012 is not provided with an electric circuit.

In this embodiment, the reinforcing holes 101213 are recessed holes, that is, the two sides of the circuit board main body 10121 are not communicated through the reinforcing holes 101213.

A modified implementation of the photosensitive assembly 1010 of the image capture module in accordance with the sixth preferred embodiment of the present disclosure is shown in Fig. 20. Unlike the above implementation, the circuit board main body 10121 of the window-form circuit board 1012 has at least one reinforcing hole 101213E, the packaging body 1013 extends into the reinforcing hole 101213E, and the reinforcing hole 101213E is a perforated hole. That is, both sides of the circuit board main body 10121 can be communicated through the reinforcing holes 101213E.

Further, the packaging body 1013 extends through the reinforcing holes 101213E to the bottom of the circuit board main body 10121 and the photosensitive element 1011, thereby forming a packaging layer 10133E at the bottom of the photosensitive assembly 1010. The packaging layer 10133E enhances the structural strength of the photosensitive assembly 1010.

That is, in this implementation, the packaging body 1013 is not only disposed on the upper portion of the circuit board main body 10121 and the photosensitive element 1011, but is also integrally disposed on the lower portion of the photosensitive element 1011. Of course, in other embodiments, the packaging layer 10133E may be disposed only below the circuit board main body 10121 and not below the photosensitive element 1011.

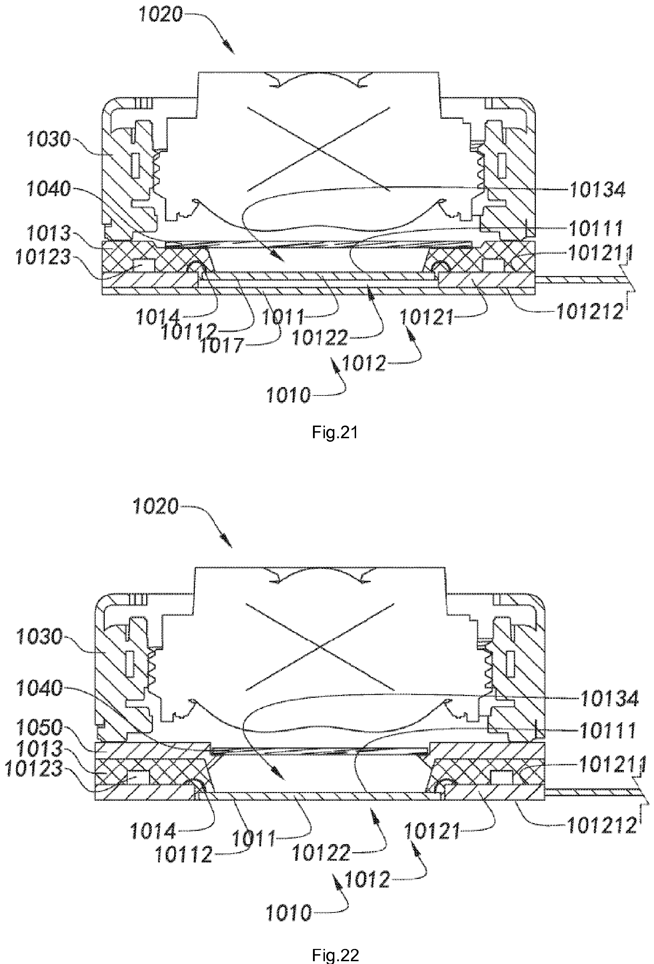

An image capture module according to the seventh preferred embodiment of the present disclosure is shown in Fig. 21. Unlike the above preferred embodiments, the photosensitive assembly 1010 includes a back plate 1017, and the back plate 1017 is disposed at the bottom of the circuit board main body 10121 to enhance the structural strength of the circuit board main body 10121, which causes the bottom of the photosensitive assembly 1010 to be flat. In an embodiment, the back plate 1017 may be a metal plate to increase the heat dissipation performance of the photosensitive assembly 1010 while enhancing the structural strength of the photosensitive assembly 1010. In another embodiment, the back plate 1017 may be a film layer attached to the bottom surface 10112 of the photosensitive element 1011 and the bottom surface 101212 of the circuit board 10121, to protect the photosensitive element 1011 and the circuit board main body 10121, and enhance the heat dissipation performance and structural strength of the photosensitive element 1011. By way of example and not limitation, the film layer is a coating of a metal-containing material.

An image capture module according to the eighth preferred embodiment of the present disclosure is shown in Fig. 22. Unlike the above embodiment, the image capture module includes a bracket 1050, the bracket 1050 is mounted on the packaging body 1013, and the filter 1040 is mounted on the bracket 1050.

Further, the bracket 1050 may be formed with a bent structure so that one end is adapted to be mounted to the packaging body 1013 and the other end is adapted to support the filter 1040.

The bracket 1050 can extend inwardly and downwardly to reduce the distance between the filter 1040 and the photosensitive element 1011, and reduce the back focal length of the image capture module.

In this implementation, a mounting position is provided for the filter 1040 by the bracket 1050, instead of directly providing the mounting position of the filter 1040 by the packaging body 1013. It should be noted that the structure of the bracket 1050 shown in the figure is merely illustrative and not limiting to the present disclosure. Since the structural strength of the filter 1040 is small, the installation position space required for installation is large. The width requirement of the mounting position of the integral package portion can be reduced by the bracket 1050 having a large structural strength, while it is also possible to buffer the stress acting on the filter 1040 when the module is impacted by an external force.

The bracket 1050 may be a closed annular or frame-shaped structure in a plan view, or may be selectively disposed on one or more sides of the packaging body 1013 or the filter 1040.

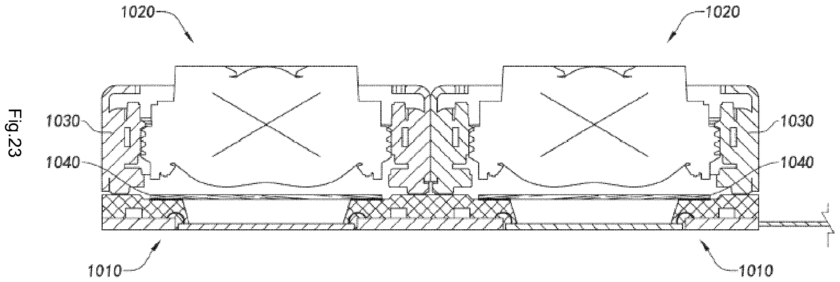

An image capture module according to the ninth preferred embodiment of the present disclosure is shown in Fig. 23. Unlike the above embodiment, the image capture module is an array of image capture modules, and the array of image capture modules includes two photosensitive assemblies 1010, two lenses 1020, two drivers 1030, and two filters 1040.

It is to be noted that, in order to facilitate the disclosure of the present application, in this embodiment of the present disclosure, a dual image capture module composed of two lenses 1020 is taken as an example, and in other embodiments of the present disclosure, the number of the lenses 1020 may be more, such as three or more. It should be understood by those skilled in the art that the number of the lenses 1020 and the number of corresponding components, such as the driver 1030, the bracket 1050 and the filter 1040 are not limiting to the present disclosure.

More specifically, in this embodiment of the present disclosure, the window-form circuit boards 1012 of the two photosensitive assemblies 1010 are integrally connected to facilitate forming the structure of the array. The two packages 1013 may be of a unitary structure, that is, two square window structures are one-shot molded in order to provide light paths for the two lenses 1020, respectively.

Various embodiments and different implementations are disclosed in the present disclosure. In the description, for the sake of the concise and clear description, only some different features are described in the embodiments and implementations. However, in the specific implementation process, different features in different embodiments and implementations may be combined as needed to form different image capture modules or photosensitive assemblies. It should be understood by those skilled in the art that the image capture module and the photosensitive assembly 1010 are not limited to the disclosure of a single embodiment or implementation.

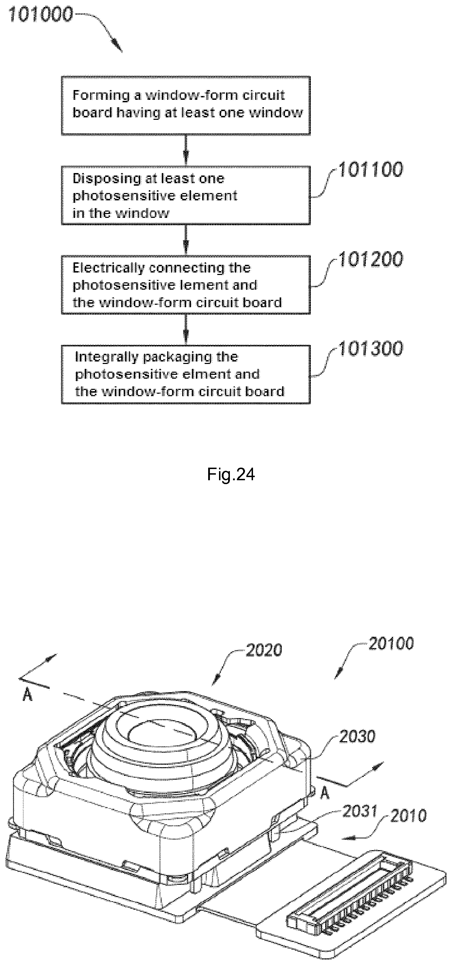

Referring to Fig. 24, in accordance with the above-described preferred embodiments of the present disclosure, the present disclosure provides a manufacturing method 101000 of a photosensitive assembly 1010, and the manufacturing method 101000 of a photosensitive assembly 1010 comprises steps of:
101100: disposing at least one photosensitive element 1011 in the window 10122 of a window-form circuit board 1012;
101200: electrically connecting the photosensitive element 1011 and the window-form circuit board 1012; and
101300: forming a packaging body 1013 integrally bonded to the photosensitive element and the window-form circuit board 1012, and causing the packaging body 1013 to form a light window 10131 opposite to the photosensitive element.

In the step 101100, the window 10122 may be a groove or a through hole.

The step 101100 may further include a step of: forming a window-form circuit board 1012 having at least one window 10122.

In the step 101100, the photosensitive element 1011 may be disposed on a side close to the upper surface of the window-form circuit board 1012 so that the top surfaces of the photosensitive element 1011 and the window-form circuit board 1012 are flush. The photosensitive element 1011 may also be disposed on a side close to the bottom surface of the window-form circuit board 1012 so that the bottom surfaces of the photosensitive element 1011 and the window-form circuit board 1012 are flush. It will be understood that the above-described manner in which the top and bottom surfaces are generally flush is by way of example only and not limiting to the present disclosure.

In the step 101200, the photosensitive element 1011 and the window-form circuit board 1012 are electrically connected by at least one electrical connection element 1014. One end of the electrical connection element 1014 is connected to the photosensitive element 1011 and the other end is connected to the top surface of the window-form circuit board 1012.

In the step 101300, the photosensitive element 1011, the electrical connection element 1014, and the electronic component 10123 protruding from the window-form circuit board 1012 are integrally packaged.

The method 101000 can further include a step 101400 of: attaching a filter 1040 to the photosensitive element 1011. The step 101400 may be before the step 101300 or may be after the step 101300. The manner of attachment may be by way of bonding.

The method 101000 further includes a step 101500 of: opening at least one reinforcing hole 101213 in the main body of the window-form circuit board 1012.

The method 101000 can further include a step 101600 of: attaching a back plate 1017 to the bottom of the window-form circuit board 1012.

In an implementation, in step 101300, the photosensitive element and the window-form circuit board are in contact with each other, and the packaging body integrally connects the photosensitive element 1011 with the window-form circuit board 1012.

In another implementation, in step 101300, the photosensitive element 1011 and the window-form circuit board 1012 are spaced apart, and the packaging body 1013 is integrally connected and filled between the photosensitive element 1011 and the window-form circuit board 1012 to reinforce the photosensitive element 1011 and the window-form circuit board 1012.

In another embodiment, in step 101300, the photosensitive element 1011 and the window-form circuit board 1012 are in indirect contact by a medium, and the packaging body 1013 integrally connects the photosensitive element 1011, the medium and the window-form circuit board 1012. For example, at least a part of the periphery of the non-photosensitive region 101112 of the photosensitive element 1011 first goes through glue-curing so that the photosensitive element 1011 and the window-form circuit board 1012 are in indirect contact.

The manner of integrally packaging is a molding manner, such as an insert molding or compression molding or transfer molding process by an injection molding machine.

Referring to Figs. 25A to 26B, an image capture module 20100 in accordance with the tenth preferred embodiment () of the present disclosure is illustrated. The image capture module 20100 may also be referred to as a sunken image capture module. The image capture module 20100 includes a photosensitive assembly 2010 and a lens 2020. The photosensitive assembly 2010 may also be referred to as a sunken photosensitive assembly.

Further, the photosensitive assembly 2010 includes an integral package base 2011, a circuit board 2012, and a photosensitive element 2013. The circuit board 2012 may also be referred to as a sunken circuit board. The photosensitive element 2013 sinks on the circuit board 2012, and the integral package base 2011 integrally packages the circuit board 2012 and the photosensitive element 2013. The manner of integrally packaging is, for example, but not limited to, transfer molding.

It should be noted that in the conventional COB package structure, the lens holder is usually manufactured separately, for example, by injection molding, and after being separately manufactured, glued to the circuit board by glue when assembling. Therefore, there are many disadvantages in this assembling method. However, in the present disclosure, on one hand, the relative height of the surfaces of the photosensitive element 2013 and the circuit board 2012 are reduced by the manner in which the photosensitive element 2013 sinks on the circuit board 2012, so that the lens 2020 can be closer to the circuit board 2012, reducing the height of the image capture module. On the other hand, when the photosensitive element 2013 sinks on the circuit board 2012, the integral package base 2011 integrally packages the circuit board 2012 and the photosensitive element 2013, thereby eliminating the need for providing support for the photosensitive chip through the circuit board as in conventional chip mounting. That is, in the present disclosure, the relative position of the photosensitive element 2013 and the circuit board 2012 can be fixed by the integral package base 2011 regardless of whether the photosensitive element 2013 is supported by the circuit board 2012, which is difficult to achieve in the conventional COB packaging process. Further, the integral package base 2011 is formed on the circuit board 2012 by means of integral packaging, and replaces the conventional lens holder to obtain many advantages. First, the process of integrally packaging replaces the conventional bonding process, and it is not necessary to reserve an adjustment gap in the AA adjustment, reducing the height of the image capture module. Secondly, the assembling manner of integrally packaging can improve the flatness of the surface by means of mold manufacturing, thereby improving the assembly precision of the image capture module. Thirdly, integrally packaging enhances the structural strength of the circuit board 2012, so that when the circuit board 2012 is slotted or opened, the structural strength requirement can still be met even when the photosensitive element 2013 sinks. However, the conventional lens holder and the circuit board are bonded, and it is difficult to meet such a requirement. Fourthly, the integral package base 2011 can integrally overmold the protruding component on the circuit board 2012, such as the electronic component 20123 described later, so that the spatial position on the circuit board 2012 can be fully utilized to reduce the size of the image capture module 20100 while preventing dust remained on the electronic component 20123 from contaminating the photosensitive element 2013. In the present disclosure, the design of the sinking of the photosensitive element 2013 and the integrated package are combined to reduce the size of the image capture module 20100.

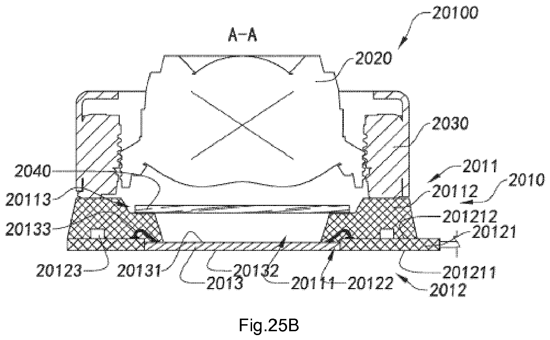

Referring to Fig. 25B to Fig. 26B, the integral package base 2011 includes a base main body 20112 and has a light window 20111. The light window 20111 is disposed on the base main body 20112 to provide a light path for the photosensitive element 2013. In other words, the base main body 20112 forms the light window 20111 to provide a light path for the photosensitive element 2013. In some embodiments, the base main body 20112 is in a closed loop shape to form a closed light window 20111. In other embodiments, the base main body 20112 may have a gap and communicate with the light window 20111 and the outside, and the present disclosure is not limited in this respect. The molding material of the base main body 20112 is, for example, but not limited to, nylon, LCP, PP, resin, or the like. Preferably, the molding material of the base main body 20112 is a thermosetting material.

Further, the circuit board 2012 includes a circuit board main body 20121 and has a setting region 20122, and the setting region 20122 is disposed on the circuit board main body 20121. The setting region 20122 may also be referred to as a sinking region. The photosensitive element 2013 is disposed in the setting region 20122 so that the photosensitive element 2013 sinks relative to the position of the circuit board main body 20121. In some embodiments, the setting region 20122 is provided as a groove, and the photosensitive element 2013 is received in the groove so that the relative height of the photosensitive element 2013 and the circuit board main body 20121 is reduced. In other embodiments, the setting region 20122 is disposed as a through hole that communicates with both sides of the circuit board main body 20121. The photosensitive element 2013 is received in the through hole, so that the relative height of the photosensitive element 2013 and the circuit board main body 20121 is reduced. In this embodiment of () the present disclosure and the accompanying drawings, the setting region 20122 is exemplified by a through hole, but it should be understood by those skilled in the art that the present disclosure is not limited in this respect. The circuit board main body 20121 is, for example, but not limited to, a Rigid-Flex board, a ceramic substrate (without a flex board), or a PCB hard board (without a flex board).

The base main body 20112 integrally packages the circuit board main body 20121 and the photosensitive element 2013, thereby fixing the relative position of the circuit board main body 20121 and the photosensitive element 2013.

The photosensitive element 2013 has a front surface 20131 and a rear surface 20132, the front surface 20131 faces the lens 2020, and the rear surface 20132 is opposite to the lens 2020. The front surface 20131 of the photosensitive element 2013 has a photosensitive region 201311 and a non-photosensitive region 201312, the photosensitive region 201311 is used for performing photosensitive function, and the non-photosensitive region 201312 surrounds the photosensitive region 201311. The circuit board main body 20121 has a top surface 201212 and the bottom surface 201211, the top surface 201212 faces the lens 2020, and the bottom surface 201211 is opposite to the lens 2020.

The base main body 20112 integrally packages at least a part of the top surface 201212 of the circuit board main body 20121 and at least a part of the non-photosensitive region 201312 of the photosensitive element 2013, thereby fixing the relative position of the circuit board 2012 and the photosensitive element 2013. In other words, the photosensitive element 2013 is connected to the circuit board main body 20121 through the base main body 20112, so that the circuit board main body 20121 is not required to provide a supporting action for the photosensitive element 2013. The manner of sinking and integrally packaging is difficult to achieve in the conventional COB package, the structural strength is not easy to achieve, and it is difficult to integrally fix the circuit board and the photosensitive chip through the lens holder.

Further, in this embodiment of the present disclosure and the accompanying drawings, the setting region 20122 is a through hole in order to provide a wider adjustment space for the photosensitive element 2013. For example, the back surface 20132 of the photosensitive element 2013 is aligned with the bottom surface 201211 of the circuit board main body, so that the bottom of the image capture module 20100 is flat, which is convenient for installation and use, or the front surface 20131 of the photosensitive element 2013 is aligned with the top surface 201212 of the circuit board main body 20121, or the front surface 20131 of the photosensitive element 2013 is slightly higher than the top surface 201212 of the circuit board main body 20121, or the front surface 20131 of the photosensitive element 2013 is slightly lower than the top surface 201212 of the circuit board main body 20121. It should be understood by those skilled in the art that the present disclosure is not limited in this respect.

In this embodiment of the present disclosure and the accompanying drawings, the description is made by taking the setting region 20122 as a through hole as an example. It should be noted that when the setting region 20122 is a through hole, the back surface 20132 of the photosensitive element 2013 can be directly exposed to the external environment, thereby improving the heat dissipation performance of the photosensitive element 2013. In the conventional COB packaging method, the photosensitive chip is usually mounted on the circuit board in a laminated manner, and the heat generated by the photosensitive chip needs to be dissipated through the circuit board, so the heat dissipation performance is poor. Moreover, when the temperature of the photosensitive chip is high, the imaging quality of the image capture module may be affected.

Further, the photosensitive element 2013 is electrically connected to the circuit board main body 20121 through at least one electrical connection element 20133 in order to transmit an electrical signal to the circuit board main body 20121. The electrical connection element 20133 is, for example, but not limited to, a gold line, a silver wire, a copper wire, or an aluminum wire. The circuit board 2012 includes at least one electronic component 20123, and the electronic component 20123 is disposed on the circuit board main body 20121. The electronic component 20123 is, for example, but not limited to, a resistor, a capacitor, a drive component, or the like. In this embodiment of the present disclosure, the electronic component 20123 protrudes from the circuit board main body 20121, and in other embodiments of the present disclosure, the electronic component 20123 may not be disposed or the electronic component 20123 does not protrude from the circuit board main body 20121, and, for example, is embedded in the circuit board main body 20121. In one embodiment, the electronic component 20123 is disposed on the circuit board main body 20121 by a surface mount process, i.e. SMT (Surface Mounting Technology).

Further, the base main body 20112 overmolds the electrical connection element 20133 and the electronic component 20123 so that the electrical connection element 20133 and the electronic component 20123 are not directly exposed to the outside, avoiding dust remained on the electrical connection element 20133 and the electronic component 20123 to contaminate the photosensitive element 2013. Moreover, by the base main body 20112 being filled around the electrical connection element 20133 and the electronic component 20123, the spatial position around the electrical connection element 20133 and the electronic component 20123 is fully utilized so that the size of the image capture module 20100 is reduced.

It should be noted that the number and position of the electrical connection elements 20133 can be set as needed, for example, on one side, two sides, three sides or four sides of the photosensitive element 2013, or may be set in connection with the set position of the electronic component 20123.

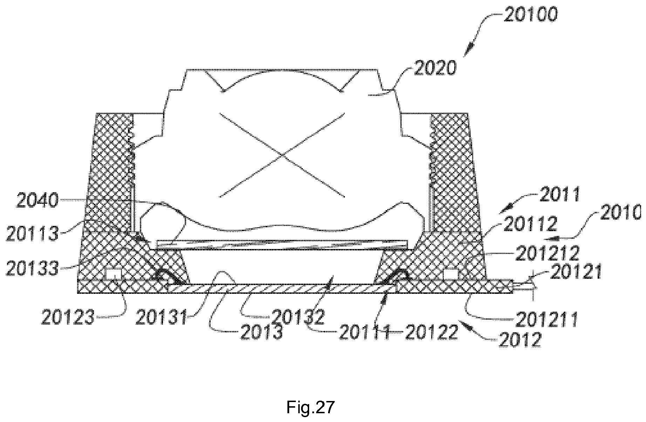

Further, in this embodiment of the present disclosure, the image capture module 20100 further includes a driver 2030, such as a voice coil motor, a piezoelectric motor, or the like. The lens 2020 is mounted on the driver 2030 to adjust the lens 2020 by the driver 2030, forming an automatic focus image capture module, i.e. an AF (Auto Focus) image capture module. The driver 2030 can be electrically connected to the circuit board main body 20121 through a pin 2031. The implementation of the pin 2031 can be a single pin, a multi pin, a single row pin, a multi row pin, or the like. Of course, in other embodiments of the present disclosure, referring to Fig. 27, the image capture module 20100 may not include the driver 2030, and the lens 2020 is directly mounted on the photosensitive assembly 2010 to form a fixed focus image capture module, i.e. a FF (Fixed focus) image capture module. It should be understood by those skilled in the art that the type of the image capture module 20100 is not limiting to the present disclosure. The specific type and structure of the driver 2030 are not limiting to the present disclosure.

The image capture module 20100 can further include a filter element 2040 for filtering light passing through the lens 2020. The filter element 2040 is, for example, but not limited to, an infrared cut-off filter, a blue glass filter, a fully transparent filter, and a visible light filter. In this embodiment of the present disclosure, the filter element 2040 is mounted to the integral package base 2011 of the photosensitive assembly 2010, and is located in the light path of the photosensitive element 2013. In other embodiments of the present disclosure, the filter element 2040 can also be mounted to other components, such as a separate bracket, the photosensitive element 2013, or the like. The present disclosure is not limited in this respect.

Further, the base main body 20112 of the integral package base 2011 has a mounting slot 20113 that communicates with the light window 20111. In this embodiment of the present disclosure, the filter element 2040 is mounted to the mounting slot 20113. More specifically, the edge of the filter element 2040 extends into the mounting slot 20113 so that the filter element 2040 is supported by the base main body 20112. In other embodiments of the present disclosure, a bracket is mounted to the mounting slot 20113, and the filter element 2040 is mounted to the bracket.

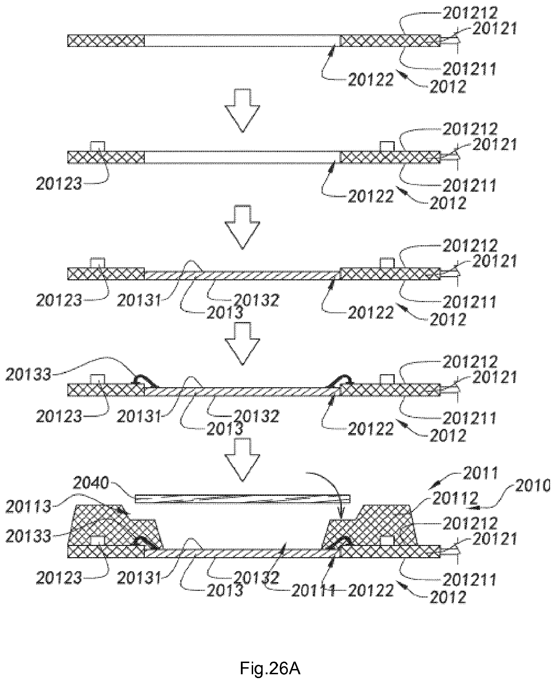

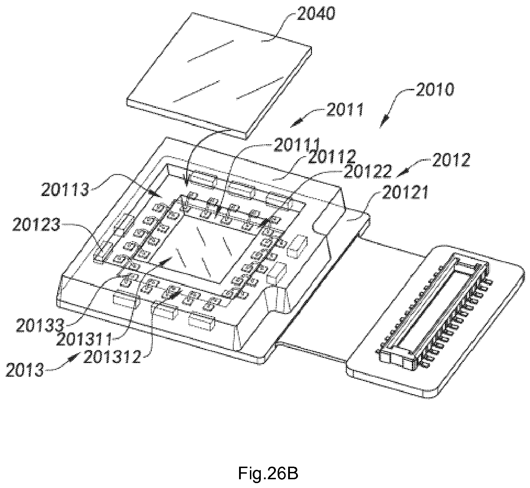

Referring to Figs. 26A and 26B, one of the forming processes of the photosensitive assembly 2010 may be as follows: firstly, surface mounting is performed on the circuit board main body 20121, the electronic component 20123 is mounted on the circuit board main body 20121, and the setting position of the electronic component 20123 can be set as needed, such as on one side or several sides; secondly, the photosensitive element 2013 is disposed in the setting region 20122 of the circuit board 2012, wherein the setting region 20122 may be formed in advance on the circuit board main body 20121, such as opening a hole in a circuit board to form the circuit board main body 20121 with the setting region 20122, or purchasing a circuit board main body 20121 with the setting region 20122; further, the photosensitive element 2013 is electrically connected to the circuit board main body 20121 through the electrical connection element 20133, so as to realize electrical signal transmission of the photosensitive element 2013 and the circuit board main body 20121, for example, electrically connecting the photosensitive element 2013 and the circuit board main body 20121 by a gold wire; further, the base main body 20112 is formed to integrally package the circuit board main body 20121 and the photosensitive element 2013 to form the light window 20111, and the electronic component 20123 and the electrical connection element 20133 are overmolded by the base main body 20112, thereby forming the photosensitive assembly 2010 that can be used for mounting the filter element 2040.

Further, after the photosensitive assembly 2010 is assembled, the driver 2030 and/or the lens 2020 are/is continuously mounted to form the image capture module 20100 that has a fixed focus or the image capture module 20100 that has an automatic focus.

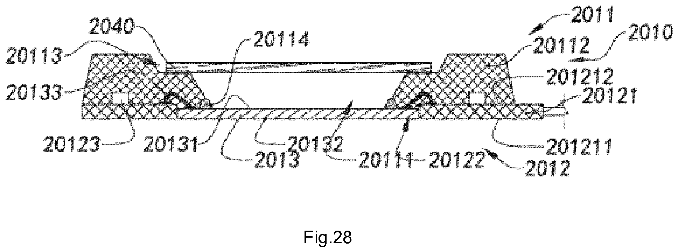

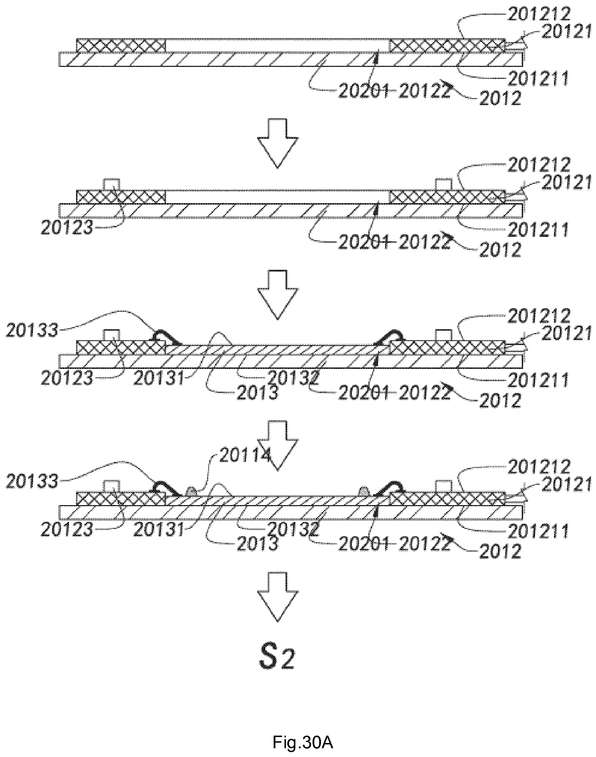

Referring to Figs. 28 to 30B, a photosensitive assembly 2010 in accordance with the eleventh preferred embodiment () of the present disclosure is illustrated. The photosensitive assembly 2010 is manufactured by a manufacturing apparatus 20200. Unlike the above preferred embodiments, the integral package base 2011 includes a spacer medium 20114, and the spacer medium 20114 is spaced apart from the base main body 20112 and the photosensitive element 2013 to protect the photosensitive element 2013 during formation of the base main body 20112 by the manufacturing apparatus, prevent the manufacturing apparatus 20200 from damaging the photosensitive element 2013 while blocking the material of the integral package from overflowing to the photosensitive region 201311 of the photosensitive element 2013.

Preferably, in this embodiment of the present disclosure, the spacer medium 20114 forms an annular raised step to facilitate supporting the manufacturing apparatus 20200 while blocking the integral package material, when the base main body 20112 is formed by the manufacturing apparatus 20200. The base main body 20112 is formed with the spacer medium 20114 as a boundary. The implementation of the spacer medium 20114 is, for example, but not limited to, formed by applying glue on the circuit board main body 20121, and may also be formed by bonding elastic elements. The present disclosure is not limited in this respect.

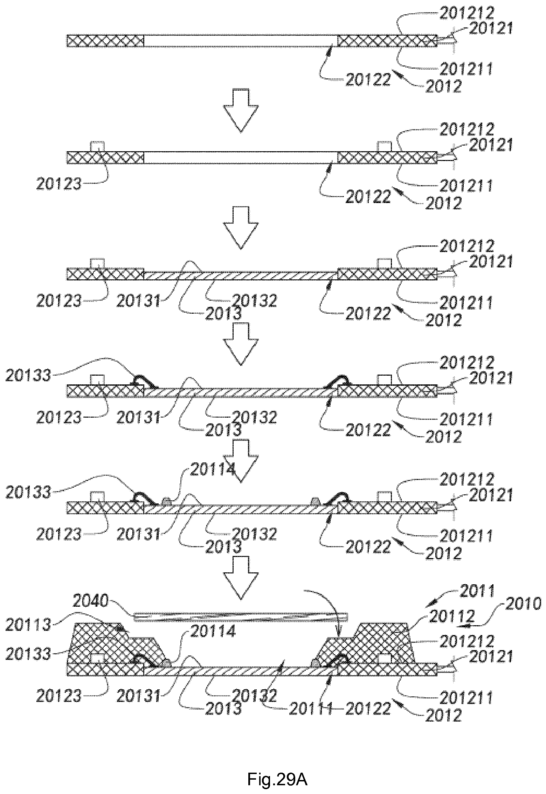

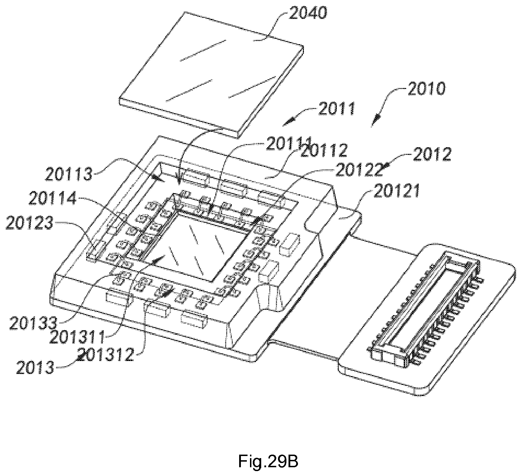

Further, referring to Figs. 29A and 29B, in the process of manufacturing the photosensitive assembly 2010, it is necessary to form the spacer medium 20114 at a predetermined position of the photosensitive element 2013 before integrally packaging the photosensitive element 2013 and the circuit board main body 20121. The photosensitive element 2013 and the circuit board main body 20121 are then integrally packaged. The spacer medium 20114 is disposed on the non-photosensitive region 201312 of the photosensitive element 2013, and the periphery of the photosensitive region 201311, and the specific setting position can be determined as needed. More specifically, the spacer medium 20114 may be formed after the surface mounting of the electronic component 20123 is performed and the electrical connection element 20133 is set, or may be formed before the electronic component 20123 and the electrical connection element 20133 are disposed. The present disclosure is not limited in this aspect.

In this embodiment of the present disclosure, the electrical connection element 20133 is disposed on four sides of the photosensitive element 2013, and accordingly, the spacer medium 20114 is disposed at a corresponding position of the electrical connection element 20133. Thus, by the spacer medium 20114, the electrical connection element 20133 is protected, and the manufacturing apparatus 20200 is prevented from touching and damaging the electrical connection element 20133. The position and height of the spacer medium 20114 can be set according to the electrical connection element 20133.

Further, in some embodiments of the present disclosure, a gap 2014 is formed between the photosensitive element 2013 and the circuit board main body 20121, and the integral base extends into the gap 2014, fixing the relative position of the photosensitive element 2013 and the circuit board main body 20121 more stably. More specifically, the gap 2014 may surround the photosensitive element 2013 so that the base main body 20112 may be filled around the photosensitive element 2013 and thus the photosensitive element 2013 is more stably fixed. Of course, in other embodiments of the present disclosure, the gap 2014 may not be formed. For example, when the size of the setting region 20122 is larger than the size of the photosensitive element 2013, the photosensitive element 2013 forms the gap 2014 with the circuit board main body 20121. When the size of the setting region 20122 is the same as the size of the photosensitive element 2013, the photosensitive element 2013 and the circuit board main body 20121 do not form the gap 2014.

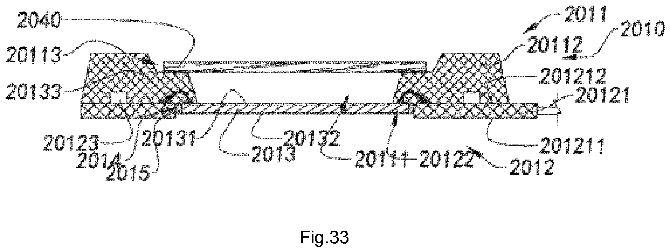

Referring to Fig. 33, in another embodiment of the present disclosure, the gap 2014 may also be filled by a filling medium 2015. The filling medium 2015 is, for example, but not limited to, glue, viscous material or the like in order to pre-fix the photosensitive element 2013 by the filling medium 2015. That is, in the process of manufacturing the photosensitive assembly 2010, the filling medium 2015 may be filled in the gap 2014 between the photosensitive element 2013 and the circuit board main body 20121, the relative position of the photosensitive element 2013 and the circuit board main body 20121 is pre-fixed through the filling medium 2015, and then the photosensitive element 2013 and the circuit board main body 20121 are integrally packaged. Further, the photosensitive element 2013 and the circuit board main body 20121 are fixed more stably by the base main body 20112.

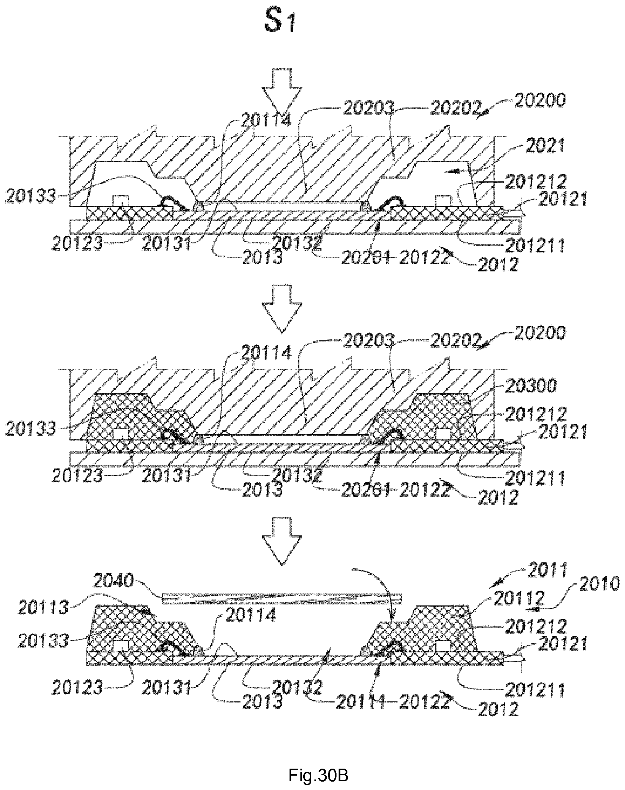

Referring to Figs. 30A and 30B, a manufacturing apparatus 20200 and a manufacturing process of a photosensitive assembly 2010 according to the eleventh preferred embodiment () of the present disclosure is shown. The manufacturing apparatus 20200 includes a molding die 20202 and a peelable substrate 20201. The molding die 20202 and the peelable substrate 20201 can be opened and closed to facilitate molding the base main body 20112 on the circuit board main body 20121.

The manufacturing apparatus 20200 includes a light window molding block 20203 for forming the light window 20111. In this embodiment of the present disclosure, the light window molding block 20203 is disposed on the molding die 20202, and the light window molding block 20203 extends downwardly to form a base molding guide groove 202021 having the same shape as the shape of the base main body 20112 with the molding die 20202, so that when the die is clamped, the liquid molding material 20300 enters the base molding guide groove 202021, and the base main body 20112 of a predetermined shape is molded. Preferably, the electronic component 20123 and the electrical connection element 20133 are received in the base molding guide groove 202021 so as to overmold the electronic component 20123 and electrical connection element 20133 by the molding material 20300 when integrally formed. That is, the base main body 20112 overmolding the electronic component 20123 and the electrical connection element 20133 is formed, and the base main body 20112 has the mounting slot 20113.

It should be noted that, in some embodiments, the molding die 20202 of the manufacturing apparatus 20200 and the inner side of the light window molding block 20203, i.e., the side forming the base main body 20112, may be provided with a film, in order to form the base main body 20112, prevent the light window molding block 20203 from damaging the photosensitive element 2013, and facilitate the mold release.

Further, in this embodiment of the present disclosure, the peelable substrate 20201 is a sticky substrate, and when the circuit board main body 20121 is placed on the peelable substrate 20201, the positions of the circuit board main body 20121 and the photosensitive element 2013 are determined relative to the peelable substrate 20201. It should be noted that the photosensitive element 2013 and the circuit board main body 20121 are both supported by the planar peelable substrate 20201, so that the bottom surface 201211 of the circuit board main body 20121 and the back surface 20132 of the photosensitive element 2013 are aligned, and thus the bottom of the photosensitive assembly 2010 is flat. Of course, in other embodiments of the present disclosure, the peelable substrate 20201 may also be in other forms, such as providing grooves or bumps to define the circuit board main body 20121 and the photosensitive element 2013.

It should be noted that, when the die is clamped, the light window molding block 20203 of the molding die 20202 is supported by the spacer medium 20114, so that the light window molding block 20203 does not directly contact the photosensitive element 2013.

Further, the molding die may further include a coating film, and the coating film is disposed on the inner side surface of the molding die 20202 to form the base main body 20112, protect the photosensitive element 2013, and prevent the light window molding block 20203 from damaging the photosensitive element 2013.

The manufacturing process of the photosensitive assembly 2010 may be as follows: the circuit board main body 20121 with the setting region 20122 is disposed on the peelable substrate 20201, and the electronic component 20123 may be mounted on the circuit board main body 20121; further, the photosensitive element 2013 is electrically connected to the circuit board main body 20121 through the electrical connection element 20133; further, the spacer medium 20114 is disposed in the non-photosensitive region 201312 of the photosensitive element 2013; further, the molding die 20202 and the peelable substrate 20201 are clamped so that the molding die 20202 is supported by the spacer medium 20114 or film, thereby preventing the light window molding block 20203 from directly contacting the photosensitive element 2013; further, the molding material 20300 is caused to enter the base molding guide groove 202021 to form the base main body 20112, integrally packaging the photosensitive element 2013 and the circuit board main body 20121; further, the molding die 20202 and the peelable substrate 20201 are opened, and the peelable substrate 20201 is removed from the photosensitive element 2013 and the circuit board main body 20121, obtaining the photosensitive assembly 2010. The manner in which the peelable substrate 20201 is separated from the circuit board main body 20121 and the photosensitive element 2013 is, for example, but not limited to, peeling, exposure, hot melt, etching, dissolving, grinding, or the like. The peelable substrate 20201 can also be placed on a lower mold of the molding die 20202 to facilitate replacement and maintenance of the peelable substrate 20201.

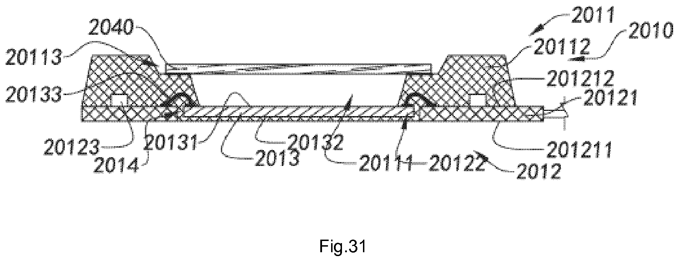

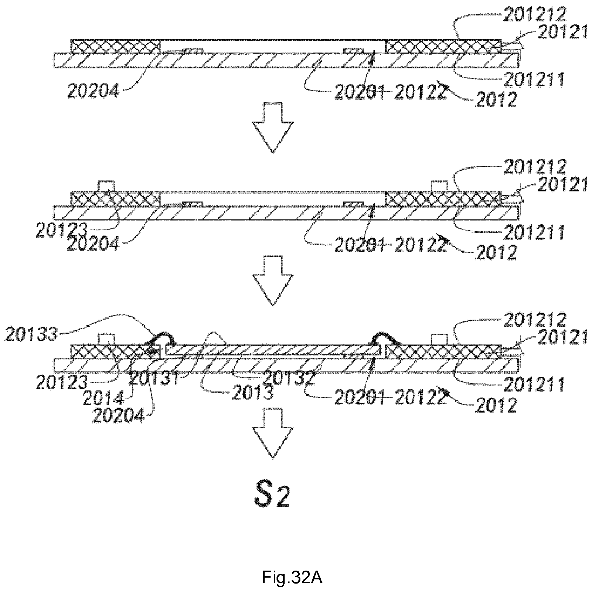

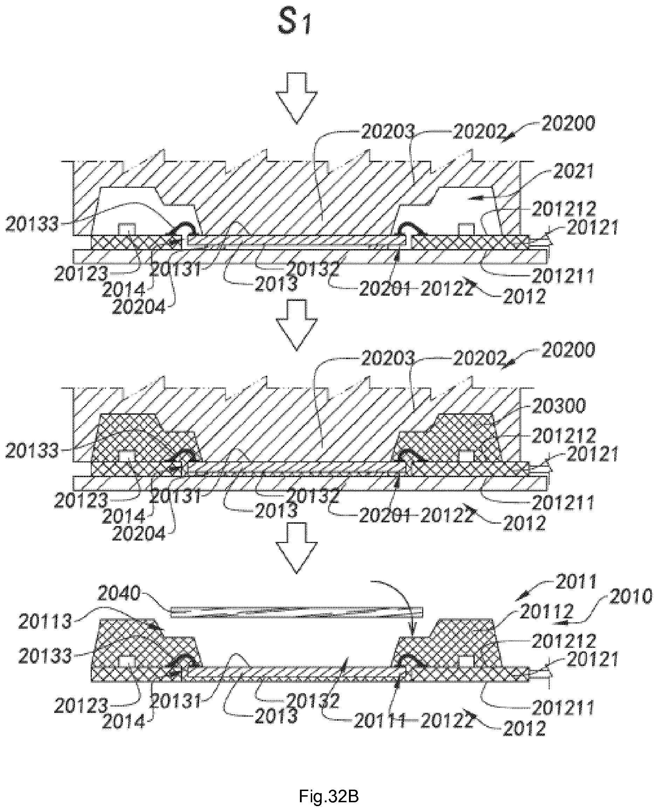

Referring to Figs. 31 to 32B, another modified implementation of the photosensitive assembly 2010 and a manufacturing apparatus 20200 therefor and a manufacturing process thereof according to the eleventh preferred embodiment of the present disclosure are shown. Unlike the above embodiment, the front surface 20131 of the photosensitive element 2013 is aligned with the top surface 201212 of the circuit board main body 20121. The base main body 20112 extends into the gap 2014 between the photosensitive element 2013 and the circuit board main body 20121, and overmolds the back surface 20132 of the photosensitive element 2013.

Further, the peelable substrate 20201 of the manufacturing apparatus 20200 is provided with at least one pillar 20204, and the pillar 20204 protruds from the peelable substrate 20201 for supporting the photosensitive element 2013. The number and shape of the pillars 20204 can be set as desired.

The manufacturing process of the photosensitive assembly 2010 may be as follows: the circuit board main body 20121 is disposed on the peelable substrate 20201 so that the circuit board main body 20121 is supported on the peelable substrate 20201, and the photosensitive element 2013 is disposed on the setting region 20122 of the circuit board main body 20121 and supported by the pillar 20204. Preferably, in an implementation, when the photosensitive element 2013 is supported by the pillar 20204, the front surface 20131 of the photosensitive element 2013 is aligned with the top surface 201212 of the circuit board main body 20121. Preferably, the surface of the peelable substrate 20201 and the pillar 20204 are sticky and can be peeled off from the contacted member. Further, in the mold clamping state, the molding material 20300 is caused to enter the base molding guide groove 202021, and extends into the gap 2014 to reach a space between the back surface 20132 of the photosensitive element 2013 and the peelable substrate 20201, overmolding the back surface 20132 of the photosensitive element 2013; further, after the base main body 20112 is molded, the molding die 20202 and the peelable substrate 20201 are opened, and the peeling substrate 20201 and/or the pillar 20204 are/is detached from the photosensitive assembly 2010. Of course, in some implementations, the pillar 20204 can be detachably disposed on the peelable substrate 20201, so that when the peelable substrate 20201 is detached, the pillar 20204 is detached from the peelable substrate 20201, and is not detached from the base main body 20112. The peelable substrate 20201 can also be placed on the lower mold of the molding die 20202 to facilitate replacement and maintenance of the peelable substrate 20201.

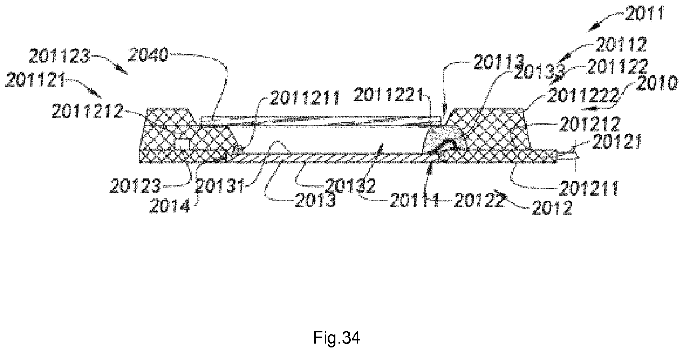

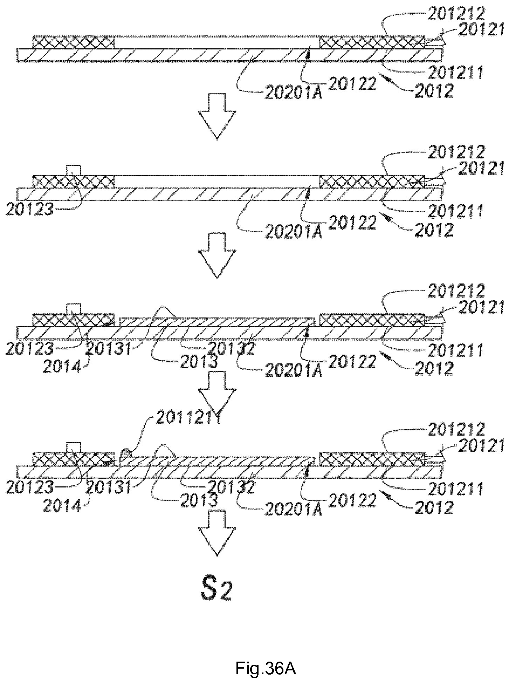

Referring to Figs. 34 to 36C, a photosensitive assembly and a manufacturing apparatus therefor according to the twelfth preferred embodiment of the present disclosure are illustrated. The photosensitive assembly 2010 is manufactured by the manufacturing apparatus 20200. Unlike the above preferred embodiments, the base main body 20112 includes a primary base 201121 and a secondary base 201122, and the primary base 201121 and the secondary base 201122 form the light window 20111, providing a light path for the photosensitive element 2013.

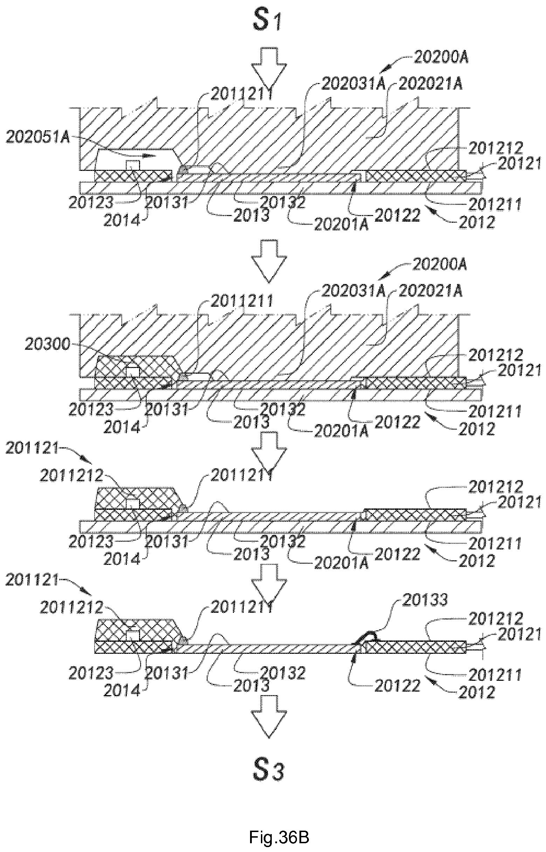

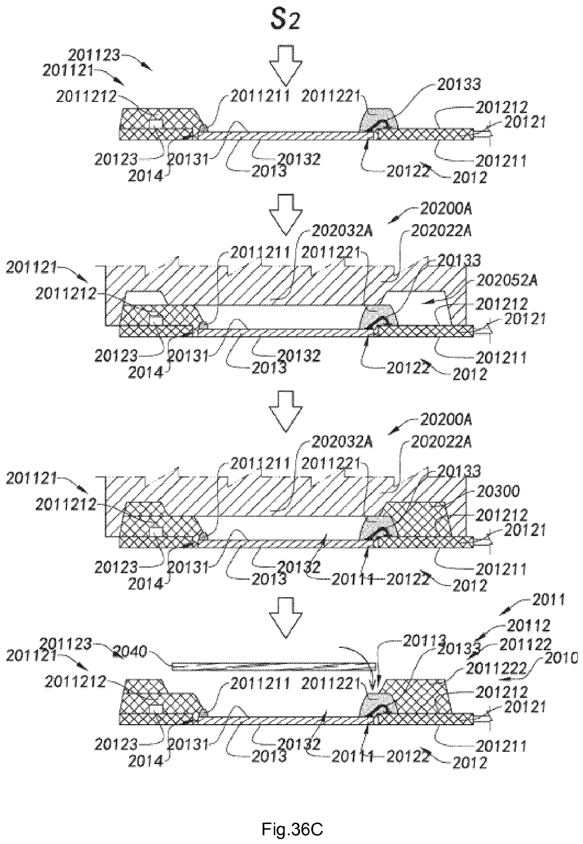

Referring to Fig. 34, Fig. 36B and Fig. 36C, the primary base 201121 includes a backing 2011211 and a primary package base 2011212. The secondary base 201122 includes an encapsulation base 2011221 and a secondary package base 2011222. The backing 2011211 separates the primary package base 2011212 from the photosensitive element 2013 to protect the photosensitive element 2013 during formation of the primary package base 2011212 by the manufacturing apparatus 20200, preventing the manufacturing apparatus 20200 from damaging the photosensitive element 2013. The encapsulation base 2011221 separates the secondary package base 2011222 from the photosensitive element 2013 to protect the photosensitive element 2013 during formation of the secondary package base 2011222 by the manufacturing apparatus 20200, preventing the manufacturing apparatus 20200 from damaging the photosensitive element 2013.

Of course, in other embodiments of the present disclosure, the primary base 201121 may not include the backing 201121, but may be only composed of the primary package base 2011212. That is, the primary package base 20111212 is one-shot molded on at least a part of the photosensitive element 2013 and the circuit board main body 20121. The encapsulation base 2011221 of the secondary base 201122 and the primary package base 2011212 form an annular structure, and the secondary package base 20111222 is one-shot molded on the basis of the annular structure, thereby forming the light window 20111.

Preferably, the primary base 201121 is disposed on one side or several sides without the electrical connection element 20133, the encapsulation base 2011221 is disposed at a position where the electrical connection element 20133 is provided, and the encapsulation base 2011221 overmolds the electrical connection element 20133.

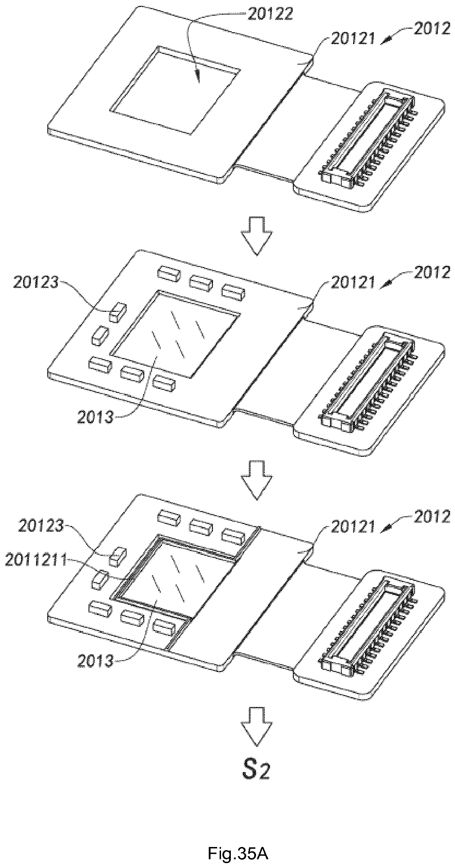

It should be noted that, referring to Figs. 35A and 36B, in this manner, the photosensitive element 2013 is pre-fixed by the primary base 201121, and since the primary base 201121 can be one-shot molded by molding, a better pre-fixing effect is achieved, thereby reducing the influence on the photosensitive element 2013 when the secondary base 201122 is formed. On the other hand, when the encapsulation base 2011221 encapsulates the electrical connection element 20133, the photosensitive element 2013 and the circuit board main body are simultaneously connected, so that the photosensitive element 2013 has a better fixing effect.

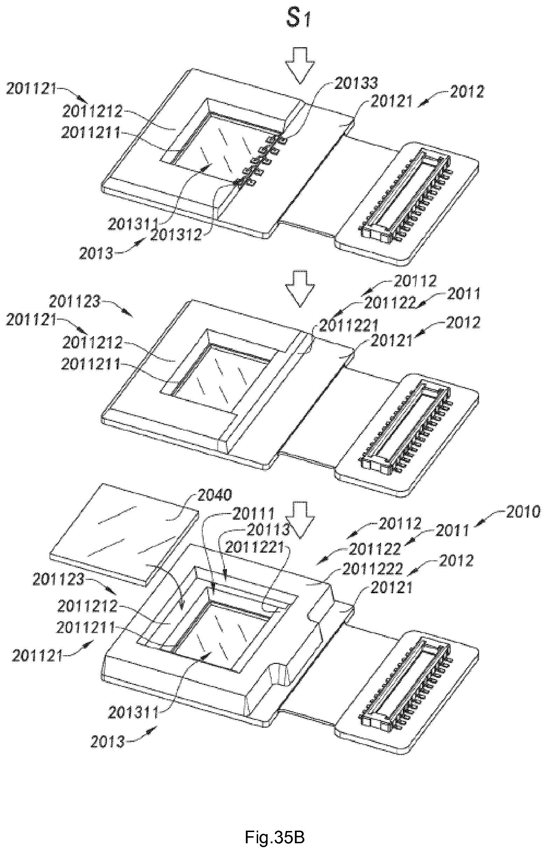

Referring to Fig. 35B and Fig. 36C, the encapsulation base 2011221 and the primary base 201121 form an annular structure 201123, and the secondary package base 2011222 and the annular structure 201123 form a mounting slot 20113. In other words, the secondary base 201122, the primary base 201121 and the encapsulation base 2011221 form the mounting slot 20113. It can be seen that, in this implementation, the mounting slot 20113 is formed by combining the primary base 201121 and the secondary base 201122, and is not one-shot molded, thereby reducing significant corners formed in the molding process, and reducing the occurrence of burrs. In this embodiment of the present disclosure, the mounting slot 20113 is adapted to mount the filter element 2040.

Further, the primary base 201121 and the encapsulation base 2011221 extend into the gap 2014 between the photosensitive element 2013 and the circuit board main body 20121, thereby fixing the photosensitive element 2013 and the circuit board main body 20121 more stably.

Hereinafter, a case where the electrical connection element 20133 is disposed on one side of the photosensitive element 2013 will be described as an example.

Referring to Figs. 36A to 36C, the manufacturing apparatus 20200A includes a peelable substrate 20201A and a molding die 20202A. The peelable substrate 20201A is used for supporting the circuit board main body 20121 and the photosensitive element 2013, and the molding die 20202A is used for forming the base main body 20112A.

Further, the molding die 20202A includes a first molding die 202021A and a second molding die 202022A, the first molding die 202021A is used for forming the primary base 201121, and the second molding die 202022A is used for forming the secondary base 201122.

Further, the first molding die 202021A has a primary base molding guide groove 202051A corresponding to the shape of the primary base 201121. The second molding die 202022A has a secondary base molding guide groove 202052A corresponding to the shape of the secondary base 201122.

The manufacturing apparatus 20200A includes two light window molding blocks, which are a first light window molding block 202031A and a second light window molding block 202032A, respectively. The first light window molding block 202031A is disposed in the first molding die 202021A, and cooperates with the first molding die 202021A to form the primary base molding guide groove 202051A, and the second light window molding block 202032A is disposed in the second molding die 202022A and cooperates with the second molding die 202022A to form the secondary base molding guide groove 202052A. The primary base 201121 and the secondary base 201122 cooperate to form the light window 20111. That is, a respective part of the light window 20111 is formed in each of the two molding processes.

For example, referring to Figs. 36A to 36C, the case where the electrical connection element 20133 is disposed on one side of the photosensitive element 2013 is described as an example. The manufacturing process of the photosensitive element 2010 is as follows: first, the circuit board main body 20121 is disposed on the peelable substrate 20201A, pre-fixing the position of the circuit board main body 20121; further, the photosensitive element 2013 sinks to the setting region 20122 of the circuit board main body 20121, and is supported by the peelable substrate 20201A, pre-fixing the position of the photosensitive element 2013; further, the backing 2011211 is disposed at a predetermined position on the photosensitive element 2013, such as disposing the backing 2011211 by applying glue; further, the first molding die 202021A is clamped, and pressed against the front surface 20131 of the photosensitive element 2013 and the top surface 201212 of the circuit board main body 20121, and the first molding die 202021A is supported by the backing 2011211, it is convenient to form the primary base 201121 outside the backing 2011211, and no packaging is performed inside the backing 2011211, and the first molding die 202021A is prevented from damaging the photosensitive element 2013, such as by the backing 2011211 bearing the force of the first molding die 202021A pressing down, and the photosensitive element 2013 may be less or not subject to a downward pressing force of the first molding die 202021A; further, the molding material 20300 is caused to enter the primary base molding guide groove 202051A, a part of the top surface 201212 of the circuit board main body 20121 and a part of the front surface 20131 of the photosensitive element 2013 are integrally packaged, and the photosensitive element 2013 and the circuit board main body 20121 are pre-fixed by the primary package base 2011212; further, after the first molding die 202021A is removed, the electrical connection element 20133 is disposed at a predetermined position of the photosensitive element 2013 where the electrical connection element 20133 is supposed to be disposed, and the photosensitive element 2013 is electrically connected to the circuit board main body 20121; further, the encapsulation base 2011221 is formed at a corresponding position of the electrical connection element 20133, encapsulating the electrical connection element 20133, and causing the encapsulation base 2011221 and the primary base 201121 to form an annular structure 201123; further, the second molding die 202022A is clamped, and the second molding die 202022A is supported by the annular structure 201123; further, the molding material 20300 is caused to enter the secondary base molding guide groove 202052A of the second molding die 202022A, and the secondary package base 2011222 is formed on the basis of the annular structure 201123, thereby obtaining the photosensitive assembly 2010.

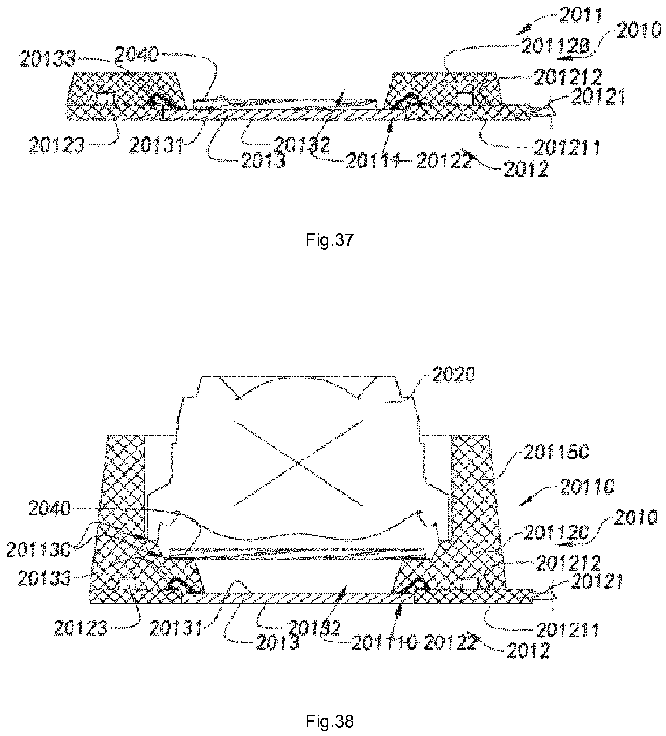

Referring to Fig. 37, a photosensitive assembly 2010 in accordance with the thirteenth preferred embodiment of the present disclosure is illustrated. Unlike the above embodiment, the photosensitive assembly 2010 includes a filter element 2040, and the photosensitive element 2013 is covered by the filter element 2040 to protect the photosensitive element 2013.

Further, in this embodiment, the base main body 20112B may be a platform-like structure. That is, the base main body 20112B does not have the mounting slot 20113, so that other components such as the driver 2030 and the lens 2020 can be provided with a larger mounting space.

For example, in the manufacturing process of the photosensitive assembly 2010, the filter element 2040 may be covered on the photosensitive element 2013 before the photosensitive element 2013 and the circuit board main body 20121 are integrally packaged. Then, the photosensitive element 2013 and the circuit board main body 20121 are integrally packaged through the manufacturing apparatus 20200, so that the photosensitive element 2013 can be protected by the filter element 2040, preventing the manufacturing apparatus from damaging the photosensitive element 2013, and blocking the dust in the environment from reaching the photosensitive element 2013. On the other hand, the back focal length of the image capture module 20100 assembled from the photosensitive unit 2010 can be reduced, and the height of the image capture module can be reduced.

In an implementation, the filter element 2040 is located inside the base main body 20112B and may not be integrally packaged. For example, the filter element 2040 may be overlaid on the photosensitive element 2013 by bonding or may also be overlaid on the photosensitive element 2013 by coating.

In another implementation, the filter element 2040 can be integrally packaged by the base main body 20112 so that it is not necessary to fix the filter element 2040 in other manners.

Referring to Fig. 38, an image capture module 20100 in accordance with the fourteenth preferred embodiment of the present disclosure is illustrated. The integral package base 2011C of the photosensitive assembly 2010 includes a lens portion 20115C, and the lens portion 20115C extends at least partially integrally upward from the base main body 20112C, and is adapted to mount a lens 2020.

Further, the lens portion 20115C forms a further mounting slot 20113C for mounting the lens 2020. In other words, the integral package base 2011C has two mounting slots 20113C, one of the mounting slots 20113C is used for mounting the filter element 2040, and the other of the mounting slots 20113C is used for mounting the lens 2020, thereby forming a fixed focus image capture module.

It should be noted that the lens portion 20115C is formed by integral molding, so that the mounting position of the lens 2020 can be determined more accurately. By the limiting action of the lens portion 20115C, the mounting deviation of the lens 2020 is reduced, making assembly easier to implement.

An adjustment space may be reserved between the lens portion 20115C and the lens 2020 to facilitate adjusting the lens 2020 during the assembly of the lens 2020. Preferably, the lens portion 20115C is internally flat and is adapted to mount the lens 2020 that is unthreaded.

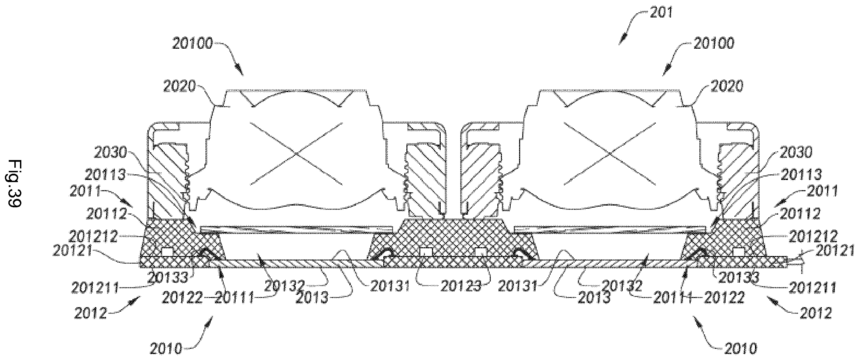

Referring to Fig. 39, an array image capture module 201 in accordance with the fifteenth preferred embodiment of the present disclosure is illustrated. The array image capture module 201 includes at least two image capture modules 20100, and the image capture modules 20100 cooperate to realize image acquisition.

It should be noted that in this embodiment and the accompanying drawings, a dual image capture module composed of two image capture modules 20100 is taken as an example for description, and in other embodiments of the present disclosure, more image capture modules 20100, for example, three or more, may be included. The present disclosure is not limited in this respect.

In an implementation, the array image capture module 201 is composed of the image capture modules 20100 in a splicing manner. For example, the circuit board main bodies 20121 are independent of each other, and/or the base main bodies 20112 are independent of each other.

In another implementation, the array image capture module 201 is composed of the image capture modules 20100 in an integrally connecting manner. For example, the circuit board main bodies 20121 are integrally connected, and the base main bodies 20112 are integrally connected.

It should be understood by those skilled in the art that the number and the manner of combination of the image capture modules 20100 are not limiting to the present disclosure.

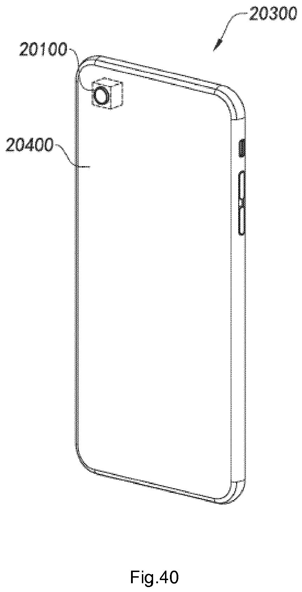

Referring to Fig. 40, the image capture module 20100 can be applied to an electronic device 20300. The electronic device 20300 is, for example, but not limited to a smart phone, a wearable device, a computer device, a television set, a transportation tool, a camera, a monitoring device, or the like. The electronic device 20300 can include an electronic device main body 20400. The image capture module 20100 is mounted in the electronic device main body 20400, and cooperates with the electronic device main body 20400 to complete image acquisition and reproduction.

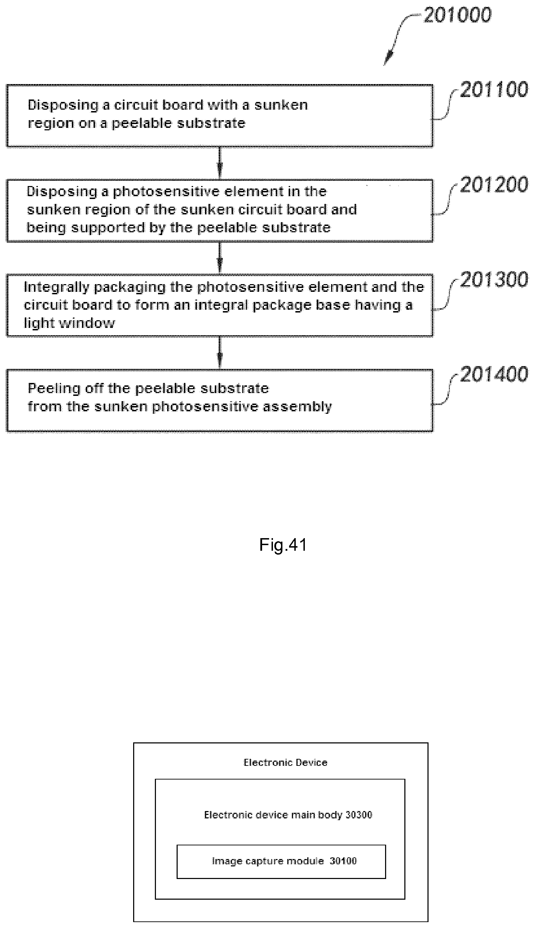

In summary, referring to Fig. 41, the present disclosure provides a method 201000 for manufacturing a photosensitive assembly 2010, the method comprising the following steps of:
201100: disposing a circuit board 2012 with a setting region 20122 on a peelable substrate 20201;
201200: sinking a photosensitive element 2013 in the setting region 20122 of the circuit board 2012 and being supported by the peelable substrate 20201 ;
201300: integrally packaging the photosensitive element 2013 and the circuit board 2012 to form an integral package base 2011 having a light window 20111; and
201400: peeling off the peelable substrate 20201 from the photosensitive assembly 2010.

In the step 201100, the setting region 20122 can be formed by opening or slotting a circuit board. The peelable substrate 20201 can be a sticky substrate.

The circuit board 2012 may include a circuit board main body 20121 and at least one electronic component 20123. The setting region 20122 and the electronic component 20123 are disposed on the circuit board main body 20121. The electronic component 20123 may be disposed on the circuit board main body 20121 before the circuit board main body 20121 is disposed on the peelable substrate 20201, or may be disposed on the circuit board main body 20121 after the circuit board main body 20121 is disposed on the peelable substrate 20201. By way of example but not limitation, the electronic component 20123 is disposed on the circuit board main body 20121 by means of SMT.

In an implementation, in the step 201200, the back surface 20132 of the photosensitive element 2013 is aligned with the bottom surface 201211 of the circuit board main body 20121.

In another implementation, in the step 201200, the peelable substrate 20201 is provided with at least one support pillar, and the photosensitive element 2013 is supported by the support pillar, so that the front surface 20131 of the photosensitive element 2013 is aligned with the front surface 20131 of the circuit board main body 20121.

The step 201200 further comprises a step of electrically connecting the photosensitive element 2013 and the circuit board main body 20121 by at least one electrical connection element 20133.

In an implementation, the step 201300 includes a step of overmolding the electronic component 20123 and the electrical connection element 20133 by the integral package base 2011.

The step 201300 may further include: forming a gap 2014 between the photosensitive element 2013 and the circuit board main body 20121, and the integral package base 2011 extending into the gap 2014.

The step 201300 may further include: forming a gap 2014 between the photosensitive element 2013 and the circuit board main body 20121, filling the gap 2014 with a filling medium 2015, and pre-fixing the photosensitive element 2013 and the circuit board main body 20121. By way of example and not limitation, the filling medium 2015 can be glue.

The step 201300 may further include: forming a gap 2014 between the photosensitive element 2013 and the circuit board main body 20121, and the integrated base extending into the gap 2014 and overmolding the back surface 20132 of the photosensitive element 2013.

The step 201300 may further include: forming a spacer medium 20114 in the non-photosensitive region 201312 of the photosensitive element 2013, and forming a base main body 20112 with the spacer medium 20114 as a boundary. Preferably, the spacer medium 20114 is an annular protrusion. For example, the spacer medium 20114 can be formed by applying glue on the photosensitive element 2013.

The step 201300 may further include the following steps of:
201301: forming a backing 2011211 at a position of the photosensitive element 2013 where the electrical connection element 20133 is not disposed;
201302: forming a primary package base 2011212 with the backing 2011211 as a boundary, and pre-fixing the photosensitive element 2013 and the circuit board main body 20121;
201303: forming an encapsulation base 2011221 at a position of the photosensitive element 2013 where the electrical connection element 20133 is disposed, overmolding the electrical connection element 20133 by the encapsulation base 2011221, and forming an annular structure 201123 with the primary package base 2011212; and
201304: forming a secondary package base 2011222 on the basis of the annular structure 201123 to form the light window.

In the step 201304, the secondary package base 2011222 may form a mounting slot 20113 with the annular structure 201123.

Further, in an implementation, before the step 201300, the method may further include a step of covering a photosensitive element 2013 with a filter element 2040.

The step 201300 may further include a step of integrally packaging the photosensitive element 2013, the circuit board 2012, and the filter element 2040.

In an implementation, the backing 2011211 and the encapsulation base 2011221 may be formed by applying glue. Of course, the backing 2011211 and the encapsulation base 2011221 may also be elastic medium of other materials.

In the step 201400, the manner in which the peelable substrate 20201 peels off the photosensitive assembly 2010 is, for example, but not limited to, peeling, exposure, hot melt, etching, dissolving, grinding, or the like.

Preferably, the manner of integrally packaging is a transfer molding manner.

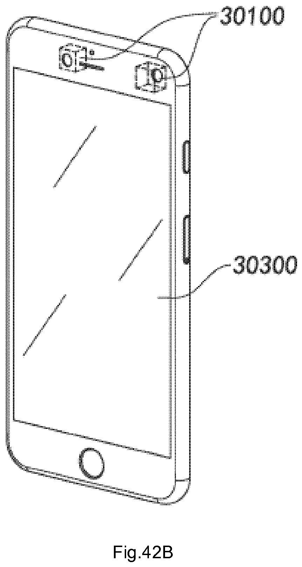

With reference to Fig. 42A and Fig. 42B in the specification of the present disclosure, the present disclosure provides an electronic device, wherein the electronic device includes an electronic device main body 30300 and at least one image capture module 30100. The image capture module 30100 is disposed in the electronic device main body 30300 for capturing an image. For example, the image capture module 30100 can be disposed at the rear of the electronic device main body 30300 to form a rear-mounted image capture module, or the image capture module 30100 can be disposed in front of the electronic device main body 30300 to form a front-mounted image capture module.

It should be noted that the electronic device main body 30300 can be, but not limited to, a smart phone, a tablet computer, a camera, a security device, a television set, a computer device, a wearable device, or the like, and the electronic device main body 30300 implemented as a smart phone shown in Fig. 42B is merely an example to illustrate the features and advantages of the present disclosure, and should not be construed as limiting the scope and scope of the present disclosure.

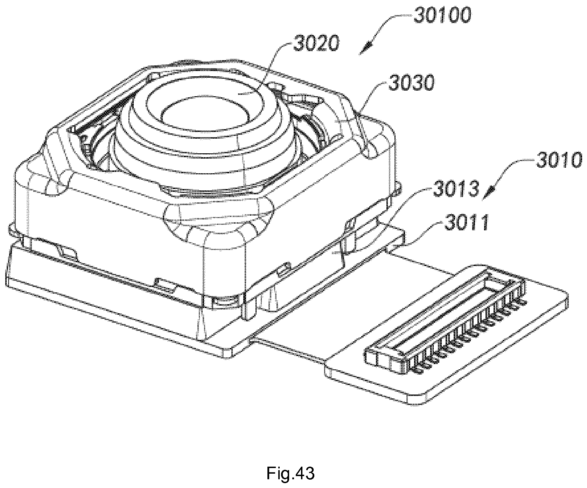

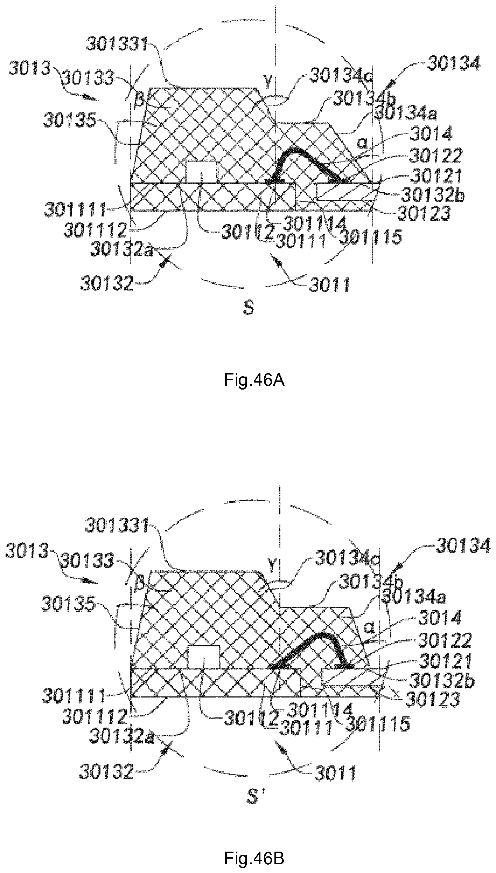

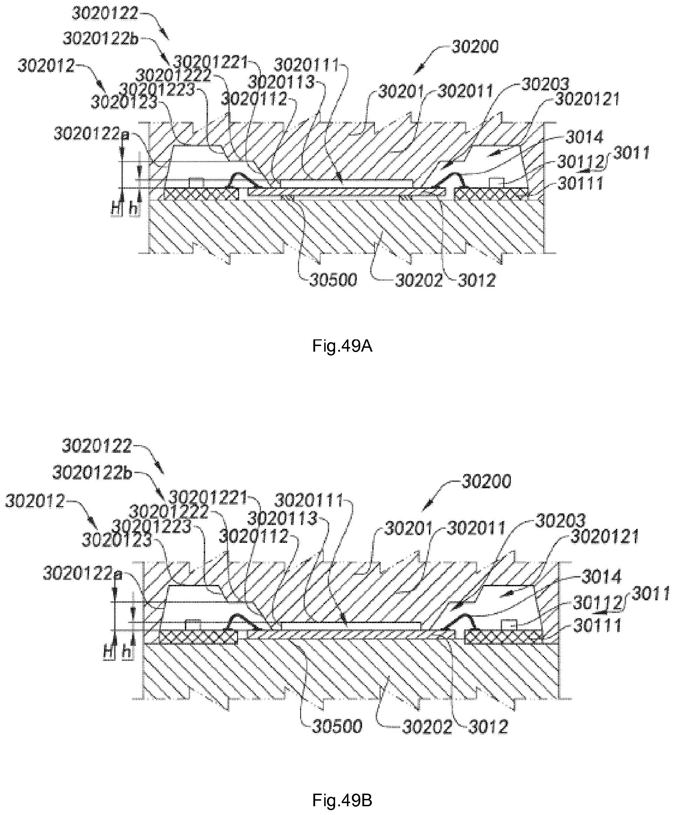

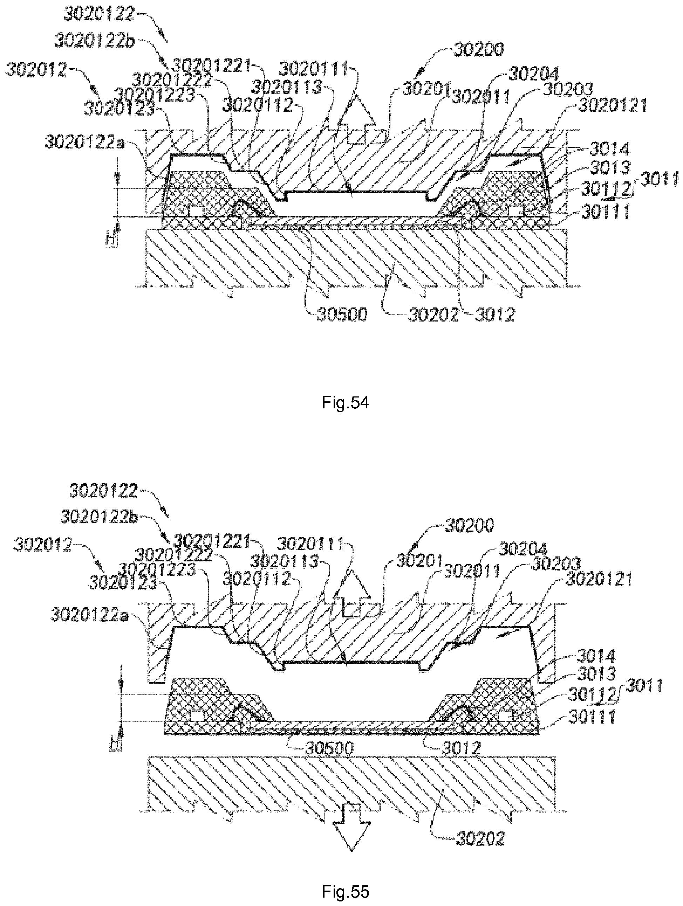

Hereinafter, the image capture module 30100 of the present disclosure will be further explained in Figs. 43 to 57B and in the following description. In addition, a molding die 30200 is further described in Figs. 49A to 55 and the following description, for performing a molding process in the process of manufacturing the image capture module 30100.

Specifically, the image capture module 30100 includes a molded circuit board assembly 3010 and at least one optical lens 3020. The molded circuit board assembly 3010 further includes a circuit board 3011, at least one photosensitive element 3012, and a maintaining portion 3013 integrally molded on the circuit board 3011 and the photosensitive element 3012. The optical lens 3020 is held in the photosensitive path of the photosensitive element 3012, so that the light reflected by an object enters the inside of the image capture module 30100 from the optical lens 3020, and is received and photoelectrically converted by the photosensitive element 3012 for imaging.

It should be noted that, in Fig. 43 to Fig. 57B and the following description, a case where the image capture module 30100 only includes one photosensitive element 3012 and one optical lens 3020 is taken as an example to illustrate the present disclosure. The features and advantages of the image capture module 30100 are not to be construed as limiting the content and scope of the image capture module 30100 of the present disclosure. In other examples of the image capture module 30100, the number of the photosensitive element 3012 and the optical lens 3020 may be more than one. For example, the photosensitive element 3012 and the optical lens 3020 are implemented as two, three, four or more.

The maintaining portion 3013 is integrally molded to the photosensitive element 3012, so that the flatness of the photosensitive element 3012 can be held by the maintaining portion 3013, and thus the flatness of the photosensitive element 3012 is no longer limited by the circuit board 3011. By this way, the flatness of the photosensitive element 3012 cannot only be ensured, but the image capture module 30100 can also select a thinner circuit board 3011. For example, the circuit board 3011 can select a thinner PCB board or a Rigid-Flex board, and even the circuit board 3011 may select an FPC board, thereby reducing the size of the image capture module 30100, especially reducing the height dimension of the image capture module 30100. The image capture module 30100 is particularly suitable for being applied to the electronic device that is intended to be thin and light, and the image capture module 30100 is also particularly suitable for being applied in the front of the electronic device to form a front-mounted image capture module.

In a specific example of the image capture module 30100 of the present disclosure, the photosensitive element 3012 and the circuit board 3011 that are conductively connected, may not be in direct contact, but by the maintaining portion 3013 integrally molded on the circuit board 3011 and the photosensitive element 3012, the photosensitive element 3012 and the circuit board 3011 are held in relative positions. Thus, in the process of using the image capture module 30100, even if the circuit board 3011 is deformed by heat, the flatness of the photosensitive element 3012 is not affected, and by this way, the imaging quality of the image capture module 30100 can be effectively improved, and the reliability of the image capture module 30100 is ensured.

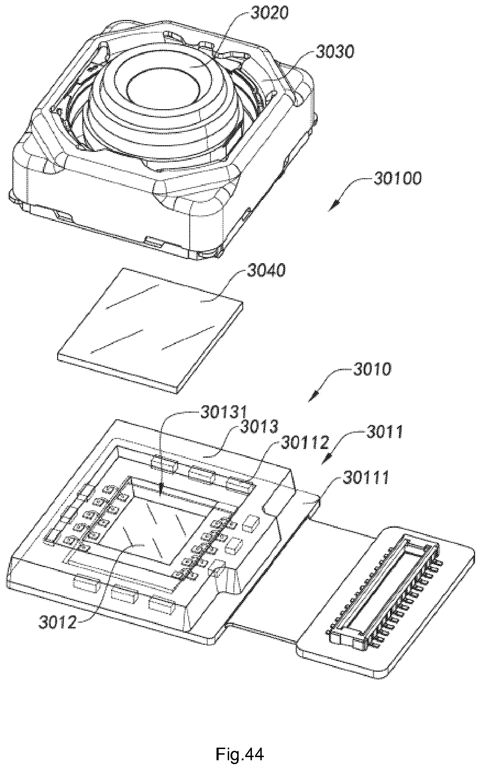

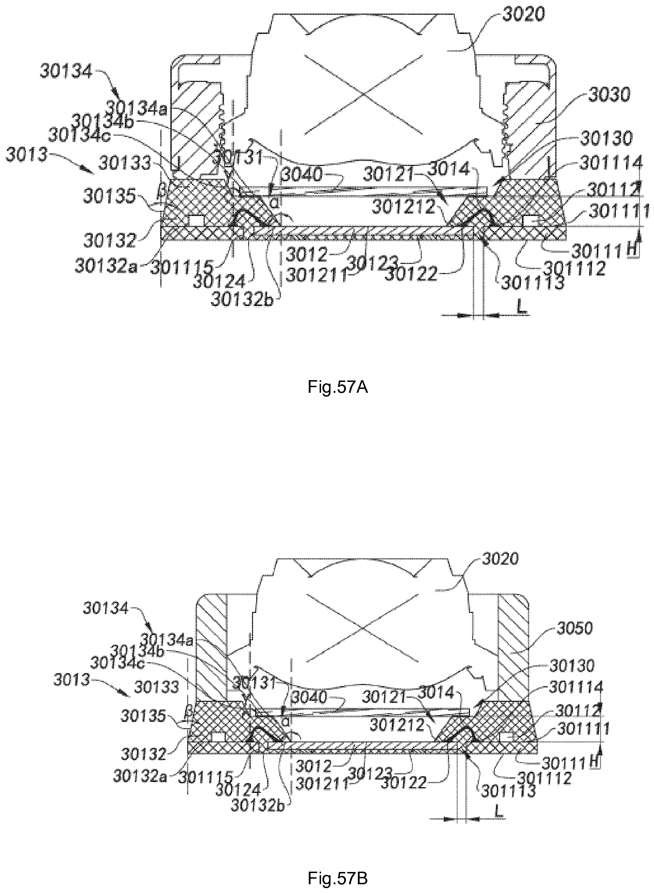

Referring to Fig. 44 and Fig. 57A and Fig. 57B, the maintaining portion 3013 forms at least one light window 30131 so that the photosensitive element 3012 and the optical lens 3020 correspond to the light window 30131 on two sides of the maintaining portion 3013, respectively. As a result, the photosensitive element 3012 communicates with the optical lens 3020 through the light window 30131, that is, the light window 30131 provides a light path for the optical lens 3020 and the photosensitive element 3012, to allow the light that enters the interior of the image capture module 30100 from the optical lens 3020 to be received and photoelectrically converted by the photosensitive element 3012 to form an image after passing through the light window 30131. In other words, the light reflected by the object enters the inside of the image capture module 30100 from the optical lens 3020, and is received and photoelectrically converted by the photosensitive element 3012 to form an image after passing through the light window 30131 of the maintaining portion 3013. Preferably, the light window 30131 of the maintaining portion 3013 is formed in the central portion of the maintaining portion 3013, that is, the light window 30131 is a central perforated hole.

The maintaining portion 3013 further has a bonding side 30132, a mounting side 30133, an inner surface 30134, and at least one outer surface 30135. When the maintaining portion 3013 has one outer surface 30135, the bonding side 30132 and the mounting sides 30133 correspond to each other, the inner surface 30134 and the outer surface 30135 correspond to each other, and the inner surface 30134 defines the light window 30131. The inner surface 30134 and the outer surface 30135 of the maintaining portion 3013 extend between the bonding side 30132 and the mounting side 30133, respectively. That is, the light window 30131 of the maintaining portion 3013 is in communication with the bonding side 30132 and the mounting side 30133.

It should be noted that the outer surface 30135 may be a flat surface or a curved surface, which is selected as needed.

In another example, the maintaining portion 3013 may further have a plurality of the outer surfaces 30135 so that the outer shape of the maintaining portion 3013 is stepped.

The photosensitive element 3012 is held on the bonding side 30132 of the maintaining portion 3013. For example, by means of being integrally bonded with the photosensitive element 3012, the maintaining portion 3013 can cause the photosensitive element 3012 to be held on the bonding side 30132 of the maintaining portion 3013, and cause the optical lens 3020 to be held on the mounting side 30133 of the maintaining portion 3013, so that the photosensitive element 3012 and the optical lens 3020 optically correspond on the two sides of the maintaining portion 3013, respectively.

Preferably, at least a part of the inner surface 30134 of the maintaining portion 3013 extends obliquely between the bonding side 30132 and the mounting side 30133. More preferably, the outer surface 30135 of the maintaining portion 3013 also extends obliquely between the bonding side 30132 and the mounting side 30133. It should be noted that the mounting side 30133 of the maintaining portion 3013 has a plane parallel to the photosensitive element 3012.

The bonding side 30132 of the maintaining portion 3013 is integrally bonded with the circuit board 3011 and the photosensitive element 3012 to form the molded circuit board assembly 3010. It should be understood by those skilled in the art that at least a part of the inner surface 30134 extends obliquely between the bonding side 30132 and the mounting side 30133, so that the opening size of the light window 30131 on the bonding side 30132 is smaller than the opening size of the light window 30131 on the mounting side 30133.

The image capture module 30100 of the present disclosure can be implemented as an automatic focus image capture module. Referring to Fig. 57A, the image capture module 30100 further includes at least one driver 3030. For example, the driver 3030 can be implemented as a voice coil motor, a piezoelectric motor or the like. The optical lens 3020 is drivably disposed on the driver 3030, and the driver 3030 is assembled to the mounting side 30133 of the maintaining portion 3013, thereby enabling the optical lens 3020 to be held by the driver 3030 in the photosensitive path of the photosensitive element 3012 on the mounting side 30133 of the maintaining portion 3013. That is, the maintaining portion 3013 is used for supporting the driver 3030.

The image capture module 30100 of the present disclosure may also be implemented as a fixed focus image capture module. For example, the optical lens 3020 may be directly attached to the mounting side 30133 of the maintaining portion 3013 so that the optical lens 3020 is held in the photosensitive path of the photosensitive element 3012. Referring to Fig. 16B, the optical lens 3020 can also be mounted on a lens holder 3050, and then the lens holder 3050 can be attached to the mounting side 30133 of the maintaining portion 3013, so that the optical lens 3020 is held by the lens holder 3050 in the photosensitive path of the photosensitive element 3012 on the mounting side 30133 of the maintaining portion 3013. Therefore, those skilled in the art can understand that, in the embodiment of the image capture module 30100 shown in Fig. 43 to Fig. 57A, a case where the image capture module 30100 is implemented as an automatic focus image capture module is taken as example to illustrate a mode that the present disclosure can be implemented. However, the content and scope of the image capture module 30100 of the present disclosure are not limited.

In addition, referring further to Fig. 57A and Fig. 57B, the image capture module 30100 may include at least one filter element 3040, wherein the filter element 3040 is mounted on the maintaining portion 3013 so that the filter element 3040 is held by the maintaining portion 3013 between the optical lens 3020 and the photosensitive element 3012, for filtering light entering the interior of the image capture module 30100 from the optical lens 3020. For example, the filter element 3040 can be, but is not limited to, an infrared cut-off filter.

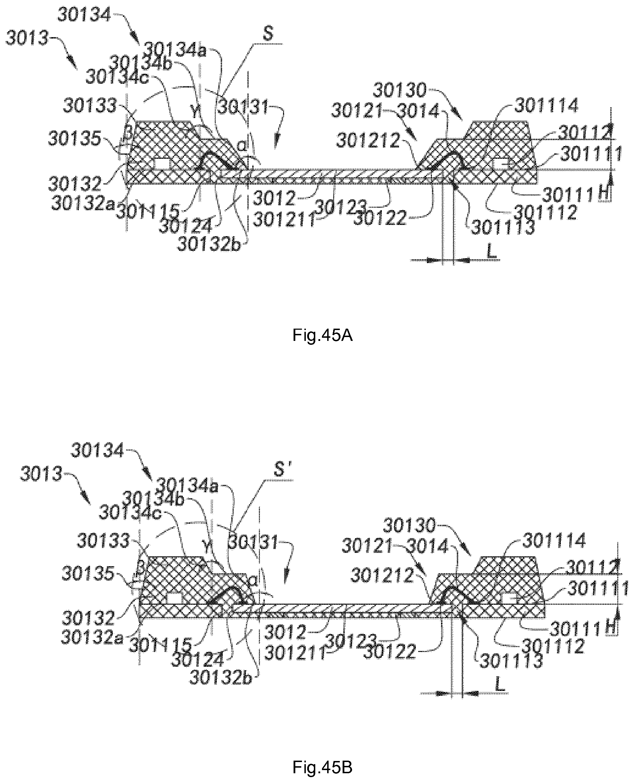

Further, referring to Fig. 45A to Fig. 45D, the bonding side 30132 of the maintaining portion 3013 has an outer bonding surface 30132a and an inner bonding surface 30132b, wherein the outer bonding surface 30132a and the inner bonding surface 30132b of the bonding side 30132 are integrally formed when the maintaining portion 3013 is formed. The circuit board 3011 and at least a part of the outer bonding surface 30132a of the maintaining portion 3013 are integrally bonded, and the photosensitive element 3012 and at least a part of the inner bonding surface 30132b of the maintaining portion 3013 are integrally bonded, to form the molded circuit board assembly 3010.

It should be noted that a plane where the outer bonding surface 30132a of the bonding side 30132 of the maintaining portion 3013 is located and a plane where the inner bonding surface 30132b is located may be in the same horizontal plane, or may have a height difference. The image capture module 30100 of the present disclosure is not limited in this regard.

Further, continuing to refer to Fig. 45A to Fig. 45D, the inner surface 30134 of the maintaining portion 3013 has a first inner surface 30134a, a second inner surface 30134b, and a third inner surface 30134c, wherein the first inner surface 30134a is formed on the bonding side 30132, the third inner surface 30134c is formed on the mounting side 30133, and the second inner surface 30134b is formed between the first inner surface 30134a and the third inner surface 30134c; and wherein the first inner surface 30134a extends obliquely from the bonding side 30132 toward the mounting side 30133, a plane where the second inner surface 30134b is located is parallel to the photosensitive element 3012, and a plane where the third inner surface 30134c is located may be perpendicular to a plane in which the second inner surface 30134b is located, or may form an included angle with the plane in which the second inner surface 30134b is located, that is, the third inner surface 30134c extends obliquely from the mounting side 30133 toward the bonding side 30132. Preferably, the third inner surface 30134c extends obliquely from the mounting side 30133 toward the bonding side 30132. The filter element 3040 is attached to the second inner surface 30134b of the maintaining portion 3013 to keep the filter element 3040 and the photosensitive element 3012 horizontal.

It can be understood that the second inner surface 30134b of the maintaining portion 3013 and the mounting surface 301331 of the mounting side 30133 of the maintaining portion 3013 have a height difference, and the plane where the second inner surface 30134b is located is lower than a plane where the mounting surface 301331 of the mounting side 30133 of the maintaining portion 3013 is located, so that the maintaining portion 3013 forms a mounting slot 30130. The filter element 3040 mounted to the second inner surface 30134b is received and held in the mounting slot 30130 of the maintaining portion 3013, to further reduce the height dimension of the image capture module 30100.

In the present disclosure, a first included angle α is formed between the first inner surface 30134a of the maintaining portion 3013 and the optical axis of the photosensitive element 3012, wherein the first included angle α is an acute angle. A third included angle γ is formed between the third inner surface 30134c of the maintaining portion 3013 and the optical axis of the photosensitive element 3012, wherein the third included angle γ is an acute angle. By this way, in the process of using the molding die 30200 to mold the molded circuit board assembly 3010 of the image capture module 30100, the frictional force generated between the molding die 30200 and the inner surface 30134 of the maintaining portion 3013 can be reduced and the second inner surface 30134a is ensured to keep horizontal, thereby improving the product yield rate of the image capture module 30100 and improving the imaging quality of the image capture module 30100.

The first included angle α ranges from 1° to 85°. That is, the minimum value allowed for the first included angle α is 1°, and the maximum value allowed therefor is 85°. Preferably, the first included angle α ranges from 35° to 75°. In some specific embodiments of the image capture module 30100 of the present disclosure, the first included angle α may range from 5° to 10°, 10° to 15°, 15° to 20°, 20° to 25°, 25° to 30°, 30° to 35°, 35° to 40°, 40° to 45°, 45° to 50°, 50° to 55°, 55° to 60°, 60° to 65 °, 65° to 70°, 70° to 75°, 75° to 80° or 80° to 85°. Of course, the first included angle α may also range from 3° to 5° or 85 ° to 90 °.

The third included angle γ ranges from 1° to 60°. That is, the minimum value allowed for the third included angle γ is 1°, and the maximum value allowed therefor is 60°. In some embodiments of the image capture module 30100 of the present disclosure, it may be 3° to 5°, 5° to 10°, 10° to 15°, 15° to 20°, 20° to 25°, or 25° to 30°. Of course, the third included angle γ may also range from 30° to 35°, 35° to 40° or 40° to 45°.

In addition, a second included angle β may be formed between the outer surface 30135 of the maintaining portion 3013 and the optical axis of the photosensitive element 3012, wherein the second included angle β is an acute angle. By this way, in the process of using the molding die 30200 to mold the molded circuit board assembly 3010 of the image capture module 30100, the frictional force generated between the molding die 30200 and the outer surface 30135 of the maintaining portion 3013 can be reduced to facilitate drafting.

The second included angle β ranges from 1° to 65°. That is, the minimum value allowed for the second included angle β is 1°, and the maximum value allowed therefor is 65°. In some embodiments of the image capture module 100 of the present disclosure, the second included angle β may range from 3° to 5°, 5° to 10°, 10° to 15°, 15° to 20°, 20° to 25°, 25° to 30°, 30° to 35°, 35° to 40° or 40° to 45°. Of course, the second included angle β may also range from 45° to 50°, 50° to 55° or 55° to 60°.

The circuit board 3011 includes a substrate 30111 and at least one electronic component 30112. The electronic component 30112 can be buried inside the substrate 30111, or the electronic component 30112 is mounted on the surface of the substrate 30111. For example, the electronic component 30112 can be mounted on the surface of the substrate 30111 by an SMT process. Preferably, in the image capture module 30100 of the present disclosure, the electronic component 30112 is mounted on the surface of the substrate 30111. When the maintaining portion 3013 is integrally molded on the substrate 30111 of the circuit board 3011, the maintaining portion 3013 may embed at least one of the electronic components 30112 to prevent contaminants such as dust adhering to the component 30112 from subsequently contaminating the photosensitive element 3012, thereby improving the imaging quality of the image capture module 30100.

Preferably, the maintaining portion 3013 embeds each of the electronic components 30112. By this way, on one hand, the maintaining portion 3013 can isolate adjacent electronic components 30112 to avoid adjacent electronic components 30112 to interfere with each other. On the other hand, the maintaining portion 3013 can prevent the electronic component 30112 from being oxidized by contact with air, and on still another hand, a safety distance is not required to be reserved between the maintaining portion 3013 and the electronic component 30112, so that the structure of the image capture module 30100 is more compact, so as to reduce the size of the image capture module 30100, especially the height of the image capture module 30100. Thus, the image capture module 30100 is particularly suitable for use in the electronic device that is intended to be thin and light. In addition, the manner in which the maintaining portion 3013 embeds each of the electronic components 30112 can prevent the maintaining portion 3013 from falling off the substrate 30111 of the circuit board 3011, thereby ensuring the reliability and stability of the image capture module 30100.

It should be noted that the type of the electronic component 30112 is not limited in the image capture module 30100 of the present disclosure. For example, the electronic component 30112 may be a resistor, a capacitor, a driver, a processor, a relay, a memory, a converter or the like.

The substrate 30111 has the substrate upper surface 301111 and a substrate lower surface 301112, wherein the substrate upper surface 301111 and the substrate lower surface 301112 correspond to each other to define a thickness dimension of the substrate 30111. Each of the electronic components 30112 is separately mounted on the substrate upper surface 301111 of the substrate 30111, and the maintaining portion 3013 is integrally molded on the substrate upper surface 301111 of the substrate 30111 to embed each of the electronic components 30112. Of course, in other embodiments of the present disclosure, the electronic component 30112 may be disposed inside on the lower surface of the substrate 30111. It should be understood by those skilled in the art that the type and location of the electronic component 30112 are not limiting to the present disclosure.

In addition, the substrate 30111 further has at least one receiving space 301113, wherein the receiving space 301113 is located at the central portion of the substrate 30111, and the receiving space 301113 extends from the substrate upper surface 301111 toward the substrate lower surface 301112. In this example of the image capture module 30100 of the present disclosure, the photosensitive element 3012 is received in the receiving space 301113 of the substrate 30111 to reduce the height difference of the chip upper surface 30121 of the photosensitive element 3012 and the substrate upper surface 301111 of the substrate 30111, even so that the chip upper surface 30121 of the photosensitive element 3012 and the substrate upper surface 301111 of the substrate 30111 to be flush, or the chip upper surface 30121 of the photosensitive element 3012 is lower than the substrate upper surface 301111 of the substrate 30111. By this way, the image capture module 30100 can have a longer lens back focal length moving space.

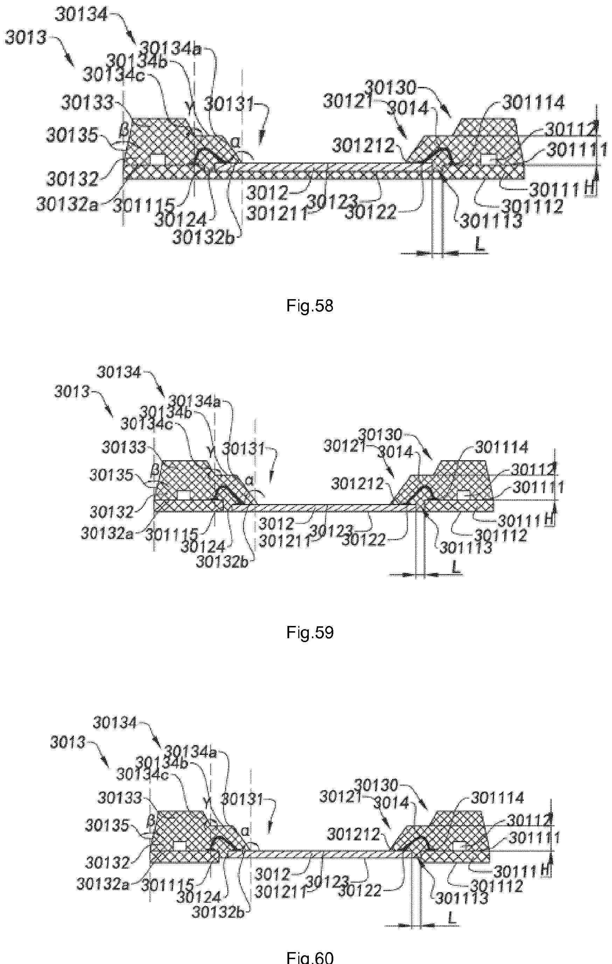

Referring to Figs. 57A and 57B, the receiving space 301113 of the substrate 30111 may be implemented as a through hole, that is, the receiving space 301113 communicates with the substrate upper surface 301111 and the substrate lower surface 301112 of the substrate 30111. In a modified embodiment of the image capture module 30100 shown in Fig. 58, the receiving space 301113 of the substrate 30111 can also be implemented as a receiving groove, that is, the receiving space 301113 has only one opening formed on the substrate upper surface 301111 of the substrate 30111.

The chip upper surface 30121 of the photosensitive element 3012 has a photosensitive region 301211 and a non-sensitive region 301212, wherein the photosensitive region 301211 is located at the center of the chip upper surface 30121, and the non-sensitive region 301212 surrounds the periphery of the photosensitive region 301211. The maintaining portion 3013 and the non-photosensitive region 301212 of the photosensitive element 3012 are integrally bonded so that the photosensitive region 301211 of the photosensitive element 3012 optically corresponds to the optical lens 3020 through the light window 30131 of the maintaining portion 3013. Therefore, the light that enters the interior of the image capture module 30100 from the optical lens 3020 is received and photoelectrically converted by the photosensitive region 301211 of the photosensitive element 3012 after passing through the filter element 3040 and the light window 30131 of the maintaining portion 3013.

The substrate 30111 of the circuit board 3011 is conductively connected with the photosensitive element 3012. Specifically, the substrate 30111 includes a set of substrate connectors 301114, each of which is disposed apart from each other on the substrate upper surface 301111, or formed apart from each other on the substrate upper surface 301111. Correspondingly, the non-photosensitive region 301212 of the photosensitive element 3012 is provided with a set of mutually spaced chip connectors 30122, or the non-photosensitive regions 301212 of the photosensitive elements 3012 forms each of the chip connectors 30122 spaced apart from each other. The molded circuit board assembly 3010 further includes a set of leads 3014, wherein the leads 3014 extend between the substrate connector 301114 of the substrate 30111 and the chip connector 30122 of the photosensitive element 3012 to conductively connect the photosensitive element 3012 and the circuit board 3011.

It is worth mentioning that the lead 3014 may be, but not limited to, a gold wire, a lead wire, a copper wire, an aluminum wire, or the like.

It is also worth mentioning that the substrate connector 301114 of the substrate 30111 and the chip connector 30122 of the photosensitive element 3012 may be, but not limited to, a square shape, a spherical shape, a disk shape, or the like.

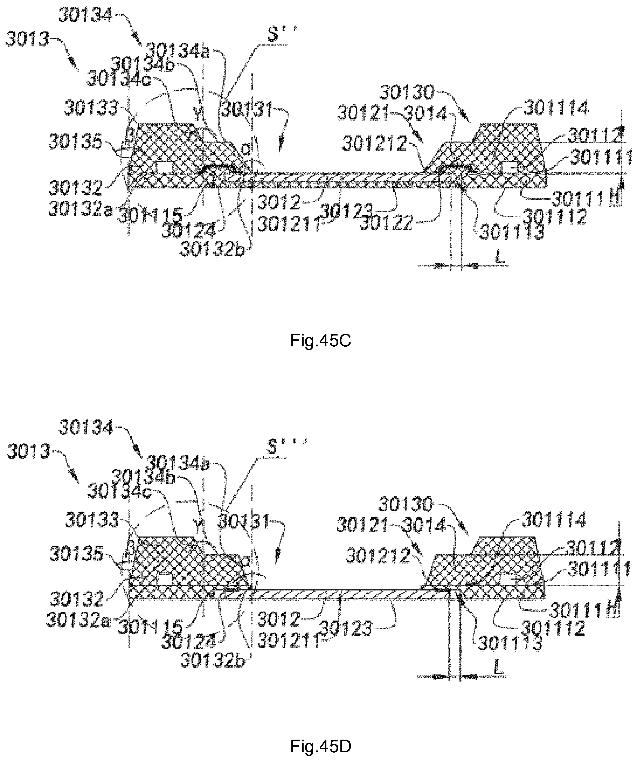

The wire bonding direction of the lead wire 3014 is not limited in the image capture module 30100 of the present disclosure. For example, in the image capture module 30100 shown in Fig. 45A, the wire bonding direction of the lead wire 3014 is from the substrate 30111 of the circuit board 3011 to the photosensitive element 3012, and in the image capture module 30100 shown in Fig. 45B, the wire bonding direction of the lead wire 3014 is from the photosensitive element 3012 to the substrate 30111 of the circuit board 3011. In Fig. 45C, the lead wire 3014 may be formed between the substrate 30111 of the circuit board 3011 and the photosensitive element 3012 by a flattening bonding process. In Fig. 45D, the lead wire 3014 may be omitted, but the photosensitive chip 3012 may be mounted on the substrate 30111 of the circuit board 3011 by a flip chip process, and the photosensitive chip 3012 and the circuit board 3011 can be conductively connected while the photosensitive chip 3012 is mounted to the circuit board 3011.

It will be understood by those skilled in the art that the wire bonding direction of the lead wire 3014 affects the angle of inclination of the inner surface 30134 of the maintaining portion 3013. For example, when the wire bonding direction of the lead wire 3014 is from the substrate 30111 of the circuit board 3011 to the photosensitive element 3012, the first included angle α formed between the first inner surface 30134a of the maintaining portion 3013 and the optical axis of the photosensitive element 3012 is larger. When the wire bonding direction of the lead wire 3014 is from the photosensitive element 3012 to the substrate 30111 of the circuit board 3011, the first included angle α formed between the first inner surface 30134a of the maintaining portion 3013 and the optical axis of the photosensitive element 3012 is smaller. In the example in which the lead wire 3014 is formed on the substrate 30111 of the circuit board 3011 and the photosensitive chip 3012 in a flattening bonding process, the first included angle α formed between the first inner surface 30134a of the maintaining portion 3013 and the optical axes of the photosensitive element 3012 has a larger value. In the example in which the photosensitive chip 3012 is directly mounted on the substrate 30111 of the circuit board 3011 by a flip chip process, the first included angle α formed between the first inner surface 30134a of the maintaining portion 3013 and the optical axis of the photosensitive element 3012 is larger. In the following description of the present disclosure, it will be further illustrated and explained.

Referring to Figs. 49A to 56, the molding die 30200 includes an upper mold 30201 and a lower mold 30202, wherein at least one of the upper mold 30201 and the lower mold 30202 can be operated so that the upper mold 30201 and the lower mold 30202 can be opened or hermetically closed to perform a clamping and drafting operation on the molding die 30200, and wherein when the upper mold 30201 and the lower mold 30202 are clamped, that is, when the upper mold 30201 and the lower mold 30202 are hermetically closed, at least one molding space 30203 is formed between the upper mold 30201 and the lower mold 30202 for molding the molded circuit board assembly 3010.

When the molded circuit board assembly 3010 is molded, the circuit board 3011 and the photosensitive element 3012 conductively connected are placed in the molding space 30203, and a fluid molding material 30400 is added to the molding space 30203, so that the molding material 30400 overmolds a portion of the substrate upper surface 301111 of the circuit board 3011 and at least a part of the non-photosensitive region 301212 of the photosensitive element 3012. Therefore, the molding material 30400 forms the maintaining portion 3013 integrally bonded to the circuit board 3011 and the photosensitive element 3012 after curing in the molding space 30203.

It should be noted that the molding material 30400 can be a liquid, a solid particle or a mixture of liquid and solid particles. The molding material 30400 may be a thermoplastic material or a thermosetting material. The molding material 30400 may be cured in the molding space 30203 by heating or cooling to form the maintaining portion 3013 integrally molded on the circuit board 3011 and the photosensitive element 3012.

More specifically, the upper mold 30201 includes at least one light window molding member 302011 and an enclosure member 302012, wherein the enclosure member 302012 is integrally formed around the light window molding member 302011, and the enclosure member 302012 has an annular molding guide groove 3020121, so that the molding guide groove 3020121 of the upper mold 30201 forms a part of the molding space 30203 when the upper mold 30201 and the lower mold 30202 are operated to be hermetically closed.

In addition, the center of the light window molding member 302011 has a groove 3020111, and the opening direction of the groove 3020111 coincides with the opening direction of the molding guide groove 3020121. In the molding process, the photosensitive region 301211 of the photosensitive element 3012 corresponds to the groove 3020111 of the light window molding member 302011, avoiding the pressing surface of the light window molding member 302011 to scratch the photosensitive region 301211 of the photosensitive element 3012 and protecting the photosensitive element 3012 during molding.

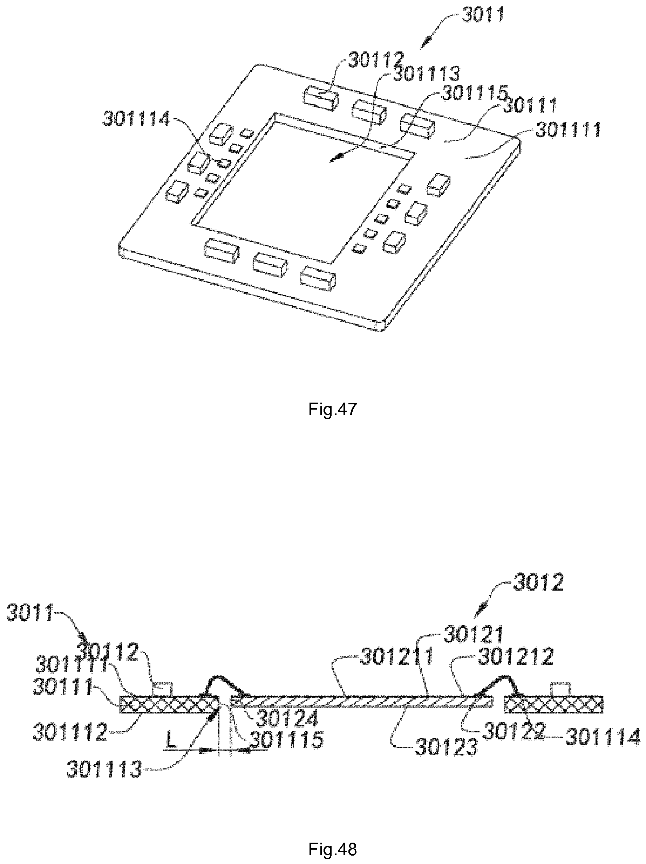

Figs. 47 to 56 illustrate a manufacturing process of the image capture module 30100.

Referring to Fig. 47, each of the electronic components 30112 is attached to the substrate upper surface 301111 of the substrate 30111 at intervals from each other. Preferably, each of the electronic components 30112 can be mounted on the substrate upper surface 301111 of the substrate 30111 by an SMT process.

Referring to Fig. 48, the photosensitive element 3012 is held in the receiving space 301113 of the substrate 30111, and the lead wire 3014 is disposed between the substrate connector 301114 of the substrate 30111 and the chip connector 30122 of the photosensitive element 3012 by a wire bonding process to conductively connect the photosensitive element 3012 and the circuit board 3011 by the lead wire 3014.

It should be noted that the wire bonding manner of the lead wire 3014 is selected as needed. For example, the wire bonding direction of the wire 3014 may be from the photosensitive element 3012 to the substrate 30111 of the circuit board 3011, or may be from the substrate 30111 of the circuit board 3011 to the photosensitive element 3012, or the lead wire 3014 may also be used to conductively connect the photosensitive element 3012 and the substrate 30111 of the circuit board 3011 in other manners.

It will be understood by those skilled in the art that the height and inclination of the lead wire 3014 on one side of the photosensitive element 3012 affect the inclination of the first inner surface 30134a of the maintaining portion 3013, so that when the height and inclination of the lead wire 3014 on one side of the photosensitive element 3012 are smaller, the first included angle α formed between the first inner surface 30134a of the maintaining portion 3013 and the optical axis of the photosensitive element 3012 may be larger, where the limit value of the first included angle α may be 85°, preferably 60° to 75°.

When the photosensitive element 3012 is received in the receiving space 301113 of the substrate 30111, the height difference between the chip upper surface 30121 of the photosensitive element 3012 and the substrate upper surface 301111 of the substrate 30111 is reduced. Preferably, in this example of the image capture module 30100 of the present disclosure, the chip upper surface 30121 of the photosensitive element 3012 and the substrate upper surface 301111 of the substrate 30111 are in the same horizontal plane, so that the image capture module 30100 has a longer lens back focal length moving space.

It should be noted that, in a modified implementation of the image capture module 30100 shown in Fig. 59, the chip upper surface 30121 of the photosensitive element 3012 may also be lower than the substrate upper surface 301111 of the substrate 30111, so that the lens back focal length moving space of the image capture module 30100 is longer. It can be understood that a chip lower surface 30123 of the photosensitive element 3012 can be at the same horizontal plane as the substrate lower surface 301112 of the substrate 30111, so that the chip upper surface 30121 of the photosensitive element 3012 is lower than the substrate upper surface 301111 of the substrate 30111.

Further, after the photosensitive element 3012 is received in the receiving space 301113 of the substrate 30111, the chip outer side surface 30124 of the photosensitive element 3012 and the substrate inner wall 301115 of the substrate 30111 are not in contact, that is, there is a first safety distance L between the chip outer side surface 30124 of the photosensitive element 3012 and the substrate inner wall 301115 of the substrate 30111 to avoid the occurrence of the bad phenomenon that the circuit board 3011 affects the flatness of the photosensitive element 3012.

It will be understood by those skilled in the art that the length and width dimensions of the receiving space 301113 of the substrate 30111 are larger than the length and width dimensions of the photosensitive element 3012, so that there is the first safety distance L between the chip outer side surface 30124 of the photosensitive element 3012 and the substrate inner wall 301115 of the substrate 30111, when the photosensitive element 3012 is received in the receiving space 301113 of the substrate 30111. By this way, when the image capture module 30100 is used for a long time, even when the substrate 30111 of the circuit board 3011 is deformed by heat, the photosensitive element 3012 does not directly contact the substrate 30111 of the circuit board 3011, to prevent the flatness of the photosensitive element 3012 from being affected, and thus the imaging quality of the image capture module 30100 is ensured. That is, the first safety distance L is formed between the substrate inner wall 301115 of the substrate 30111 and the chip outer side surface 30124 of the photosensitive element 3012, and a space is reserved for deformation of the substrate 30111.

In the image capture module 30100 of the present disclosure, the first safety distance L ranges from 0 mm to 5 mm (excluding 0 mm). Preferably, the first safety distance L ranges from 0 mm to 0.5 mm. Preferably, the first safety distance L ranges from 0 mm to 0.3mm. More preferably, the range of the first safety distance L is selected from 0 mm to 0.03 mm, 0.03 mm to 0.06 mm, 0.06 mm to 0.1 mm, 0.1 mm to 0.15 mm, 0.15 mm to 0.2 mm, 0.2 mm to 0.25 mm or 0.25mm-0.3mm. Of course, the range of the first safety distance L may also be other sizes, such as greater than 0.5 mm, 0.5 mm to 0.6 mm, 0.6 mm to 0.7 mm, 0.7 mm to 0.8 mm, 0.8 mm to 0.9 mm, 0.9 mm to 1 mm, 1 mm to 1.5 mm, 1.5 mm to 2 mm, 2 mm to 2.5 mm, 2.5 mm to 3 mm, 3 mm to 3.5 mm, 3.5 mm to 4 mm, 4 mm to 4.5 mm, or 4.5 mm to 5 mm.

Referring to Fig. 49A, the photosensitive element 3012 and the circuit board 3011 conductively connected are placed on the inner wall of the lower mold 30202 of the molding die 30200, and the upper mold 30201 and the lower mold 30202 of the molding die 30200 is subjected to a mold clamping operation, so that the molding space 30203 is formed between the upper mold 30201 and the lower mold 30202, and the photosensitive element 3012 and the circuit board 3011 conductively connected are held in the molding space 30203.

It can be understood that at least one support member 30500 may be disposed between the chip lower surface 30123 of the photosensitive element 3012 and the inner wall of the lower mold 30202 to ensure that the chip upper surface 30121 of the photosensitive element 3012, and the substrate upper surface 301111 of the substrate 30111 are at the same horizontal plane. In one example of the image capture module 30100 of the present disclosure, the support member 30500 may be a separate component so that after the molded circuit board assembly 3010 is formed, the support member 30500 forms a portion of the molded circuit board assembly 3010, referring to Fig. 49A.

In another example, referring further to Fig. 49B, the support member 30500 may also be integrally formed on the inner wall of the lower mold 30202, so that after the molding process is completed, the molded circuit board assembly 3010 such as shown in Fig. 19 is obtained.

Continuing to refer to Fig. 49A and Fig. 49B, it should be noted that the pressing surface of the enclosure member 302012 of the upper mold 30201 is pressed against the outer side portion of the substrate 30111 of the circuit board 3011 and the non-photosensitive region 301212 of the photosensitive element 3012, so that each of the electronic components 30112 of the circuit board 3011 and a portion of the non-photosensitive region 301212 of the photosensitive element 3012 correspond to the molding guide groove 3020121 of the enclosure member 302012. Accordingly, the pressing surface of the optical molding member 302011 of the upper mold 30201 is pressed against the non-photosensitive region 301212 of the photosensitive element 3012, so that the photosensitive region 301211 of the photosensitive element 3012 corresponds to the groove 3020111 of the light window molding member 302011, thereby avoiding the pressing surface of the light window molding member 302011 from scratching the photosensitive region 301211 of the photosensitive element 3012.

It should also be noted that a portion of the pressing surface of the enclosure member 302012 of the upper mold 30201 and the pressing surface of the light window molding member 302011 are of a unitary structure.

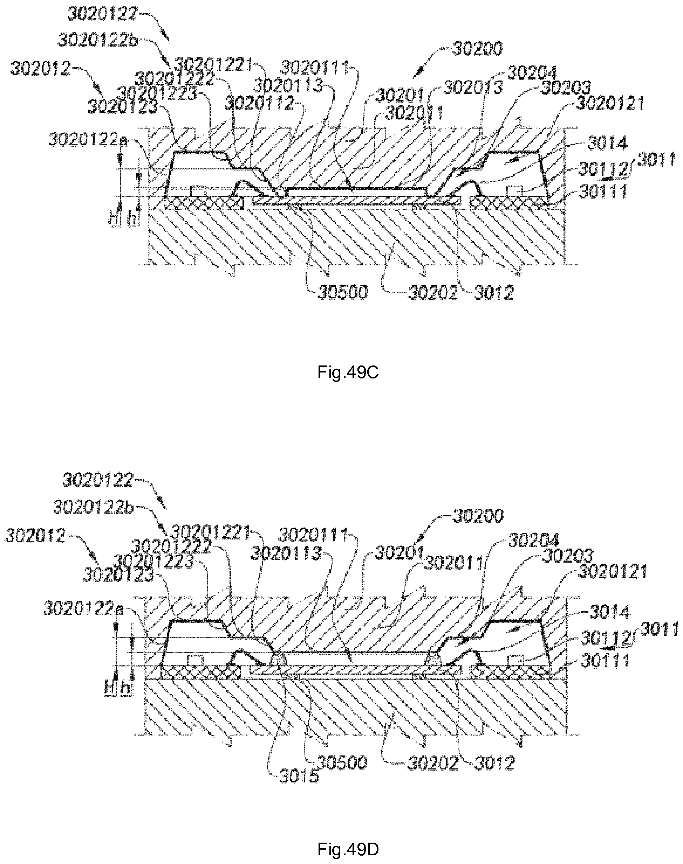

Referring to Fig. 49C, the molding die 30200 may further include a deformable cover film 30204, wherein the cover film 30204 is overlappedly disposed on the mold inner wall 302013 of the upper mold 30201. Preferably, the thickness of the cover film 30204 may vary slightly when the cover film 30204 is subjected to pressure. It can be understood that the pressing surface of the enclosure member 302012 of the upper mold 30201 and the pressing surface of the light window molding member 302011 are a part of the mold inner wall 302013 of the upper mold 30201, so that the cover film 30204 is also overlappedly disposed on the pressing surface of the enclosure member 302012 and the pressing surface of the light window molding member 302011.

When the pressing surface of the enclosure member 302012 of the upper mold 30201 and the pressing surface of the light window molding member 302011 are pressed against the substrate 30111 of the circuit board 3011 and the non-photosensitive region 301212 of the photosensitive element 3012, the cover film 30204 is located between the pressing surface of the enclosure member 302012 and the substrate upper surface 301111 of the substrate 30111 to prevent the generation of a gap between the pressing surface of the enclosure member 302012 and the substrate upper surface 301111 of the substrate 30111, and the cover film 30204 is located between the pressing surface of the light window molding member 302011 and the chip upper surface 30121 of the photosensitive element 3012 to prevent the generation of a gap between the pressing surface of the light window molding member 302011 and the chip upper surface 30121 of the photosensitive element 3012.

It can be understood that the cover film 30204 is used to isolate the mold inner wall 302013 of the upper mold 30201 and the substrate upper surface 301111 of the substrate 30111 and isolate the mold inner wall 302013 of the upper mold 30201 and the chip upper surface 30121 of the photosensitive element 3012, which can prevent the mold inner wall 302013 of the upper mold 30201 from scratching the chip upper surface 30121 of the photosensitive element 3012 or the substrate upper surface 301111 of the substrate 30111. In addition, the cover film 30204 can also absorb the impact force generated when the molding die 30200 is clamped to prevent the impact force from acting on the circuit board 3011 and the photosensitive element 3012, thereby protecting the circuit board 3011 and the photosensitive element 3012.

In addition, continuing to refer to Fig. 49A, Fig. 49B and Fig. 49C, the photosensitive region 301211 of the photosensitive element 3012 corresponds to the groove 3020111 of the light window molding member 302011 of the upper mold 30201, wherein the light window molding member 302011 has a light window molding peripheral wall 3020112 and a light window molding top wall 3020113. The light window molding top wall 3020113 is formed by a recess, and the light window molding peripheral wall 3020112 surrounds the periphery of the light window molding top wall 3020113 to form the groove 3020111 of the light window molding member 302011. It can be understood that the distance between the pressing surface of the light window molding member 302011 of the upper mold 30201 and the light window molding top wall 3020113 of the light window molding member 302011 is the same as the distance between the photosensitive region 301211 of the photosensitive element 3012 and the light window molding top wall 3020113 of the light window molding member 302011.

In the image capture module 30100 of the present disclosure, the second safety distance h is formed between the photosensitive region 301211 of the photosensitive element 3012 and the light window forming top wall 3020113 of the light window molding member 302011, where the second safety distance h ranges from 0 mm to 1 mm (including 0 mm). Preferably, the second safety distance h ranges from 0 mm to 0.01 mm, 0.01 mm to 0.05 mm, or 0.05 mm to 0.1 mm. Of course, the second safety distance h can also range from 0.1 mm to 1 mm, such as 0.1 mm to 0.2 mm, 0.2 mm to 0.3 mm, 0.3 mm to 0.4 mm, 0.4 mm to 0.5 mm, 0.5 mm to 0.6 mm, 0.6 mm to 0.7 mm, 0.7 mm to 0.8 mm, 0.8 mm to 0.9 mm, or 0.9 mm to 1 mm.

Continuing to refer to Figs. 49A, 49B, and 49C, the mold inner wall 302013 of the upper mold 30201 and the non-photosensitive region 301212 of the photosensitive element 3012 have a third safety distance H therebetween.

Specifically, the enclosure member 302012 of the upper mold 30201 has two guide groove molding peripheral walls 3020122 and a guide groove molding top wall 3020123, wherein one of the guide groove molding peripheral walls 3020122 is an outer guide groove molding peripheral wall 3020122a, and the other of the guide groove molding peripheral walls 3020122 is an inner guide groove molding peripheral wall 3020122b, and wherein the outer guide groove molding peripheral wall 3020122a and the inner guide groove molding peripheral wall 3020122b extend to the guide groove molding top wall 3020123, respectively, to form the molding guide groove 3020121 of the enclosure member 302012.

The inner guide groove molding peripheral wall 3020122b further has a first inner wall 30201221, a second inner wall 30201222, and a third inner wall 30201223, wherein the first inner wall 30201221, the second inner wall 30201222, and the third inner wall 30201223 are connected to each other and sequentially extend from the opening of the molding guide groove 3020121 to the guide groove molding top wall 3020123. It should be noted that the first inner wall 30201221 of the upper mold 30201 has the same inclination with the first inner surface 30134a of the maintaining portion 3013, the second inner wall 30201222 is flush with the second inner surface 30134b, and the inclination of the third inner wall 30201223 is the same as that of the third inner surface 30134c. Further, the outer surface 30135 of the maintaining portion 3013 and the outer guide groove molding peripheral wall 3020122a have the same inclination.

In the image capture module 30100 of the present disclosure, the vertical distance between the second inner wall 30201222 of the upper mold 30201 and the non-photosensitive region 301212 of the photosensitive element 3012 with respect to the non-photosensitive region is defined as the third safety distance H, which determines the distance between the second inner surface 30134b of the maintaining portion 3013 and the non-photosensitive region 301212 of the photosensitive element 3012. It can be understood that the size of the third safety distance H should not be too large or too small, so that the maintaining portion 3013 can be used to ensure the flatness of the photosensitive element 3012 without excessive stress generated on the photosensitive element 3012. In the image capture module 30100 of the present disclosure, the third safety distance H ranges from 0 mm to 3 mm (excluding 0 mm). Preferably, the third safety distance H ranges from 0 mm to 0.05 mm, 0.05 mm to 0.1 mm, 0.1 mm to 0.15 mm, 0.15 mm to 0.2 mm, 0.2 mm to 0.25 mm, or 0.25 mm to 0.3 mm. Of course, the third safety distance H ranges from 0.3 mm to 3 mm, 0.3 mm to 0.5 mm, 0.5 mm to 1 mm, 1 mm to 1.5 mm, 1.5 mm to 2 mm, 2 mm to 2.5 mm, or 2.5 mm to 3 mm.

Referring to Fig. 49D, in another example of the image capture module 30100, the light window molding member 302011 of the upper mold 30201 may not be provided with the groove 3020111, that is, the pressing surface of the light window molding member 302011 of the upper mold 30201 is a flat surface, and when the molded circuit board assembly 3010 is molded by the molding die 30200, the photosensitive region 301211 of the photosensitive element 3012 and the pressing surface of the light window molding member 302011 of the upper mold 30201 have the second safety distance h therebetween.

Specifically, a frame-shaped protective element 3015 is disposed outside the photosensitive region 301211 of the chip upper surface 30121 of the photosensitive element 3012, or the protective element 3015 is formed outside the photosensitive region 301211 of the chip upper surface 30121 of the photosensitive element 3012, so that the protective element 3015 protrudes from the chip upper surface 30121 of the photosensitive element 3012.

In one example of the image capture module 30100, the protective element 3015 can be prefabricated, and after the protective element 3015 is formed, the protective element 3015 is mounted on the chip upper surface 30121 of the photosensitive element 3012, so that the photosensitive region 301211 of the photosensitive element 3012 corresponds to a through hole of the protective element 3015.

In another example of the image capture module 30100, the protective element 3015 may be integrally formed outside the photosensitive region 301211 of the photosensitive element 3012, such as by applying glue and curing the glue outside the photosensitive region 301211 of the photosensitive element 3012. The frame-shaped protective element 3015 may be formed on the chip upper surface 30121 of the photosensitive element 3012, and the photosensitive region 301211 of the photosensitive element 3012 corresponds to the through hole of the protective element 3015. It is to be understood that the protective element 3015 is formed in the non-photosensitive region 301212 of the photosensitive element 3012 to avoid the protective element 3015 from blocking the photosensitive region 301211 of the photosensitive element 3012. Of course, in some embodiments of the present disclosure, the cover film 30204 may have a larger thickness, which may serve as a better cushioning effect during the manufacturing process to protect the photosensitive element 3012.

Preferably, the protective element 3015 may have elasticity so that when the molding die 30200 is clamped, the protective element 3015 can absorb an impact force generated when the molding die 30200 is clamped, thereby preventing the impact force from acting on the photosensitive element 3012. The protective element 3015 can also prevent the generation of a gap between the top surface of the protective element 3015 and the pressing surface of the light window molding member 302011 of the upper mold 30201 by deforming.

In addition, the protective element 3015 may also be rigid, so that when the molding die 30200 is clamped, the impact force generated when the molding die 30200 is clamped is absorbed by the pressing surface of the light window molding member 302011 located in the upper mold 30201 and the cover film 30204 of the top surface of the protective element 3015, and the generation of a gap between the top surface of the protective element 3015 and the mold inner walls 302013 of the upper mold 30201 is blocked by the cover film 30204.

After the molding die 30200 is clamped, the protective element 3015 is used to support the upper mold 30201 so that the second safety distance h is generated between the photosensitive region 301211 of the photosensitive element 3012 and the pressing surface of the light window molding member 302011 of the upper mold 30201 by the protective element 3015. Therefore, in the process of using the molding die 30200 to mold the molded circuit board assembly 3010, the photosensitive region 301211 of the photosensitive element 3012 is prevented from being scratched by the pressing surface of the light window molding member 302011 of the upper mold 30201.

It should be noted that the maintaining portion 3013 can overmold at least a part of the protective element 3015 after molding. For example, in this example of the molded circuit board assembly 3010 illustrated in Fig. 20, the maintaining portion 3013 overmolds the outer side of the protective element 3015, and in this example of the molded circuit board assembly 3010 shown in Fig. 21, the maintaining portion 3013 may overmold at least a part of the top surface of the protective element 3015.

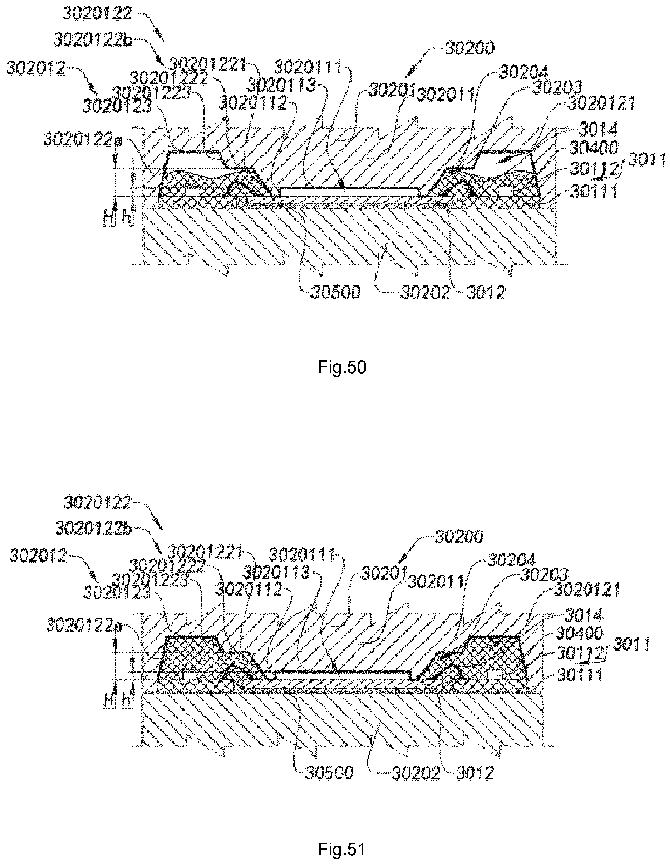

Referring to Figs. 50 and 51, the molding material 30400 in a fluid state is added into the molding space 30203 of the molding die 30200, wherein the molding material 30400 may be filled in a space formed between the chip lower surface 30123 of the photosensitive element 3012 and the lower mold 30202, a space formed between the substrate inner wall 301115 of the substrate 30111 and the chip outer side surface 30124 of the photosensitive element 3012, and the molding guide groove 3020121 of the upper mold 30201. After the molding material 30400 is cured in the molding space 30203, the maintaining portion 3013 is integrally formed with the circuit board 3011 and the photosensitive element 3012, wherein the light window molding member 302011 enables the maintaining portion 3013 to form the light window 30131.

It can be understood that, in this specific example of the image capture module 30100 of the present disclosure, the material filled in the space formed between the substrate inner wall 301115 of the substrate 30111 and the chip outer side surface 30124 of the photosensitive element 3012 is the molding material 30400, that is, a part of the maintaining portion 3013 is formed between the substrate inner wall 301115 of the substrate 30111 and the chip outer side surface 30124 of the photosensitive element 3012. In some examples of the image capture module 30100 of the present disclosure, a space formed between the substrate inner wall 301115 of the substrate 30111 and the chip outer side surface 30124 of the photosensitive element 3012 may not be filled by any material. In other examples of the image capture module 30100 of the present disclosure, a space formed between the substrate inner wall 301115 of the substrate 30111 and the chip outer side surface 30124 of the photosensitive element 3012 may also be filled with a flexible material, such as glue. Therefore, the molded circuit board assembly 3010 shown in Fig. 22 is obtained after the molding process is completed. In addition, a part of the protective element 3015 may also be filled in a space formed between the substrate inner wall 301115 of the substrate 30111 and the chip outer side surface 30124 of the photosensitive element 3012. Therefore, the molded circuit board assembly 3010 shown in Fig. 23 is obtained after the molding process is completed.

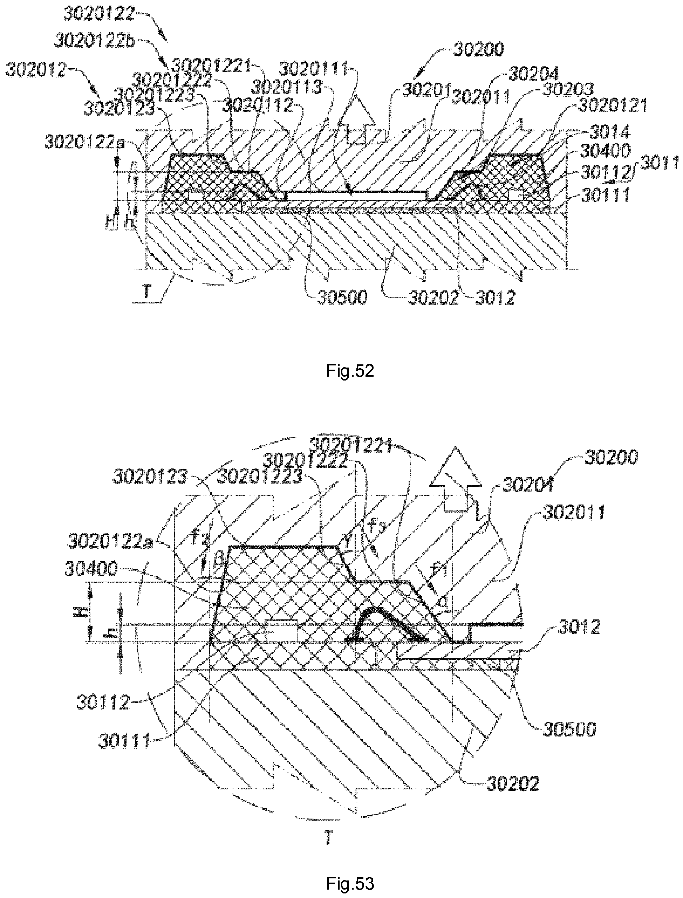

Figs. 52 to 55 show the drafting process of the molding die 30200. After the molding material 30400 is cured in the molding space 30203 of the molding die 30200, a drawing process is performed on the upper mold 30201 and the lower mold 30202 of the molding die 30200, namely the upper mold 30201 and the lower mold 30202 are separated from each other.

In the image capture module 30100 of the present disclosure, the first inner surface 30134a of the maintaining portion 3013 extends obliquely from the bonding side 30132 of the maintaining portion 3013 toward the mounting side 30133, so that the first included angle α is formed between the first inner surface 30134a and the optical axis of the photosensitive element 3012, where the first included angle α is an acute angle. Therefore, at the moment when drafting is performed to the molding die 30200, there is a frictional force f1 between the first inner surface 30134a of the maintaining portion 3013 and the mold inner wall 302013 of the upper mold 30201. When the upper mold 30201 of the molding die 30200 is slightly displaced relative to the lower mold 30202, no frictional force is generated between the first inner surface 30134a of the maintaining portion 3013 and the mold inner wall 302013 of the upper mold 30201. By this way, on one hand, the mold inner wall 302013 of the upper mold 30201 can be prevented from rubbing against the inner surface 30134 of the maintaining portion 3013 to scratch the inner surface 30134 of the maintaining portion 3013, and on the other hand, the mold inner wall 302013 of the upper mold 30201 can be prevented from rubbing against the inner surface 30134 of the maintaining portion 3013 to generate a pulling force acting on the maintaining portion 3013, thereby ensuring reliability of the bonding of the maintaining portion 3013 and the circuit board 3011 with the photosensitive element 3012.

That is, the first inner surface 30134a of the maintaining portion 3013 extends obliquely, so that not only the roughness of the first inner surface 30134a of the maintaining portion 3013 can be protected, but also the molding die 30200 can be easily released.

In the image capture module 30100 of the present disclosure, the third inner surface 30134c of the maintaining portion 3013 extends obliquely from the mounting side 30133 of the maintaining portion 3013 toward the bonding side 30132, so that the third included angle γ is formed between the third inner surface 30134c and the optical axis of the photosensitive element 3012, where the third included angle γ□is an acute angle. Therefore, at the moment when drafting is performed to the molding die 30200, there is a frictional force f3 between the third inner surface 30134c of the maintaining portion 3013 and the mold inner wall 302013 of the upper mold 30201. When the upper mold 30201 of the molding die 30200 is slightly displaced relative to the lower mold 30202, no frictional force is generated between the mold inner wall 302013 of the upper mold 30201 and the third inner surface 30134c of the maintaining portion 3013. By this way, on one hand, the mold inner wall 302013 of the upper mold 30201 can be prevented from rubbing against the inner surface 30134 of the maintaining portion 3013 to scratch the inner surface 30134 of the maintaining portion 3013, and on the other hand, the mold inner wall 302013 of the upper mold 30201 can be prevented from rubbing against the inner surface 30134 of the maintaining portion 3013 to generate a pulling force acting on the maintaining portion 3013, thereby ensuring reliability of the bonding of the maintaining portion 3013 and the circuit board 3011 with the photosensitive element 3012. On still another hand, the levelness of the second inner surface 30134b can be ensured.

Preferably, in the image capture module 30100 of the present disclosure, the outer surface 30135 of the maintaining portion 3013 extends obliquely from the bonding side 30132 of the maintaining portion 3013 toward the mounting side 30133, so that the second included angle β is formed between the outer surface 30135 of the maintaining portion 3013 and the optical axis of the photosensitive element 3012, and the second included angle β is an acute angle. Similarly, the outer surface 30135 of the maintaining portion 3013 extends obliquely. In the process of the molding die 30200 being drafted, at the moment when drafting is performed to the molding die 30200, a frictional force f2 is generated between the outer surface 30135 of the maintaining portion 3013 and the outer guide groove molding peripheral wall 3020122a of the upper mold 30201. When the upper mold 30201 of the molding die 30200 is slightly displaced relative to the lower mold 30202, no frictional force may be generated between the outer surface 30135 of the maintaining portion 3013 and the outer guiding groove molding peripheral wall 3020122a of the upper mold 30201. Thus, not only drafting can be easily performed, but also the roughness of the outer surface 30135 of the maintaining portion 3013 can be ensured, increasing the product yield rate of the image capture module 30100.

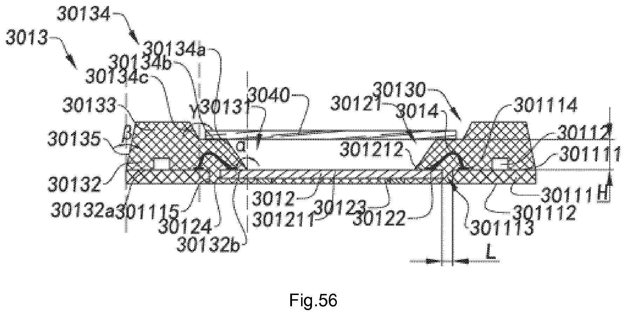

Referring to Fig. 56 and Fig. 57A, the filter element 3040 is first mounted on the second inner surface 30134b of the maintaining portion 3013 so that the filter element 3040 is parallel to the photosensitive region 301211 of the photosensitive element 3012. Then, the driver 3030 assembled with the optical lens 3020 is mounted to the mounting side 30133 of the maintaining portion 3013, and the driver 3030 and the circuit board 3011 are conductively connected, so that the optical lens 3020 is held in the photosensitive path of the photosensitive element 3012 to obtain the image capture module 30100.

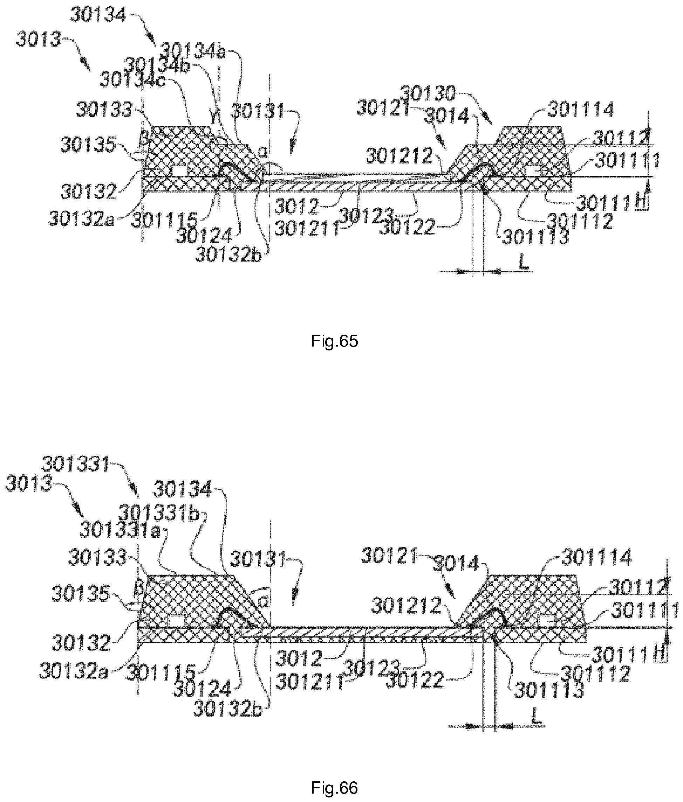

Fig. 65 shows a modified implementation of the molded circuit board assembly 3010, wherein the filter element 3040 can also overlappedly disposed on the photosensitive element 3012 before molding the maintaining portion 3013. Thus, in the molding process, the maintaining portion 3013, the filter element 3040, the photosensitive element 3012, and the circuit board 3011 are integrally molded.

Fig. 66 shows a modified implementation of the molded circuit board assembly 3010, wherein the inner surface 30134 of the maintaining portion 3013 is a complete surface, and the filter element 3040 and the driver 3030 are mounted to the mounting side 30133 of the maintaining portion 3013, respectively. Specifically, the mounting surface 301331 of the mounting side 30133 of the maintaining portion 3013 has an outer mounting surface 301331a and an inner mounting surface 301331b, wherein the outer mounting surface 301331a and the inner mounting surface 301331b are integrally formed, and the outer mounting surface 301331a and the inner mounting surface 301331b are preferably in the same plane. The outer mounting surface 301331a of the mounting side 30133 extends from the outer surface 30135 toward the inner surface 30134, and the inner mounting surface 301331b of the mounting side 30133 extends from the inner surface 30134 toward the outer surface 30135. The driver 3030 is mounted to at least a part of the outer mounting surface 301331a of the mounting side 30133, so that the optical lens 3020 assembled to the driver 3030 is held in the light path of the photosensitive element 3012. The filter element 3040 is mounted to at least a part of the inner mounting surface 301331b of the mounting side 30133, so that the filter element 3040 is held between the photosensitive element 3012 and the optical lens 3020.

It will be understood by those skilled in the art that the inclination of the inner surface 30134 of the maintaining portion 3013 is limited by the wire bonding direction of the lead wire 3014. When the wire bonding direction of the lead wire 3014 is from the photosensitive element 3012 to the circuit board 3011, the first included angle α between the inner surface 30134 of the maintaining portion 3013 and the optical axis of the photosensitive element 3012 is smaller. When the wire bonding direction of the lead wire 3014 is from the circuit board 3011 to the photosensitive element 3012, the first included angle α between the inner surface 30134 of the maintaining portion 3013 and the optical axis of the photosensitive element 3012 is larger.

It will also be understood by those skilled in the art that if the first included angle α is too large, the lead wire 3014 may be damaged when the molded circuit board assembly 3010 is molded by the molding die 30200. Moreover, after the maintaining portion 3013 is molded, the lead wire 3014 is exposed on the inner surface 30134 of the maintaining portion 3013. As a result, in case of imaging, the light entering the interior of the image capture module 30100 from the optical lens 3020 is reflected by the lead wire 3014, which generates stray light inside the image capture module 30100 so as to affect imaging of the image capture module 30100. If the first included angle α is too small, the molding die 30200 is not easily drafted, and when the molding die 30200 is drafted, the maintaining portion 3013 may be damaged and the maintaining portion 3013 is caused to generate particles such as debris to contaminate the photosensitive region 301212 of the photosensitive element 3012.

In addition, the values of the second included angle β and the third included angle γ should also be too large or too small. Otherwise, the filter element 3040 and the driver 3030 cannot be mounted to the maintaining portion 3013, or the molding die 30200 is not easy to draft.

That is, the first included angle α, the second included angle β, and the third included angle γ□each have the maximum and minimum limits. The first included angle α ranges from 1° to 85°. The second included angle β ranges from 1° to 65°. The third included angle γ ranges from 1° to 60°. Optionally, the first included angle α ranges from 35° to 75°.

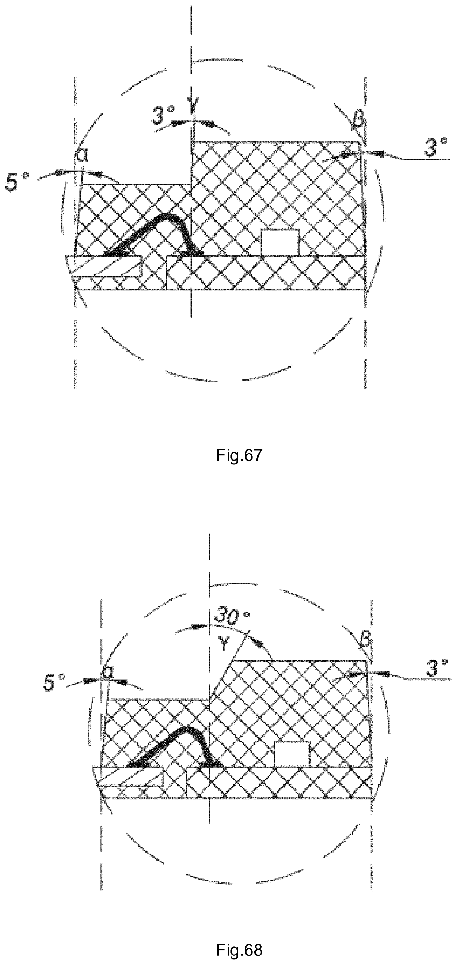

In the molded circuit board assembly 3010 shown in Fig. 67, the first included angle α is 5°, the second included angle β is 3°, and the third included angle γ is 3°.

In the molded circuit board assembly 3010 shown in Fig. 68, the first included angle α is 5°, the second included angle β is 3°, and the third included angle γ is 30°.

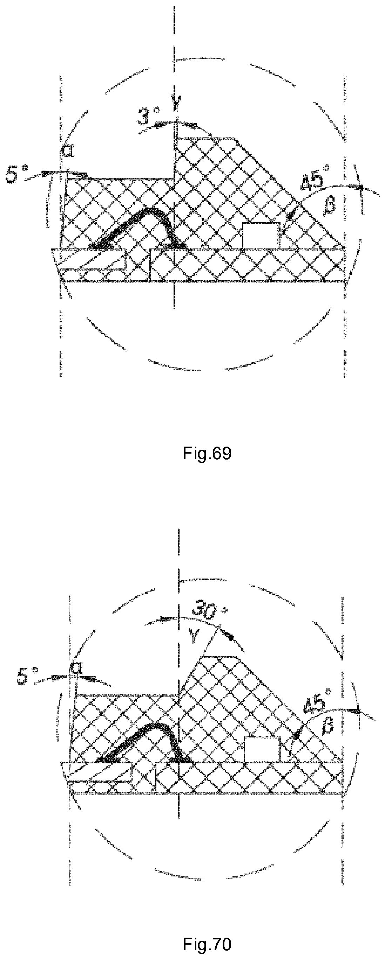

In the molded circuit board assembly 3010 shown in Fig. 69, the first included angle α is 5°, the second included angle β is 45°, and the third included angle γ is 3°.

In the molded circuit board assembly 3010 shown in Fig. 70, the first included angle α is 5°, the second included angle β is 45°, and the third included angle γ is 30°.

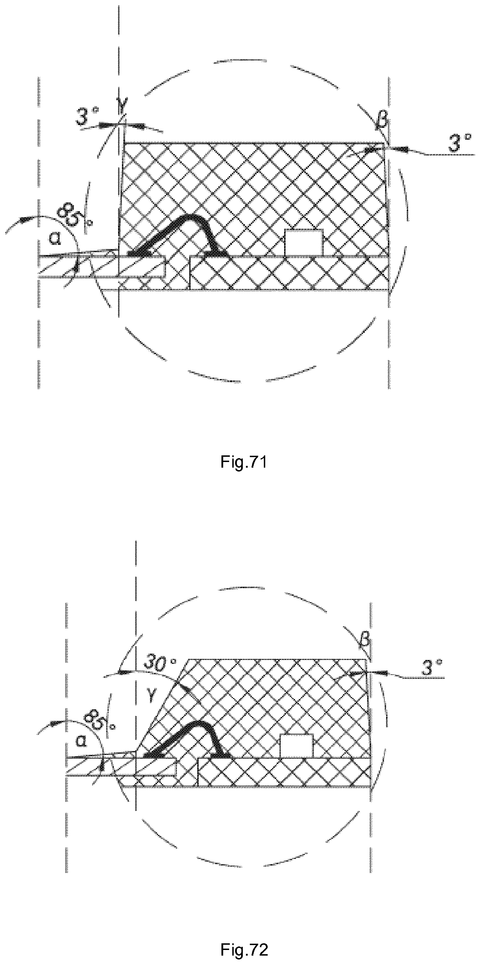

In the molded circuit board assembly 3010 shown in Fig. 71, the first included angle α is 85°, the second included angle β is 3°, and the third included angle γ is 3°.

In the molded circuit board assembly 3010 shown in Fig. 72, the first included angle α is 85°, the second included angle β is 3°, and the third included angle γ is 30°.

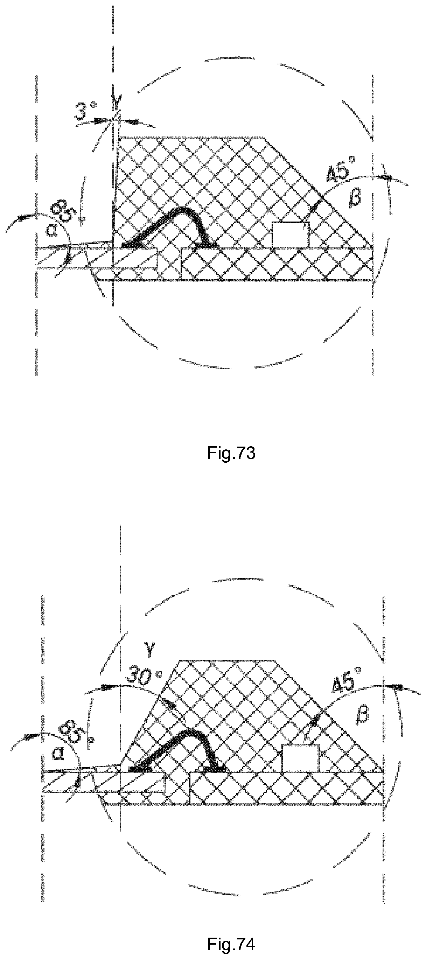

In the molded circuit board assembly 3010 shown in Fig. 73, the first included angle α is 85°, the second included angle β is 45°, and the third included angle γ is 3°.

In the molded circuit board assembly 3010 shown in Fig. 74, the first included angle α is 85°, the second included angle β is 45°, and the third included angle γ is 30°.

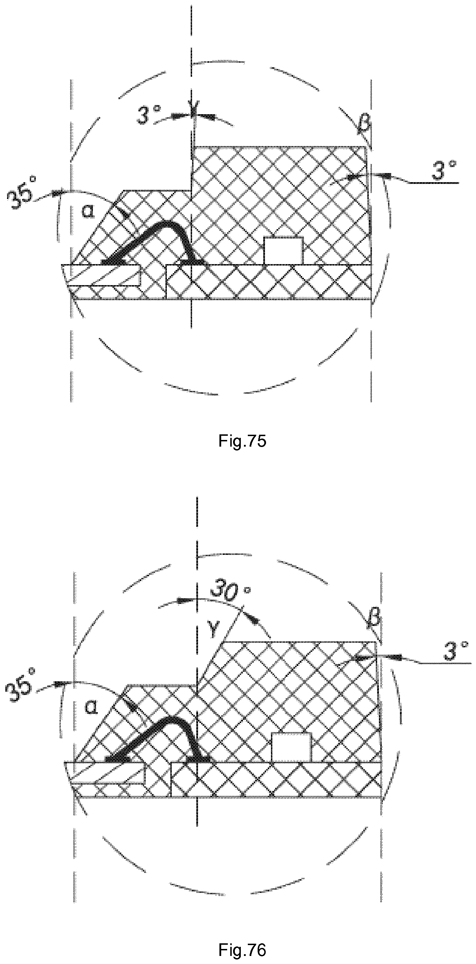

In the molded circuit board assembly 3010 shown in Fig. 75, the first included angle α is 35°, the second included angle β is 3°, and the third included angle γ is 3°.

In the molded circuit board assembly 3010 shown in Fig. 76, the first included angle α is 35°, the second included angle β is 3°, and the third included angle γ is 30°.

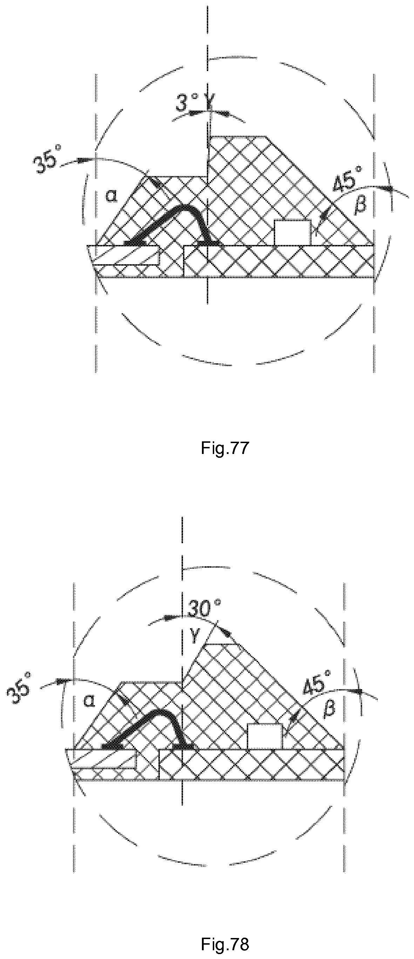

In the molded circuit board assembly 3010 shown in Fig. 77, the first included angle α is 35°, the second included angle β is 45°, and the third included angle γ is 3°.

In the molded circuit board assembly 3010 shown in Fig. 78, the first included angle α is 35°, the second included angle β is 45°, and the third included angle γ is 30°.

It will be understood by those skilled in the art that the examples shown in FIGS. 67 to 78 are only taken as examples where the wire bonding direction of the lead wire 3014 is from the substrate 30111 of the circuit board 3011 to the photosensitive chip 3012, to illustrate and describe the features and advantages of the image capture module 30100 of the present disclosure, and should not be considered as limiting the content and scope of the image capture module 30100 of the present disclosure. It can be understood that, in other examples, the wire bonding direction of the lead wire 3014 may be from the photosensitive chip 3012 to the substrate 30111 of the circuit board 3011, as shown in Fig. 45, or the lead wire 3014 is formed between the substrate 30111 of the circuit board 3011 and the photosensitive chip 3012 by a flattening bonding process, as shown in Fig. 45C, or the photosensitive chip 3012 is directly mounted to the substrate 30111 of the circuit board 3011 by a flip chip process, as shown in Fig. 45D.

According to another aspect of the present disclosure, the present disclosure further provides a manufacturing method of a molded circuit board assembly 3010, wherein the manufacturing method comprises steps of:
(a) conductively connecting a circuit board 3011 and a photosensitive element 3012 housed in a receiving space 301113 of the circuit board 3011;
(b) placing the circuit board 3011 and the photosensitive element 3012 conductively connected in a lower mold 30202 of a molding die 30200;
(c) hermetically closing an upper mold 30201 and the lower mold 30202 of the molding die 30200 to form a molding space 30203 between the upper mold 30201 and the lower mold 30202, for housing the circuit board 3011 and the photosensitive element 3012 conductively connected, and causing a part of the circuit board 3011 and a part of a non-photosensitive region 301212 of the photosensitive element 3012 to correspond to a molding guide groove 20121 of an enclosure member 302012 of the upper mold 30201, and causing a photosensitive region 301211 of the photosensitive element 3012 to correspond to a light window molding member 302011 of the upper mold 30201; and
(d) adding a fluid molding material 30400 to the molding space 30203 to cure the molding material 30400 in the molding guide groove 20121 to form a maintaining portion 3013 integrally molded on the circuit board 3011 and the photosensitive element 3012, and form a light window 30131 of the maintaining portion 3013 at a position corresponding to the light window molding member 302011, to obtain the molded circuit board assembly 3010.

It should be understood by those skilled in the art that the embodiments of the present disclosure described in the above description and the accompanying drawings are only exemplary. The scope of protection of the present application is defined by the appended claims.

## Claims

1. A photosensitive assembly (1010; 2010; 3010), comprising:
at least one photosensitive element (1011; 2013; 3012), wherein the photosensitive element includes a top surface (10111; 20131; 30121) and a bottom surface (10112; 20132; 30123), with the top surface being suitable for photoelectric conversion;
at least one circuit board (1012; 2012; 3011) with a window formed therein;
wherein the photosensitive assembly comprises at least one packaging body (1013; 1013C; 20112; 3013) formed of molding material, wherein the photosensitive element and the circuit board are integrally packaged by the packaging body, the packaging body forms a light window (10134; 20111; 30131) corresponding to the photosensitive element, allowing light to pass through the light window to reach the top surface (10111; 20131; 30121) of the photosensitive element (1011; 2013; 3012) for photoelectric conversion, the circuit board comprises a circuit board main body (10121; 20121; 30111), and the circuit board main body has a window (10122; 20122; 301113), in which
the photosensitive element is disposed, wherein the circuit board main body (10121; 20121; 30111) has a substrate inner wall to define the window (10122; 20122; 301113), and the photosensitive element has an outer side surface, wherein there is a first safety distance (L) between the outer side surface of the photosensitive element and the substrate inner wall so that the photosensitive element is not in contact with the substrate inner wall of the circuit board and thus a gap (10125; 2014) is formed,
**characterized in that** the packaging body (1013; 20112; 3013) extends into the gap (10125; 2014) between the photosensitive element (1011; 2013; 3012) and the circuit board main body (10121; 20121; 30111), and overmolds the bottom surface of the photosensitive element (1011; 2013; 3012).

2. The photosensitive assembly according to claim 1, wherein the window (10122; 20122; 301113) is a through hole, in which the photosensitive element (1011; 2013; 3012) is disposed.

3. The photosensitive assembly according to claim 2, wherein the photosensitive element (1011; 2013; 3012) is electrically connected by at least one electrical connection element (1014; 20133; 3014), one end of the electrical connection element being connected to the photosensitive element (1011; 2013; 3012) and the other end being connected to the surface of the circuit board main body (10121; 20121; 30111).

4. The photosensitive assembly according to claim 3, wherein the packaging body (1013; 20112; 3013) integrally packages the electrical connection element.

5. The photosensitive assembly according to claim 4, wherein the photosensitive assembly comprises at least one electronic component (10123; 20123; 30112) protruding or partially protruding from the circuit board main body (10121; 20121; 30111), the packaging body (1013; 20112; 3013) integrally packaging the electronic component.

6. The photosensitive assembly according to claim 4, wherein the top surface (10111; 20131; 30121) of the photosensitive element (1011; 2013; 3012) comprises a photosensitive region (101111; 201311; 301211) and a non-photosensitive region (101112; 201312; 301212), the packaging body (1013; 20112; 3013) integrally packaging at least a part of the non-photosensitive region.

7. The photosensitive assembly according to claim 6, wherein the photosensitive assembly further comprises an annular barrier member (1015; 3015), the barrier member being disposed around the photosensitive region (101111; 301211) of the photosensitive element (1011; 3012).

8. The photosensitive assembly according to claim 4, wherein the surface of the packaging body (1013; 20112; 3013) is a stepped structure.

9. The photosensitive assembly according to claim 4, wherein the surface of the packaging body (1013; 20112; 3013) is a planar structure.

10. An image capture module, **characterized in that** it comprises:
at least one photosensitive assembly (1010; 2010; 3010) according to any one of claims 1 to 9; and
at least one lens (1020; 2020; 3020), the lens being located in the photosensitive path of the photosensitive element, allowing light entering from the lens to pass through the light window (10134; 20111; 30131) to reach the photosensitive element (1011; 2013; 3012).

## Patentansprüche

1. Lichtempfindliche Baugruppe (1010; 2010; 3010), umfassend:
mindestens ein lichtempfindliches Element (1011; 2013; 3012), wobei das lichtempfindliche Element eine obere Oberfläche (10111; 20131; 30121) und eine untere Oberfläche (10112; 20132; 30123) umfasst, wobei die obere Oberfläche zur fotoelektrischen Umwandlung geeignet ist;
mindestens eine Leiterplatte (1012; 2012; 3011) mit einem darin ausgebildeten Fenster;
wobei die lichtempfindliche Baugruppe mindestens einen Verpackungskörper (1013; 1013C; 20112; 3013) umfasst, der aus Formmaterial gebildet ist, wobei das lichtempfindliche Element und die Leiterplatte integral durch den Verpackungskörper verpackt sind, der Verpackungskörper ein Lichtfenster (10134; 20111; 30131) bildet, das dem lichtempfindlichen Element entspricht und es ermöglicht, dass Licht durch das Lichtfenster gelangt, um die obere Oberfläche (10111; 20131; 30121) des lichtempfindlichen Elements (1011; 2013; 3012) zur fotoelektrischen Umwandlung zu erreichen, wobei die Leiterplatte einen Leiterplattenhauptkörper (10121; 20121; 30111) umfasst, und der Leiterplattenhauptkörper ein Fenster (10122; 20122; 301113) aufweist, in dem das lichtempfindliche Element angeordnet ist, wobei der Leiterplattenhauptkörper (10121; 20121; 30111) eine Substratinnenwand aufweist, um das Fenster (10122; 20122; 301113) zu begrenzen, und wobei das lichtempfindliche Element eine äußere Seitenfläche aufweist, wobei zwischen der äußeren Seitenfläche des lichtempfindlichen Elements und der Substratinnenwand ein erster Sicherheitsabstand (L) besteht, so dass das lichtempfindliche Element keinen Kontakt mit der Substratinnenwand der Leiterplatte hat und somit ein Spalt (10125; 2014) entsteht,
**dadurch gekennzeichnet, dass** der Verpackungskörper (1013; 20112; 3013) in den Spalt (10125; 2014) zwischen dem lichtempfindlichen Element (1011; 2013; 3012) und dem Leiterplattenhauptkörper (10121; 20121; 30111) hineinragt und die untere Oberfläche des lichtempfindlichen Elements (1011; 2013; 3012) überformt.

2. Lichtempfindliche Baugruppe nach Anspruch 1, wobei das Fenster (10122; 20122; 301113) ein Durchgangsloch ist, in dem das lichtempfindliche Element (1011; 2013; 3012) angeordnet ist.

3. Lichtempfindliche Baugruppe nach Anspruch 2, wobei das lichtempfindliche Element (1011; 2013; 3012) durch mindestens ein elektrisches Verbindungselement (1014; 20133; 3014) elektrisch verbunden ist, wobei ein Ende des elektrischen Verbindungselements mit dem lichtempfindlichen Element (1011; 2013; 3012) verbunden ist und das andere Ende mit der Oberfläche des Leiterplattenhauptkörpers (10121; 20121; 30111) verbunden ist.

4. Lichtempfindliche Baugruppe nach Anspruch 3, wobei der Verpackungskörper (1013; 20112; 3013) das elektrische Verbindungselement integral verpackt.

5. Lichtempfindliche Baugruppe nach Anspruch 4, wobei die lichtempfindliche Baugruppe mindestens eine elektronische Komponente (10123; 20123; 30112) umfasst, die aus dem Leiterplattenhauptkörper (10121; 20121; 30111) hervorsteht oder teilweise hervorsteht, der Verpackungskörper (1013; 20112; 3013) die elektronische Komponente integral verpackt.

6. Lichtempfindliche Baugruppe nach Anspruch 4, wobei die obere Oberfläche (10111; 20131; 30121) des lichtempfindlichen Elements (1011; 2013; 3012) einen lichtempfindlichen Bereich (101111; 201311; 301211) und einen nicht lichtempfindlichen Bereich (101112; 201312; 301212) umfasst, wobei der Verpackungskörper (1013; 20112; 3013) zumindest einen Teil des nicht lichtempfindlichen Bereichs integral verpackt.

7. Lichtempfindliche Baugruppe nach Anspruch 6, wobei die lichtempfindliche Baugruppe außerdem ein ringförmiges Barriereelement (1015; 3015) umfasst, wobei das Barriereelement um den lichtempfindlichen Bereich (101111; 301211) des lichtempfindlichen Elements (1011; 3012) herum angeordnet ist.

8. Lichtempfindliche Baugruppe nach Anspruch 4, wobei die Oberfläche des Verpackungskörpers (1013; 20112; 3013) eine abgestufte Struktur ist.

9. Lichtempfindliche Baugruppe nach Anspruch 4, wobei die Oberfläche des Verpackungskörpers (1013; 20112; 3013) eine ebene Struktur ist.

10. Bilderfassungsmodul, **dadurch gekennzeichnet, dass** es umfasst:
mindestens eine lichtempfindliche Baugruppe (1010; 2010; 3010) nach einem der Ansprüche 1 bis 9; und
mindestens eine Linse (1020; 2020; 3020), wobei sich die Linse im lichtempfindlichen Pfad des lichtempfindlichen Elements befindet und es ermöglicht, dass von der Linse eintretendes Licht durch das Lichtfenster (10134; 20111; 30131) gelangt, um das lichtempfindliche Element (1011; 2013; 3012) zu erreichen.

## Revendications

1. Un ensemble photosensible (1010; 2010; 3010), comprenant:
au moins un élément photosensible (1011; 2013; 3012), dans lequel l'élément photosensible comprenant une surface supérieure (10111; 20131; 30121) et une surface inférieure (10112; 20132; 30123), avec la surface supérieure étant appropriée pour une conversion photoélectrique;
au moins une carte de circuit imprimé (1012; 2012; 3011) dans laquelle est formée une fenêtre;
dans lequel l'ensemble photosensible comprend au moins un corps d'emballage (1013; 1013C; 20112; 3013) formé d'un matériau de moulage, dans lequel l'élément photosensible et la carte de circuit imprimé sont intégralement emballés par le corps d'emballage, le corps d'emballage forme une fenêtre lumineuse (10134; 20111; 30131) correspondant à l'élément photosensible, permettant à la lumière de passer à travers la fenêtre lumineuse pour atteindre la surface supérieure (10111; 20131; 30121) de l'élément photosensible (1011; 2013; 3012). ) pour la conversion photoélectrique, la carte de circuit imprimé comprend un corps principal de carte de circuit imprimé (10121; 20121; 30111), et le corps principal de carte de circuit imprimé a une fenêtre (10122; 20122; 301113), dans lequel l'élément photosensible est disposé, dans lequel le corps principal de carte de circuit imprimé (10121; 20121; 30111) a une paroi interne de substrat pour définir la fenêtre (10122; 20122; 301113), et l'élément photosensible a une surface latérale externe, dans laquelle il existe une première distance de sécurité (L) entre la surface latérale externe de l'élément photosensible et la paroi interne du substrat de sorte que l'élément photosensible n'est pas en contact avec la paroi interne du substrat de la carte de circuit imprimé et ainsi un espace (10125; 2014) est formé,
**caractérisé en ce que** le corps d'emballage (1013; 20112; 3013) s'étend dans l'espace (10125; 2014) entre l'élément photosensible (1011; 2013; 3012) et le corps principal de carte de circuit imprimé (10121; 20121; 30111), et surmoule le surface inférieure de l'élément photosensible (1011; 2013; 3012).

2. L'ensemble photosensible selon la revendication 1, dans lequel la fenêtre (10122; 20122; 301113) est un trou traversant, dans lequel l'élément photosensible (1011; 2013; 3012) est disposé.

3. L'ensemble photosensible selon la revendication 2, dans lequel l'élément photosensible (1011; 2013; 3012) est connecté électriquement par au moins un élément de connexion électrique (1014; 20133; 3014), une extrémité de l'élément de connexion électrique étant connectée à l'élément photosensible (1011; 2013; 3012) et l'autre extrémité étant connectée à la surface du corps principal de carte de circuit imprimé (10121; 20121; 30111).

4. L'ensemble photosensible selon la revendication 3, dans lequel le corps d'emballage (1013; 20112; 3013) emballe intégralement l'élément de connexion électrique.

5. L'ensemble photosensible selon la revendication 4, dans lequel l'ensemble photosensible comprend au moins un composant électronique (10123; 20123; 30112) faisant saillie ou faisant partiellement saillie du corps principal de carte de circuit imprimé (10121; 20121; 30111), le corps d'emballage (1013; 20112; 3013) emballant intégralement le composant électronique.

6. L'ensemble photosensible selon la revendication 4, dans lequel la surface supérieure (10111; 20131; 30121) de l'élément photosensible (1011; 2013; 3012) comprend une région photosensible (101111; 201311; 301211) et une région non photosensible (101112; 201312; 301212), le corps d'emballage (1013; 20112; 3013) emballe intégralement au moins une partie de la région non photosensible.

7. L'ensemble photosensible selon la revendication 6, dans lequel l'ensemble photosensible comprend en outre un élément barrière annulaire (1015; 3015), l'élément barrière étant disposé autour de la région photosensible (101111; 301211) de l'élément photosensible (1011; 3012).

8. L'ensemble photosensible selon la revendication 4, dans lequel la surface du corps d'emballage (1013; 20112; 3013) est une structure étagée.

9. L'ensemble photosensible selon la revendication 4, dans lequel la surface du corps d'emballage (1013; 20112; 3013) est une structure plane.

10. Un module de capture d'images, **caractérisé en ce qu'**il comprend:
au moins un ensemble photosensible (1010; 2010; 3010) selon l'une quelconque des revendications 1 à 9; et
au moins une lentille (1020; 2020; 3020), la lentille se trouve dans le trajet photosensible de l'élément photosensible, permettant à la lumière entrant par la lentille de traverser la fenêtre lumineuse (10134; 20111; 30131) pour atteindre l'élément photosensible (1011; 2013; 3012).
